# EUROPEAN PATENT APPLICATION

(11) **EP 4 465 801 A1**
(43) Date of publication of application: **20.11.2024**
(21) Application number: 23740261.5
(22) Date of filing: 11.01.2023
(51) Int. Cl.: H10K 85/30, C07D 213/24, C07F 15/00, C09K 11/06, H10K 50/12, H10K 59/10, H10K 71/12, H10K 101/10

(54) **IRIDIUM COMPLEX COMPOUND, COMPOSITION FOR ORGANIC ELECTROLUMINESCENT ELEMENT, ORGANIC ELECTROLUMINESCENT ELEMENT AND METHOD FOR PRODUCING SAME, AND DISPLAY DEVICE**

(30) Priority: 13.01.2022 JP 2022003809; 13.01.2022 JP 2022003810
(71) Applicant: Mitsubishi Chemical Corporation, Tokyo 100-8251 (JP)
(72) Inventor: NAGAYAMA, Kazuhiro, Tokyo 100-8251 (JP); KOMATSU, Hideji, Tokyo 100-8251 (JP); KATO, Akane, Tokyo 100-8251 (JP); NARA, Mayuko, Tokyo 100-8251 (JP); ABE, Tomohiro, Tokyo 100-8251 (JP); OKABE, Kazuki, Tokyo 100-8251 (JP)
(74) Representative: Hoffmann Eitle
(86) International application number: PCT/JP2023/000382
(87) International publication number: WO 2023/136252

(57) **Abstract**

An iridium complex compound represented by formula (1') below.

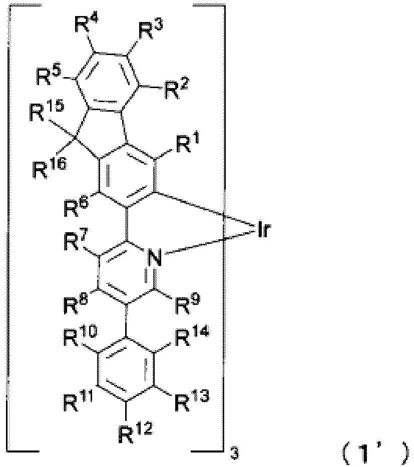

R² to R⁵ are each selected from a [substituent group W]; R¹, R⁶ to R¹⁰, and R¹⁴ are a hydrogen atom, F, a methyl group, a trifluoromethyl group, an ethyl group, a vinyl group, or an ethynyl group; R¹⁵ and R¹⁶ are a linear, branched, or cyclic alkyl group having 1 to 30 carbon atoms, an aralkyl group having 5 to 60 carbon atoms, or a heteroaralkyl group having 5 to 60 carbon atoms; one of R¹¹ to R¹³ has a structure represented by formula (2) below; and the remaining two are selected from a [substituent group Z].

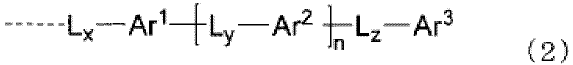

## Description

### Technical Field

The present invention relates to an organic electroluminescent element composition that is useful for forming a light-emitting layer of an electroluminescent element (which may be hereinafter referred to as an "organic EL element"). The invention also relate to an electroluminescent element including a light-emitting layer formed using the organic electroluminescent element composition, a method for producing the same, and a display device including the organic electroluminescent element.

The invention also relates to an iridium complex compound and particularly to an iridium complex compound useful as a material of a light-emitting layer of an organic EL element, an organic electroluminescent element composition containing the compound, an organic electroluminescent element using the organic electroluminescent element composition, and a method for producing the same.

### Background Art

Various electronic devices that use organic EL elements such as organic EL lighting devices and organic EL displays have been put to practical use. Organic EL elements, which have low power consumption because of their low applied voltage, can emit light of three primary colors and are being used not only for large-size display monitors but also for small to medium-size displays typified by cellular phones and smartphones.

An organic EL element is produced by stacking a plurality of layers such as a light-emitting layer, a charge injection layer, and a charge transport layer. At present, most organic electroluminescent elements are produced by vapor deposition of organic materials in a vacuum. However, the vacuum vapor deposition method includes a complex vapor deposition process, and its productivity is low. One problem with organic EL elements produced by the vacuum vapor deposition method is that it is very difficult to produce large-size illumination devices and large-size panels using these organic EL elements.

In recent years, a wet deposition method (application method) has been studied as a process for efficiently producing organic EL elements usable for large-size displays and lighting devices. One advantage of the wet deposition method over the vacuum vapor deposition method is that stable layers can be more easily formed, and it is expected to apply the wet deposition method to mass production of displays and lighting devices and to large-size devices.

To produce an organic EL element using the wet deposition method, it is necessary that all materials used be soluble in an organic solvent and the solution can be used as an ink. If the solubility of the materials used is poor, operations such as long time heating must be performed, and the materials may deteriorate before they are used. Moreover, if a homogeneous solution state cannot be maintained for a long time, the materials may precipitate from the solution, and a film cannot be formed using, for example, an inkjet device. The solubility required for the materials used for the wet deposition method has two meanings. Specifically, the materials can rapidly dissolve in an organic solvent, and the dissolved materials do not precipitate, so that the uniform state is maintained.

One advantage of the wet deposition method over the vacuum vapor deposition method is that a larger number of materials can be used for one layer. In the vacuum vapor deposition method, when a large number of materials are used, it is difficult to uniformly control their evaporation rates. However, in the wet deposition method, even when a large number of materials are used, an ink having a constant compositional ratio can be prepared so long as the materials can dissolve in an organic solvent.

In recent years, attempts have been made to use two or more iridium complexes for an ink in order to increase the luminous efficiency of organic electroluminescent elements and reduce their driving voltage by utilizing the above advantage to thereby improve the performance of the organic EL elements (e.g., PTL 1 and PTL 2).

With attention given to the chemical structures of materials, attempts have been made to use, as a red light-emitting material in a white light emitting element, an iridium complex having, as a ligand, phenylpyridine substituted with a triazine ring at a specific position (e.g., PTL 3 and PTL 4).

In view of the above, attempts have been made to improve the performance of organic EL elements by using an iridium complex exhibiting maximum light emission at a relatively short wavelength as an assist dopant and using, as a light-emitting dopant for a red element, an iridium complex having, as a ligand, phenylpyridine substituted with a triazine ring at a specific position (e.g., PTL 5).

However, with the above prior art techniques, the performance of the organic EL elements is not sufficient for display applications. In particular, there is a need to further reduce the driving voltage of red elements, improve their luminous efficiency, and improve their driving lifetime.

Examples of the required performance of organic EL elements include improved luminous efficiency and a longer driving lifetime. It is difficult to use organic EL display materials that do not meet these requirements simultaneously.

In particular, for red organic EL elements, attention is being focused on how to improve their luminous efficiency, i.e., luminous intensity (candela) per unit current. To broaden the color gamut of a display and obtain images with higher color reproducibility, a red light-emitting material that emits light with a longer wavelength must be used for red elements. However, to obtain a longer wavelength in the red region, there are two essential problems in terms of luminous efficiency.

The first problem is a problem with the luminous efficacy (spectral luminous efficacy) of the human eye. In a wavelength range longer than 600 nm, the luminous efficacy decreases rapidly as the wavelength of light increases, and therefore the value of luminous efficiency decreases significantly.

The second problem is that, due to the energy gap law, as the excitation energy decreases (as the wavelength of the light emitted increases), the interaction with the vibrational state of light-emitting molecules increases and the rate of non-radiative deactivation increases exponentially, so that the emission quantum yield decreases. Specifically, the luminous efficiency decreases.

Accordingly, improving the luminous efficiency of red elements is significantly important to improve the performance of organic EL displays.

One way to improve the characteristics of red elements is to add an assist dopant to a light-emitting layer so as to coexist with other materials. Generally, host molecules that transport charges and dopant molecules that emit light when they receive excitation energy generated by recombination of holes and electrons are present in a light-emitting layer of an organic EL element. The recombination can occur on the host or the dopant. However, the light-emitting layer is often designed such that the recombination occurs on the dopant because the luminous efficiency can be expected to be improved. In many red elements, the durability of red light-emitting dopant molecules is low. Therefore, when the light-emitting layer is designed as described above, a load is concentrated on the dopant molecules, and therefore the driving lifetime is shortened.

One way to improve this is to add second dopant molecules having a larger energy gap than the dopant molecules (in other words, emitting light with a shorter maximum emission wavelength) so as to coexist with the dopant molecules. In this case, excitons are first generated on the second dopant, and the energy is transferred to the red light-emitting dopant having a narrower energy gap to thereby emit light. Since the second dopant having high durability, i.e., an assist dopant, is used to disperse the load, the lifetime of the element can be extended. Moreover, since the HOMO-LUMO gap of the red light-emitting dopant is narrow, a host material suitable for injection of holes or electrons cannot be prepared in some cases. However, by designing the element such that a material having a large energy gap is used as an assist dopant to allow recombination to occur on the assist dopant, the amount of reactive current can be reduced, and the luminous efficiency can be improved. The assist dopant preferred for red elements itself emits light of a yellowish green to yellow color or an orange color.

The advantage of the wet deposition method over the vacuum vapor deposition method is that many components are allowed to coexist in the light-emitting layer to thereby improve its performance. In the vacuum vapor deposition method, when a large number of materials are used, it is difficult to uniformly control their evaporation rates. However, in the wet deposition method, even when a large number of materials are used, an ink having a constant compositional ratio can be prepared so long as the materials can dissolve in an organic solvent.

In recent years, attempts have been made to use two iridium complexes as a light-emitting dopant and an assist dopant for an ink in order to increase the luminous efficiency of organic EL elements and to reduce their driving voltage to thereby improve the performance of the organic EL elements (e.g., PTL 1 and PTL 2).

Moreover, a structure having a fluorenylpyridine ligand has been disclosed as an example of an iridium complex compound that can emit light of a yellowish green to yellow color (PTL 6 and PTL 7).

However, with the assist dopant structures disclosed in PTL 1 and PTL 2, the color of the emitted light is green, and the energy difference from the red dopant is large. Therefore, energy transfer is slow, so that emission of light from the assist dopant itself is observed. This adversely affects the characteristics of the red element such as color purity.

The solvent solubility of the compounds specifically disclosed in PTL 6 and PTL 7 is insufficient. Therefore, it is difficult to use these compounds as materials for the wet deposition method, and their characteristics as assist dopants are insufficient.

### Citation List

### Patent Literature

PTL 1: WO2015/192939
PTL 2: WO2016/015815
PTL 3: WO2017/154884
PTL 4: JP2018-83941A
PTL 5: WO2020/235562
PTL 6: JP2002-332291A
PTL 7: WO2015/105014

### Summary of Invention

It is an object of the invention to provide an organic electroluminescent element that is used, in particular, as a red element, can be produced by a wet deposition method, and has higher luminous efficiency and a longer driving lifetime than conventional elements.

In view of the above, the inventors have conducted extensive studies to take the advantage of the wet deposition method that allows a larger number of materials to be used for one layer. Then the inventors have found that the performance of an organic electroluminescent element can be improved by using, as an assist dopant, an iridium complex having a ligand including a fluorene ring, using, as a light-emitting dopant in a red element, an iridium complex having a triazine ring that has a longer maximum emission wavelength than the assist dopant, preparing an organic electroluminescent element composition by dissolving the assist dopant and the light-emitting dopant in a solvent, and producing the organic electroluminescent element using the prepared composition. Thus, the invention has been completed. The inventors have also found that, by using an iridium complex having a ligand further including a fluorene ring as the light-emitting dopant, the performance of the organic electroluminescent element is further improved.

It is also an object of the invention to provide an iridium complex compound that has high solvent solubility usable for the wet deposition method and that, when used as an assist dopant in a red light-emitting element, can improve the luminous efficiency of the red organic EL element.

The inventors have found that an iridium complex compound having a specific chemical structure has high solvent solubility and contributes to an improvement in the luminous efficiency and driving lifetime of a red light-emitting organic EL element.

The present invention has the following gist.
[1] An organic electroluminescent element composition comprising: a compound represented by formula (31) below; and a compound represented by formula (32) below or a compound represented by formula (1) below: 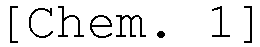 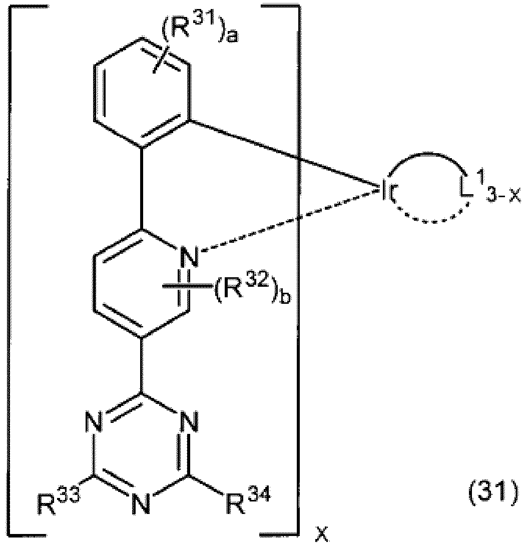
   [wherein, in the above formula, Ir represents an iridium atom;
   R³¹ and R³² are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms, each of which may optionally have a substituent;
   when a plurality of R³¹'s or R³²'s are present, they may be the same or different;
   when a plurality of R³¹'s are present, adjacent R³¹'s may be bonded together to form a ring;
   a is an integer of 0 to 4; b is an integer of 0 to 3;
   R³³ and R³⁴ are each independently a hydrogen atom, a fluorine atom, a chlorine atom, a bromine atom, an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 20 carbon atoms, each of which may optionally have a substituent;
   when a plurality of R³³'s or R³⁴'s are present, they may be the same or different;
   L¹ represents an organic ligand; and x is an integer of 1 to 3], 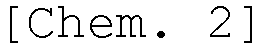 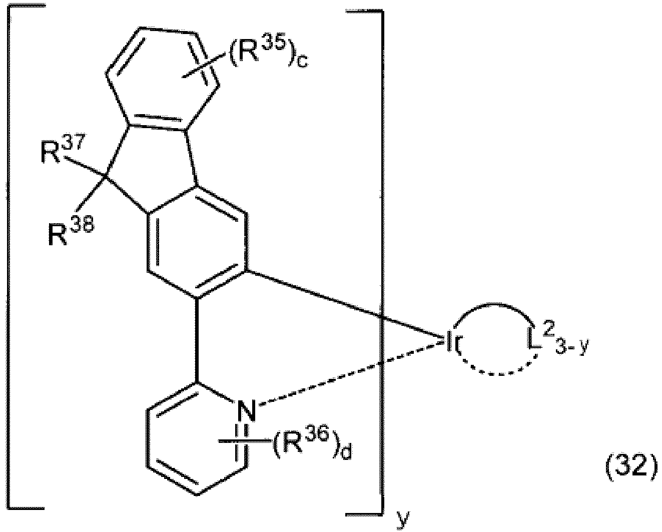
   [wherein, in the above formula, Ir represents an iridium atom;
   R³⁵ to R³⁸ are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms, each of which may optionally have a substituent;
   when a plurality of R³⁵'s, R³⁶'s, R³⁷'s, or R³⁸'s are present, they may be the same or different;
   when a plurality of R³⁵'s are present, adjacent R³⁵'s may be bonded together to form a ring;
   c and d are each independently an integer of 0 to 4;
   L² represents an organic ligand; and y is an integer of 1 to 3], 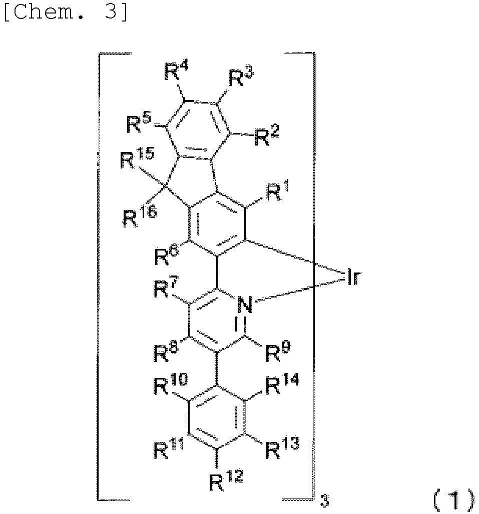
   [wherein, in formula (1) above, Ir represents an iridium atom;
   R¹ to R¹⁶ each represent a substituent within any of the following ranges; adjacent two of R¹ to R¹⁶ may be bonded together to form a ring while losing respective hydrogen atoms;
   R² to R⁵ are each selected from a [substituent group W] shown below;
   R¹, R⁶ to R¹⁰, and R¹⁴ are each independently a hydrogen atom, F, a methyl group, a trifluoromethyl group, an ethyl group, a vinyl group, or an ethynyl group;
   R¹⁵ and R¹⁶ are each independently a linear, branched, or cyclic alkyl group having 1 to 30 carbon atoms, an aromatic hydrocarbon group having 5 to 60 carbon atoms, an aromatic heterocyclic group having 5 to 60 carbon atoms, an aralkyl group having 5 to 60 carbon atoms, or a heteroaralkyl group having 5 to 60 carbon atoms, each of which may optionally have a substituent, which is the same as R' in the "substituent group W" shown below;
   one of R¹¹ to R¹³ has a structure represented by formula (2) below; and the remaining two are each selected from a [substituent group Z] shown below: 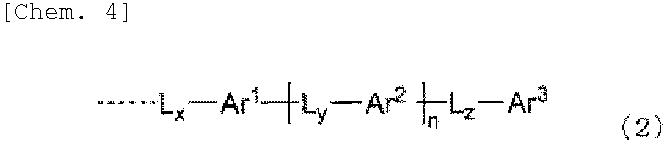
   wherein, in formula (2) above, a broken line represents a bond to formula (1);
   n represents an integer of 1 to 10;
   when a plurality of L_{y}'s and a plurality of Ar²'s are present, they may be the same or different;
   Lₓ, L_{y}, and L_{z} are each independently a direct bond or selected from -O-, -S-, -NR'-, -Si(R')₂-, -B(R')-, -C(=O)-, -P(=O) (R')-, -S(=O)₂-, -OSO₂-, and alkylene groups having 1 to 30 carbon atoms, wherein each of the alkylene groups may be optionally substituted with at least one R', wherein one -CH₂- group or 2 or more non-adjacent -CH₂- groups in each alkylene group may be replaced with -C(-R')=C(-R')-, -C=C-, -Si(-R')₂-, -C(=O)-, -NR'-, -O-, -S-, or -CONR'-, wherein R' is the same as R' in the [substituent group W] shown below, and wherein at least one hydrogen atom in these groups may be replaced with F, Cl, Br, I, or -CN;
   Ar¹ and Ar² each independently represent a divalent 5- or 6-membered aromatic hydrocarbon group or a divalent 5- or 6-membered aromatic heterocyclic group; Ar¹ and Ar² may each optionally have a substituent selected from the [substituent group Z] shown below;
   Ar³ represents a monovalent 5- or 6-membered aromatic hydrocarbon group or a monovalent 5- or 6-membered aromatic heterocyclic group; and Ar³ may optionally have a substituent selected from the [substituent group Z] shown below:

### [substituent group W]

substituents selected from a hydrogen atom, F, Cl, Br, I, -N(R')₂, -CN, -NO₂, -OH, -SH, -COOR', -C(=O)R', -C(=O)NR', -P(=O)(R')₂, -S(=O)R', -S(=O)₂R', -OS(=O)₂R', -SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms,
wherein the alkyl groups, the alkoxy groups, the alkylthio groups, the alkenyl groups, and the alkynyl groups may each be optionally substituted with at least one R', wherein one -CH₂- group or 2 or more non-adjacent -CH₂-groups in each of these groups may be optionally replaced with -C(-R')=C(-R')-, -C=C-, -Si(-R')₂, -C(=O)-, -NR'-, -O-, -S-, -CONR'-, a divalent aromatic hydrocarbon group, or a divalent aromatic heterocyclic group, wherein at least one hydrogen atom in each of these groups may be optionally replaced with F, Cl, Br, I, or -CN, and
wherein the aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each independently be optionally substituted with at least one R';
R's are each independently selected from a hydrogen atom, F, Cl, Br, I, -N(R'')₂, -OH, -SH, -CN, -NO₂, -Si(R'')₃, -B(OR'')₂, -C(=O)R'', -P(=O)(R")₂, -S(=O)₂R'', -OSO₂R'', linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms,
wherein the alkyl groups, the alkoxy groups, the alkylthio groups, the alkenyl groups, and the alkynyl groups may each be optionally substituted with at least one R'', wherein one -CH₂- group or 2 or more non-adjacent -CH₂-groups in each of these groups may be optionally replaced with -C(-R') =C (-R") -, -C=C-, -Si(-R")₂-, -C(=O)-, -NR"-, -O-, -S-, -CONR''-, a divalent aromatic hydrocarbon group, or a divalent aromatic heterocyclic group, wherein at least one hydrogen atom in each of these groups may be replaced with F, Cl, Br, I, or -CN,
wherein the aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each be optionally substituted with at least one R", and wherein two or more adjacent R's may be bonded together while losing respective hydrogen atoms to thereby form an aliphatic, aromatic hydrocarbon, or aromatic heterocyclic monocyclic or condensed ring;
R"s are each independently selected from a hydrogen atom, F, -CN, aliphatic hydrocarbon groups having 1 to 20 carbon atoms, aromatic hydrocarbon groups having 5 to 20 carbon atoms, and aromatic heterocyclic groups having 5 to 20 carbon atoms; and two or more adjacent R"s may be bonded together while losing respective hydrogen atoms to form an aliphatic, aromatic hydrocarbon, or aromatic heterocyclic monocyclic or condensed ring:

### [substituent group Z]

substituents selected from a hydrogen atom, F, Cl, Br, I, -N(R')₂, -CN, -NO₂, -OH, -SH, -COOR', -C(=O)R', -C(=O)NR', -P(=O)(R')₂, -S(=O)R', -S(=O)₂R', -OS(=O)₂R', -SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms, wherein the alkyl groups, the alkoxy groups, the alkylthio groups, the aryloxy groups, the arylthio groups, the aralkyl groups, the heteroaralkyl groups, the diarylamino groups, the arylheteroarylamino groups, and the diheteroarylamino groups may each be optionally substituted with at least one R', and wherein R' is the same as R' in the [substituent group W] above].

The organic electroluminescent element composition according to [1], wherein the compound represented by formula (31) above is a compound represented by formula (31-1) below: 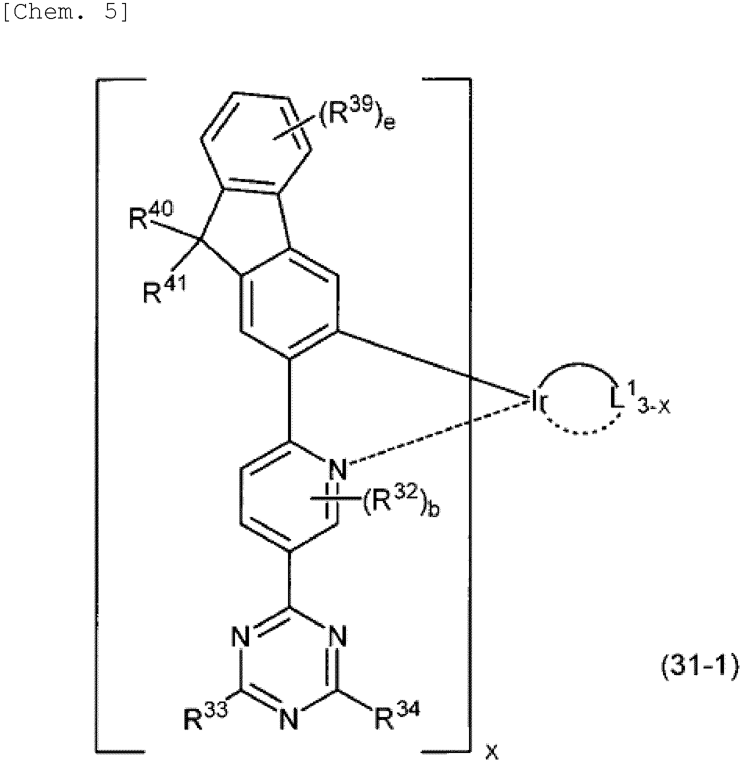
[wherein, in the above formula, Ir represents an iridium atom;
R³² to R³⁴, b, L¹, and x are the same as R³² to R³⁴, b, L¹, and x, respectively, in formula (31) above;
R³⁹ to R⁴¹ are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms, each of which may optionally have a substituent; when a plurality of R³⁹'s, R⁴⁰'s, or R⁴¹'s are present, they may be the same or different; when a plurality of R³⁹'s are present, adjacent R³⁹'s may be bonded together to form a ring; and
e is an integer of 0 to 4].

[3] The organic electroluminescent element composition according to [1] or [2], wherein R³⁶ in formula (32) above is a group including a plurality of benzene rings linked together.

[4] The organic electroluminescent element composition according to any one of [1] to [3], wherein the optional substituents on R³¹ to R³⁴ in formula (31) above are each an alkyl group, an aralkyl group, a heteroaralkyl group, an alkoxy group, an aryloxy group, a heteroaryloxy group, an alkylsilyl group, an arylsilyl group, an alkylcarbonyl group, an arylcarbonyl group, an alkylamino group, an arylamino group, an aryl group, or a heteroaryl group.

[5] The organic electroluminescent element composition according to any one of [1] to [4], wherein the optional substituents on R³⁵ to R³⁸ in formula (32) above are each an alkyl group, an aralkyl group, a heteroaralkyl group, an alkoxy group, an aryloxy group, a heteroaryloxy group, an alkylsilyl group, an arylsilyl group, an alkylcarbonyl group, an arylcarbonyl group, an alkylamino group, an arylamino group, an aryl group, or a heteroaryl group.

[6] The organic electroluminescent element composition according to any one of [1] to [5], wherein x in formula (31) above is 2 or less, and wherein L¹ has at least one structure selected from the group consisting of formulas (33), (34), and (35) below: 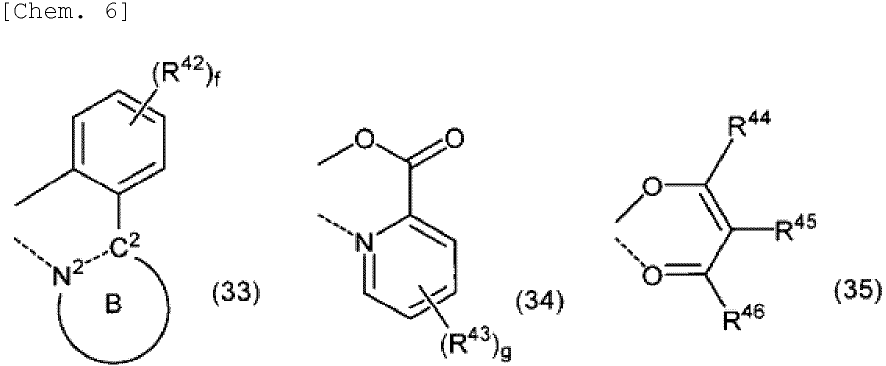
[wherein, in formulas (33) to (35) above, R⁴² and R⁴³ are each independently the same as R³¹ in formula (31); when a plurality of R⁴²s or R⁴³'s are present, they may be the same or different;
R⁴⁴ to R⁴⁶ are each independently a hydrogen atom, an alkyl group having 1 to 20 carbon atoms and optionally substituted with a fluorine atom, a phenyl group optionally substituted with an alkyl group having 1 to 20 carbon atoms, or a halogen atom;
f is an integer of 0 to 4; g is an integer of 0 to 4;
ring B is a pyridine ring, a pyrimidine ring, an imidazole ring, a quinoline ring, an isoquinoline ring, a quinazoline ring, a quinoxaline ring, an azatriphenylene ring, a carboline ring, a benzothiazole ring, or a benzoxazole ring; and ring B may optionally have a substituent].

[7] The organic electroluminescent element composition according to any one of [1] to [6], wherein y in formula (32) above is 2 or less, and wherein L² has at least one structure selected from the group consisting of formulas (33), (34), and (35) below: 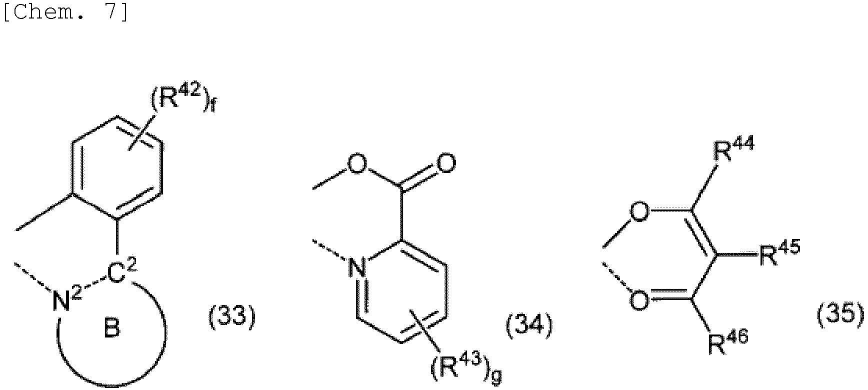
[wherein, in formulas (33) to (35) above, R⁴² and R⁴³ are each independently the same as R³¹ in formula (31) above; when a plurality of R⁴²'s or R⁴³'s are present, they may be the same or different;
R⁴⁴ to R⁴⁶ are each independently a hydrogen atom, an alkyl group having 1 to 20 carbon atoms and optionally substituted with a fluorine atom, a phenyl group optionally substituted with an alkyl group having 1 to 20 carbon atoms, or a halogen atom;
f is an integer of 0 to 4; g is an integer of 0 to 4;
ring B is a pyridine ring, a pyrimidine ring, an imidazole ring, a quinoline ring, an isoquinoline ring, a quinazoline ring, a quinoxaline ring, an azatriphenylene ring, a carboline ring, a benzothiazole ring, or a benzoxazole ring; and ring B may optionally have a substituent].

[8] The organic electroluminescent element composition according to any one of [1] to [7], wherein a in formula (31) above is 1, or wherein a in formula (31) above is an integer of 2 or more and adjacent R³¹'s are not bonded together to form a ring.

[9] The organic electroluminescent element composition according to any one of [1] to [8], wherein the compositional mass ratio of the compound represented by formula (31) above is equal to or more than one-fifth of the compositional mass ratio of the compound represented by formula (32) above or the compound represented by formula (1) above.

[10] An organic electroluminescent element comprising an anode and a cathode that are disposed on a substrate and further comprising an organic layer between the anode and the cathode,
wherein the organic layer contains the organic electroluminescent element composition according to any one of [1] to [9].

[11] The organic electroluminescent element according to [10], wherein the organic layer is a light-emitting layer.

[12] A display device comprising the organic electroluminescent element according to [11].

[13] The organic electroluminescent element composition according to any one of [1] to [9], further comprising a solvent.

[14] A method for producing an organic electroluminescent element including an anode and a cathode that are disposed on a substrate and further including an organic layer between the anode and the cathode, the method comprising the step of forming a light-emitting layer by a wet deposition method using the organic electroluminescent element composition according to [13].

[15] An iridium complex compound represented by formula (1') below: 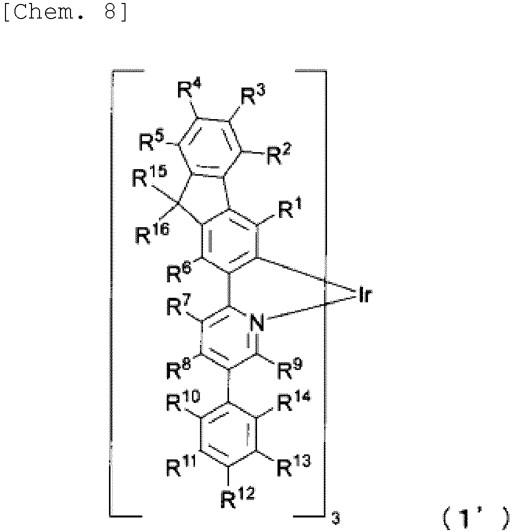
[wherein, in formula (1') above, Ir represents an iridium atom;
R¹ to R¹⁶ each represent a substituent within any of the following ranges; adjacent two of R¹ to R¹⁶ may be bonded together to form a ring while losing respective hydrogen atoms;
R² to R⁵ are each selected from a [substituent group W] shown below;
R¹, R⁶ to R¹⁰, and R¹⁴ are each independently a hydrogen atom, F, a methyl group, a trifluoromethyl group, an ethyl group, a vinyl group, or an ethynyl group;
R¹⁵ and R¹⁶ are each independently a linear, branched, or cyclic alkyl group having 1 to 30 carbon atoms, an aralkyl group having 5 to 60 carbon atoms, or a heteroaralkyl group having 5 to 60 carbon atoms, each of which may optionally have a substituent, which is the same as R' in the "substituent group W" shown below;
one of R¹¹ to R¹³ has a structure represented by formula (2) below; and the remaining two are each selected from a [substituent group Z] shown below: 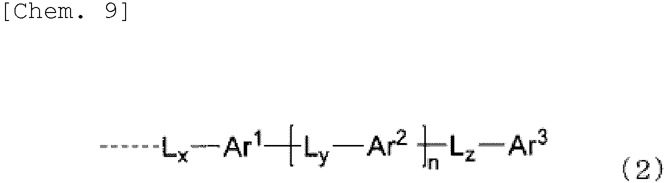
wherein, in formula (2) above, a broken line represents a bond to formula (1');
n represents an integer of 1 to 10;
when a plurality of L_{y}'s and a plurality of Ar²'s are present, they may be the same or different;
Lₓ, L_{y}, and L_{z} are each independently a direct bond or selected from -O-, -S-, -NR'-, -Si(R')₂-, -B(R')-, -C(=O)-, -P(=O) (R')-, -S(=O)₂-, -OSO₂-, and alkylene groups having 1 to 30 carbon atoms, wherein each of the alkylene groups may be optionally substituted with at least one R', wherein one -CH₂- group or 2 or more non-adjacent -CH₂- groups in each alkylene group may be replaced with -C(-R')=C(-R')-, -C=C-, -Si(-R')₂-, -C(=O)-, -NR'-, -O-, -S-, or -CONR'-, wherein R' is the same as R' in the [substituent group W] shown below, and wherein at least one hydrogen atom in these groups may be replaced with F, Cl, Br, I, or -CN;
Ar¹ and Ar² each independently represent a divalent 5- or 6-membered aromatic hydrocarbon group or a divalent 5- or 6-membered aromatic heterocyclic group; Ar¹ and Ar² may each optionally have a substituent selected from the [substituent group Z] shown below;
Ar³ represents a monovalent 5- or 6-membered aromatic hydrocarbon group or a monovalent 5- or 6-membered aromatic heterocyclic group; and Ar³ may optionally have a substituent selected from the [substituent group Z] shown below:

### [substituent group W]

substituents selected from a hydrogen atom, F, Cl, Br, I, -N(R')₂, -CN, -NO₂, -OH, -SH, -COOR', -C(=O)R', -C(=O)NR', -P(=O) (R')₂, -S(=O)R', -S(=O)₂R', -OS(=O)₂R', -SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms,
wherein the alkyl groups, the alkoxy groups, the alkylthio groups, the alkenyl groups, and the alkynyl groups may each be optionally substituted with at least one R', wherein one -CH₂- group or 2 or more non-adjacent -CH₂-groups in each of these groups may be optionally replaced with -C(-R')=C(-R')-, -C=C-, -Si(-R')₂, -C(=O)-, -NR'-, -O-, -S-, -CONR'-, a divalent aromatic hydrocarbon group, or a divalent aromatic heterocyclic group, wherein at least one hydrogen atom in each of these groups may be optionally replaced with F, Cl, Br, I, or -CN, and
wherein the aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each independently be optionally substituted with at least one R';
R's are each independently selected from a hydrogen atom, F, Cl, Br, I, -N(R'')₂, -OH, -SH, -CN, -NO₂, -Si(R")₃, -B(OR'')₂, -C(=O)R", -P(=O)(R")₂, -S(=O)₂R", -OSO₂R", linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms,
wherein the alkyl groups, the alkoxy groups, the alkylthio groups, the alkenyl groups, and the alkynyl groups may each be optionally substituted with at least one R", wherein one -CH₂- group or 2 or more non-adjacent -CH₂-groups in each of these groups may be optionally replaced with -C(-R")=C(-R") -, -C=C-, -Si(-R")₂-, -C(=O)-, -NR' '-, -O-, -S-, -CONR''-, a divalent aromatic hydrocarbon group, or a divalent aromatic heterocyclic group, wherein at least one hydrogen atom in each of these groups may be replaced with F, Cl, Br, I, or -CN,
wherein the aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each be optionally substituted with at least one R", and wherein two or more adjacent R's may be bonded together while losing respective hydrogen atoms to thereby form an aliphatic, aromatic hydrocarbon, or aromatic heterocyclic monocyclic or condensed ring;
R"s are each independently selected from a hydrogen atom, F, -CN, aliphatic hydrocarbon groups having 1 to 20 carbon atoms, aromatic hydrocarbon groups having 5 to 20 carbon atoms, and aromatic heterocyclic groups having 5 to 20 carbon atoms; and two or more adjacent R"s may be bonded together while losing respective hydrogen atoms to form an aliphatic, aromatic hydrocarbon, or aromatic heterocyclic monocyclic or condensed ring:

### [substituent group Z]

substituents selected from a hydrogen atom, F, Cl, Br, I, -N(R')₂, -CN, -NO₂, -OH, -SH, -COOR', -C(=O)R', -C(=O)NR', -P(=O)(R')₂, -S(=O)R', -S(=O)₂R', -OS(=O)₂R', -SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms, wherein the alkyl groups, the alkoxy groups, the alkylthio groups, the aryloxy groups, the arylthio groups, the aralkyl groups, the heteroaralkyl groups, the diarylamino groups, the arylheteroarylamino groups, and the diheteroarylamino groups may each be optionally substituted with at least one R', and wherein R' is the same as R' in the [substituent group W] above].

[16] The iridium complex compound according to [15], wherein R¹¹ has a structure represented by formula (2) above.

[17] The iridium complex compound according to [15] or [16], wherein R¹, R⁶ to R¹⁰, and R¹⁴ are each a hydrogen atom.

[18] The iridium complex compound according to any one of [15] to [17], wherein R¹⁵ and R¹⁶ are each independently a linear, branched, or cyclic alkyl group having 1 to 8 carbon atoms.

[19] The iridium complex compound according to any one of [15] to [18], wherein n in formula (2) above is 5 or less.

[20] The iridium complex compound according to any one of [15] to [19], wherein Ar¹ and Ar² are each independently a phenylene group optionally having a substituent, and wherein Ar³ is a phenyl group optionally having a substituent.

[21] The iridium complex compound according to [20], wherein Ar¹ and Ar² are each independently a phenylene group optionally having, as a substituent, a linear, branched, or cyclic alkyl group having 1 to 30 carbon atoms, and wherein Ar³ is a phenyl group optionally having, as a substituent, a linear, branched, or cyclic alkyl group having 1 to 30 carbon atoms.

[22] The iridium complex compound according to any one of [15] to [21], wherein formula (1') above is represented by formula (3), (4), or (5) below: 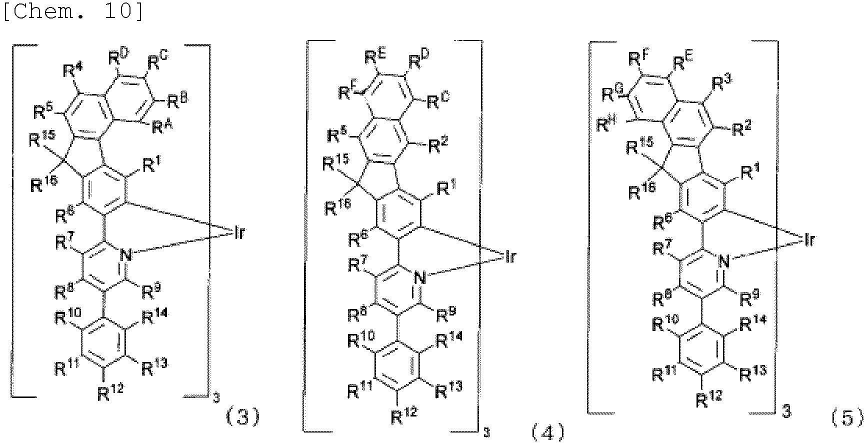 [wherein, in formulas (3) to (5),
R¹ to R¹⁶ are the same as R¹ to R¹⁶ in formula (1');
R^{A} and R^{B} are each the same as R²;
R^{C} and R^{D} are each the same as R³;
R^{E} and R^{F} are each the same as R⁴; and
R^{G} and R^{H} are each the same as R⁵].

[23] An organic electroluminescent element composition comprising the iridium complex compound according to any one of [15] to [22] .

[24] The organic electroluminescent element composition according to [23], further comprising a phosphorescent light-emitting material represented by formula (201) below: 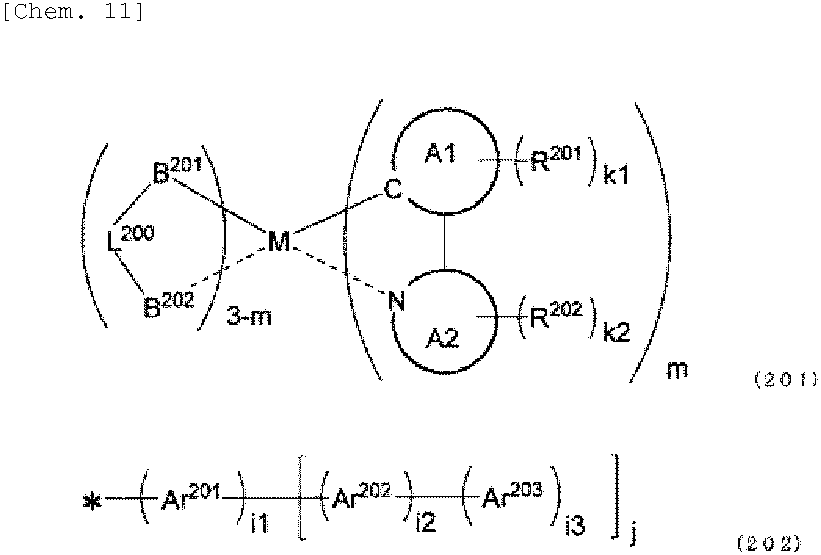
[wherein, in formula (201) above, M is a metal selected from groups 7 to 11 of a periodic table;
ring A1 represents an aromatic hydrocarbon ring structure optionally having a substituent or an aromatic heterocyclic structure optionally having a substituent;
ring A2 represents an aromatic heterocyclic structure optionally having a substituent;
R²⁰¹ and R²⁰² are each independently a structure represented by formula (202) above; "*" represents a bond to ring A1 or ring A2; R²⁰¹ and R²⁰² may be the same or different; when a plurality of R²⁰¹'s are present, they may be the same or different; when a plurality of R²⁰² 's are present, they may be the same or different;
Ar²⁰¹ represents a divalent aromatic hydrocarbon ring structure optionally having a substituent or a divalent aromatic heterocyclic structure optionally having a substituent; when a plurality of Ar²⁰¹'s are present, they may be the same or different;
Ar²⁰² represents a divalent aromatic hydrocarbon ring structure optionally having a substituent, a divalent aromatic heterocyclic structure optionally having a substituent, or a divalent aliphatic hydrocarbon structure optionally having a substituent; when a plurality of Ar²⁰²'s are present, they may be the same or different;
Ar²⁰³ represents a monovalent aromatic hydrocarbon ring structure optionally having a substituent or a monovalent aromatic heterocyclic structure optionally having a substituent; when a plurality of Ar²⁰³'s are present, they may be the same or different;
substituents bonded to ring A1, substituents bonded to ring A2, or a substituent bonded to ring A1 and a substituent bonded to ring A2 may be bonded together to form a ring;
B²⁰¹-L²⁰⁰-B²⁰² represents an anionic bidentate ligand;
B²⁰¹ and B²⁰² each independently represent a carbon atom, an oxygen atom, or a nitrogen atom; these atoms may each be an atom included in a ring;
L²⁰⁰ represents a single bond or an atomic group that, together with B²⁰¹ and B²⁰², forms the bidentate ligand;
when a plurality of B²⁰¹-L²⁰⁰-B²⁰² moieties are present, they may be the same or different;
i1 and i2 are each independently an integer of 0 or more and 12 or less;
i3 is an integer of 0 or more, with the upper limit thereof being the number of substituents that Ar²⁰² can have;
j is an integer of 0 or more, with the upper limit thereof being the number of substituents that Ar²⁰¹ can have;
k1 and k2 are each independently an integer of 0 or more, with the upper limit thereof being the number of substituents that ring A1 or A2 can have; and
m is an integer of 1 to 3].

[25] The organic electroluminescent element composition according to [24], wherein a combination of (ring A1 - ring A2) in formula (201) above is (benzene ring-pyridine ring-triazine ring), (benzene ring-quinoline ring), (benzene ring-quinoxaline ring), (benzene ring-quinazoline ring), (benzene ring-imidazole ring), or (benzene ring-benzothiazole ring).

[26] An organic electroluminescent element comprising an anode and a cathode that are disposed on a substrate and further comprising an organic layer between the anode and the cathode, wherein the organic layer contains the iridium complex compound according to any one of [15] to [22].

[27] An organic electroluminescent element comprising an anode and a cathode that are disposed on a substrate and further comprising an organic layer between the anode and the cathode, wherein the organic layer contains the organic electroluminescent element composition according to any one of [23] to [25].

[28] The organic electroluminescent element according to [26] or [27], wherein the organic layer is a light-emitting layer.

[29] A display device comprising the organic electroluminescent element according to any one of [26] to [28] .

[30] The organic electroluminescent element composition according to any one of [23] to [25], further comprising an organic solvent.

[31] A method for producing an organic electroluminescent element including an anode and a cathode that are disposed on a substrate and further including an organic layer between the anode and the cathode, the method comprising the step of forming the organic layer by a wet deposition method using the organic electroluminescent element composition according to [30].

[32] The method for producing an organic electroluminescent element according to [31], wherein the organic layer is a light-emitting layer.

### Advantageous Effects of Invention

The organic electroluminescent element composition of the invention contains, as an assist dopant, an iridium complex having a ligand including a fluorene ring and further contains, as a light-emitting dopant, an iridium complex having a triazine ring having a longer maximum emission wavelength than the assist dopant. Therefore, an organic electroluminescent element having higher luminous efficiency and a longer driving lifetime than conventional products can be produced. In particular, the organic electroluminescent element can be produced as a red element by a wet deposition method. The organic electroluminescent element provided can have higher luminous efficiency and a longer driving lifetime than conventional products.

In the organic electroluminescent element composition of the invention, iridium complexes having respective ligands including fluorene rings having the same structure may be used as an assist dopant and a light-emitting dopant. In this case, energy transfer from the assist dopant to the light-emitting dopant can be utilized at maximum efficiency, and an organic electroluminescent element having a longer driving lifetime can be produced.

The iridium complex compound of the invention has high solvent solubility. When the iridium complex compound is used as an assist dopant of a red organic EL element, its luminous efficiency can be improved. Moreover, when the iridium complex compound is used as a light-emitting material, an organic EL element that emits yellowish green to yellow to orange light with a narrow half-value width at high efficiency can be produced.

### Brief Description of Drawing

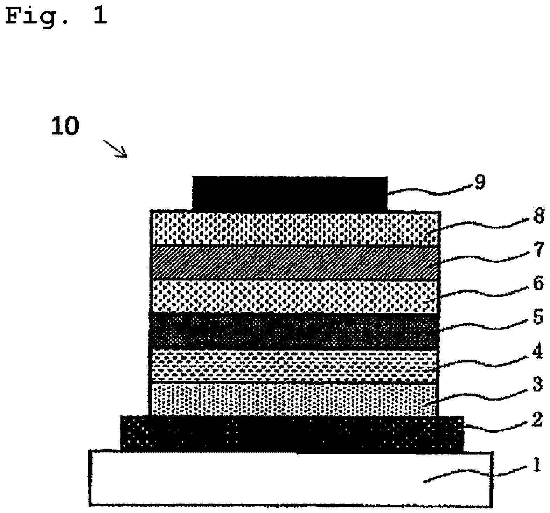

[Fig. 1] A cross-sectional view schematically showing an example of the structure of the organic electroluminescent element of the invention.

### Description of Embodiments

Embodiments of the invention will be described in detail. However, the invention is not limited to the following embodiments and can be embodied in various modified forms within the scope of the invention.

In the present description, the term "hydrogen atom (H)" is intended to encompass a deuterium atom (D), which is an isotope of hydrogen.

In the present description, a (hetero)aralkyl group, a (hetero)aryloxy group, and a (hetero)aryl group represent an aralkyl group optionally including a heteroatom, an aryloxy group optionally including a heteroatom, and an aryl group optionally including a heteroatom, respectively. The phrase "optionally including a heteroatom" means that one or two or more of the carbon atoms forming the aryl skeleton in the main skeleton of an aryl, aralkyl, or aryloxy group may each be replaced with a heteroatom. Examples of the heteroatom include a nitrogen atom, an oxygen atom, a sulfur atom, a phosphorus atom, and a silicon atom. Of these, a nitrogen atom is preferred in terms of durability.

In the present description, the term "(hetero)aryl group" is used to include a monocyclic group, a bicyclic, tetracyclic, or tetracyclic condensed ring group, and a group in which a plurality of groups selected from monocyclic rings and bicyclic to tetracyclic condensed ring groups are linked together.

The (hetero)aryl group represents an aryl group optionally including a heteroatom, i.e., an aryl group or a heteroaryl group. The aryl group is an aromatic hydrocarbon group, and the heteroaryl group is an aromatic heterocyclic group.

### [Organic electroluminescent element composition]

An organic electroluminescent element composition according to an embodiment of the invention contains a compound represented by formula (31) below and further contains a compound represented by formula (32) below or a compound represented by formula (1) below.

### [Light-emitting dopant]

The light-emitting dopant is a dopant that emits light when excited by receiving excitation energy from an assist dopant described later.

The organic electroluminescent element composition in the present embodiment contains the compound represented by formula (31) below, and this compound functions mainly as the light-emitting dopant. The composition may contain only one or a plurality of compounds represented by formula (31). The compound serving as the light-emitting dopant may include a light-emitting dopant compound other than the compound represented by formula (31). When a light-emitting dopant compound other than the compound represented by formula (31) is contained, the total content of the compound represented by formula (31) with respect to the total amount of the compounds serving as light-emitting dopants is preferably 50% by mass or more and more preferably 100% by mass. It is more preferable that only the compound represented by formula (31) is used as the light-emitting dopant.

### [Compound represented by formula (31)]

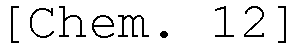

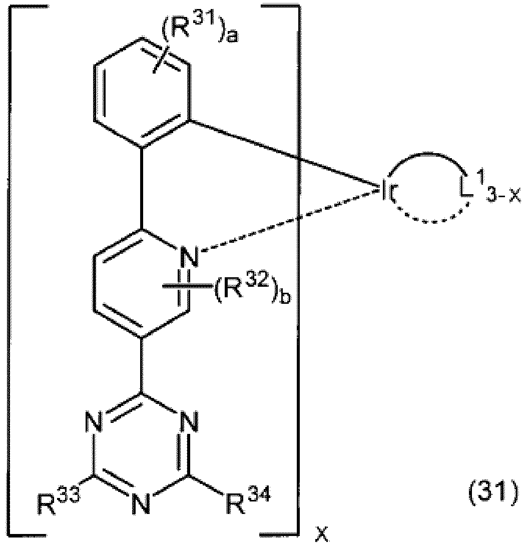

In the above formula, Ir represents an iridium atom.

R³¹ and R³² are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms. Each of which may optionally have a substituent.

When a plurality of R³¹'s or R³²'s are present, they may be the same or different.

When a plurality of R³¹'s are present, adjacent R³¹'s may be bonded together to form a ring.

a is an integer of 0 to 4. b is an integer of 0 to 3.

R³³ and R³⁴ are each independently a hydrogen atom, a fluorine atom, a chlorine atom, a bromine atom, an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 20 carbon atoms. Each of which may optionally have a substituent.

When a plurality of R³³'s or R³⁴'s are present, they may be the same or different.

L¹ represents an organic ligand. x is an integer of 1 to 3.

From the viewpoint of durability, R³¹ to R³⁴ are each independently preferably an alkyl group having 1 to 20 carbon atoms, a (hetero)aralkyl group having 7 to 40 carbon atoms, an arylamino group having 6 to 20 carbon atoms, a (hetero)aryl group having 3 to 30 carbon atoms, or a (hetero)aryl group having 3 to 20 carbon atoms, more preferably an alkyl group having 1 to 20 carbon atoms, a (hetero)aralkyl group having 7 to 40 carbon atoms, or a (hetero)aryl group having 3 to 20 carbon atoms, and still more preferably an alkyl group having 1 to 20 carbon atoms, an aralkyl group having 7 to 40 carbon atoms, or an aryl group having 6 to 20 carbon atoms.

The optional substituents on R³¹ to R³⁴ are each preferably a substituent selected from a substituent group Z described later.

When a is 2 or more, two adjacent R³¹'s may be bonded together to form a ring condensed with the benzene ring having the R³¹'s.

When a plurality of R³¹'s are present, adjacent R³¹'s may be bonded together to form a condensed ring, and examples of the condensed ring include a fluorene ring, a naphthalene ring, a dibenzothiophene ring, and a dibenzofuran ring. From the viewpoint of stability, a fluorene ring is particularly preferred.

From the viewpoint of shifting the emission wavelength to the long wavelength side, it is preferable that adjacent R³¹'s are bonded together to form a ring.

From the viewpoint of not shifting the emission wavelength to the long wavelength side, it is preferable that adjacent R³¹'s are not bonded together to form a ring. Specifically, it is preferable that a in formula (31) is 1 or is 2 or more, provided that adjacent R³¹'s are not bonded together to form a ring.

a is preferably 0 in terms of ease of production and is preferably 1 or 2 and more preferably 1 because the durability and solubility are improved.

b is preferably 0 in terms of ease of production and is preferably 1 because the solubility is improved.

x is preferably 2 or 3 and more preferably 3 because a large number of structures each including a triazine ring having high electron acceptability are present and the LUMO is further stabilized.

L¹ is an organic ligand, and no particular limitation is imposed on L¹. L¹ is preferably a monovalent bidentate ligand and is more preferably selected from formulas (33), (34), and (35) below. Broken lines in formulas (33), (34), and (35) each represent a coordinate bond. In formulas (33), (34), and (35), N² represents that the coordinate bond extends from a nitrogen atom in ring B, and C² represents a carbon atom to which a benzene ring having R⁴² is bonded. When two organic ligands L¹'s are present, the organic ligands L¹'s may have mutually different structures. When x is 3, no L¹ is present.

When x in formula (31) is 2 or less, it is preferable that each L¹ has at least one structure selected from the group consisting of formulas (33), (34), and (35) below.

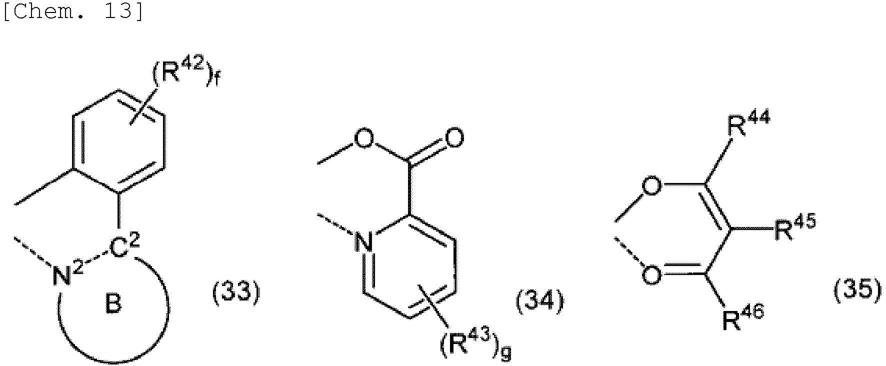

In formulas (33), (34), and (35) above, R⁴² and R⁴³ are the same as R³¹ in formula (1) above. Specifically, R⁴² and R⁴³ are each selected from the same group as that for the substituent selected as R³¹. Preferred examples thereof are also the same, and they may each optionally have a substituent. When a plurality of R⁴²'s or R⁴³'s are present, they may be the same or different.

R⁴⁴ to R⁴⁶ are each independently a hydrogen atom, an alkyl group having 1 to 20 carbon atoms and optionally substituted with a fluorine atom, a phenyl group optionally substituted with an alkyl group having 1 to 20 carbon atoms, or a halogen atom.

f is an integer of 0 to 4. g is an integer of 0 to 4.

Ring B is a pyridine ring, a pyrimidine ring, an imidazole ring, a quinoline ring, an isoquinoline ring, a quinazoline ring, a quinoxaline ring, an azatriphenylene ring, a carboline ring, a benzothiazole ring, or a benzoxazole ring. Ring B may optionally have a substituent.

Preferably, the optional substituents on R⁴², R⁴³, and ring B are each selected from the substituent group Z described later.

Preferred R⁴² and R⁴³ are each independently an alkyl group having 1 to 20 carbon atoms or an aryl group having 6 to 30 carbon atoms and optionally substituted with an alkyl group having 1 to 20 carbon atoms. The aryl group having 6 to 30 carbon atoms is a monocyclic ring, a bicyclic condensed ring, a tricyclic condensed ring, or a group in which a plurality of monocyclic rings, bicyclic condensed rings, or tricyclic condensed rings are linked together.

f and g are each preferably 0 in terms of ease of production and are each preferably 1 or 2 and more preferably 1 because the solubility is improved.

R⁴⁴ to R⁴⁶ each independently represent a hydrogen atom, an alkyl group having 1 to 20 carbon atoms and optionally substituted with a fluorine atom, a phenyl group optionally substituted with an alkyl group having 1 to 20 carbon atoms, or a halogen atom. Preferably, R⁴⁴ and R⁴⁶ are each independently a methyl group or a t-butyl group, and R⁴⁵ is a hydrogen atom, an alkyl group having 1 to 20 carbon atoms, or a phenyl group.

From the viewpoint of durability, ring B is preferably a pyridine ring, a pyrimidine ring, or an imidazole ring and more preferably a pyridine ring.

Preferably, from the viewpoint that the durability and solubility are improved, a hydrogen atom on ring B is replaced with an alkyl group having 1 to 20 carbon atoms, a (hetero)aralkyl group having 7 to 40 carbon atoms, or a (hetero)aryl group having 3 to 20 carbon atoms.

From the viewpoint of ease of production, it is preferable that the hydrogen atoms on ring B are unsubstituted.

From the viewpoint that, when the composition is used for an organic electroluminescent element, excitons are easily generated and the luminous efficiency is improved, it is preferable that a hydrogen atom on ring B is replaced with a phenyl group optionally having a substituent or a naphthyl group optionally having a substituent. The optional substituents on the phenyl and naphthyl groups are each preferably a substituent selected from a substituent group Q described later.

Preferably, ring B is a quinoline ring, an isoquinoline ring, a quinazoline ring, a quinoxaline ring, an azatriphenylene ring, or a carboline ring because excitons are easily generated on the assist dopant and the luminous efficiency is improved. In particular, a quinoline ring, an isoquinoline ring, and a quinazoline ring are preferred from the viewpoint of durability and emission of red light.

A preferred substituent on ring B is an alkyl group having 1 to 20 carbon atoms or an aryl group having 6 to 20 carbon atoms and optionally substituted with an alkyl group having 1 to 20 carbon atoms. The aryl group having 6 to 20 carbon atoms is a monocyclic ring, a bicyclic condensed ring, a tricyclic condensed ring, or a group in which a plurality of monocyclic rings, bicyclic condensed rings, or tricyclic condensed rings are linked together.

The light-emitting dopant represented by formula (31) and contained in the organic electroluminescent element composition in the present embodiment has preferably a structure in which a is 2 or more and adjacent R³¹'s are bonded together to form a fluorene ring. In particular, a compound represented by formula (31-1) is preferred.

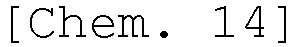

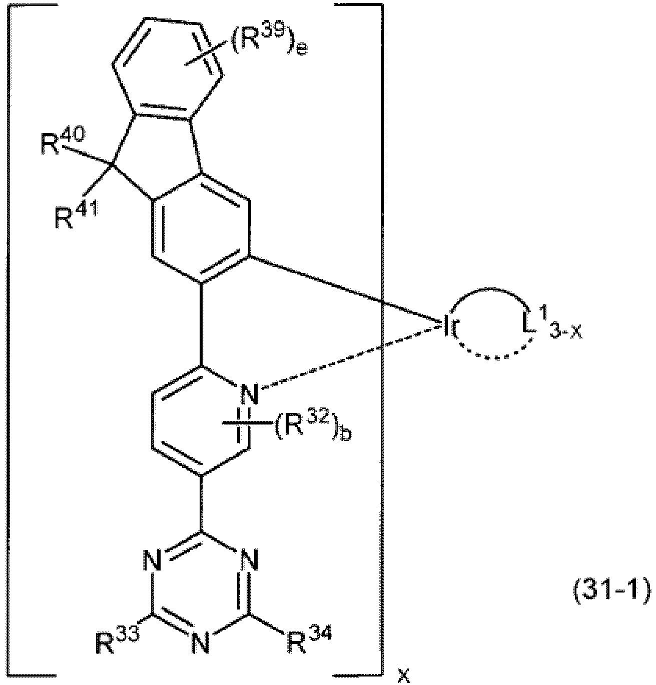

In the above formula, Ir represents an iridium atom.

R³² to R³⁴, b, L¹, and x are the same as R³² to R³⁴, b, L¹, and x, respectively, in formula (31) above.

R³⁹ to R⁴¹ are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms. Each of which may optionally have a substituent. When a plurality of R³⁹'s, R⁴⁰'s, or R⁴¹'s are present, they may be the same or different. When a plurality of R³⁹'s are present, adjacent R³⁹'s may be bonded together to form a ring.

e is an integer of 0 to 4.

R³⁹ is a substituent on R³¹ when R³¹ is a phenyl group and is preferably a substituent selected from the substituent group Q described later. R³⁹ is more preferably an alkyl group having 1 to 20 carbon atoms or an aromatic hydrocarbon group having 6 to 30 carbon atoms and optionally substituted with an alkyl group having 1 to 20 carbon atoms. The aromatic hydrocarbon group having 6 to 30 carbon atoms is a monocyclic ring, a bicyclic, tricyclic, or tetracyclic condensed ring, or a group in which a plurality of monocyclic rings or bicyclic to tetracyclic condensed rings are linked together. R³⁹ is still more preferably an alkyl group having 1 to 20 carbon atoms and yet more preferably an alkyl group having 1 to 8 carbon atoms.

R⁴⁰ and R⁴¹ are each a substituent on R³¹ when R³¹ or part of R³¹ is a methyl group and are each independently preferably an alkyl group having 1 to 20 carbon atoms, an aromatic hydrocarbon group having 6 to 30 carbon atoms and optionally substituted with an alkyl group having 1 to 20 carbon atoms, an alkoxy group having 1 to 20 carbon atoms, or an aromatic hydrocarbon group having 6 to 30 carbon atoms and optionally substituted with an alkoxy group having 1 to 20 carbon atoms. The aromatic hydrocarbon group having 6 to 30 carbon atoms is a monocyclic group, a bicyclic, tricyclic, or tetracyclic condensed ring, or a group in which a plurality of monocyclic rings or bicyclic to tetracyclic condensed rings are linked together. R⁴⁰ and R⁴¹ are each more preferably an alkyl group having 1 to 20 carbon atoms or an aromatic hydrocarbon group having 6 to 12 carbon atoms and optionally substituted with an alkyl group having 1 to 20 carbon atoms and still more preferably an alkyl group having 1 to 8 carbon atoms or an aromatic hydrocarbon group having 6 carbon atoms and optionally substituted with an alkyl group having 1 to 8 carbon atoms. The aromatic hydrocarbon structure having 6 carbon atoms is a benzene structure, and an aromatic hydrocarbon structure having 12 carbon atoms is a biphenyl structure.

Specific examples of the preferred alkyl groups in R³⁹ to R⁴¹ include a methyl group, an ethyl group, a n-propyl group, a n-butyl group, a n-pentyl group, a n-hexyl group, a n-octyl group, an isopropyl group, an isobutyl group, an isopentyl group, a t-butyl group, a cyclohexyl group, and a 2-ethylhexyl group.

Specific examples of the preferred aromatic hydrocarbon groups in R³¹ to R⁴¹ include a benzene ring, a naphthalene ring, an anthracene ring, a phenanthrene ring, a perylene ring, a tetracene ring, a pyrene ring, a benzpyrene ring, a chrysene ring, a triphenylene ring, a fluoranthene ring, a biphenyl group, and a terphenyl group each having a free valence of 1.

Specific examples of the preferred alkoxy groups in R⁴⁰ and R⁴¹ include a methoxy group, an ethoxy group, a propyloxy group, an isopropyloxy group, a hexyloxy group, a cyclohexyloxy group, and an octadecyloxy group.

### <Substituent group Q>

Each of the substituents used may be an alkyl group, an aralkyl group, a heteroaralkyl group, an alkoxy group, an aryloxy group, a heteroaryloxy group, an alkylsilyl group, an arylsilyl group, an alkylcarbonyl group, an arylcarbonyl group, an alkylamino group, an arylamino group, an aryl group, or a heteroaryl group.

Each substituent is preferably an alkyl group having 1 to 20 carbon atoms, an aralkyl group having 7 to 40 carbon atoms, a heteroaralkyl group having 7 to 40 carbon atoms, an alkoxy group having 1 to 20 carbon atoms, an aryloxy group having 6 to 20 carbon atoms, a heteroaryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, an aryl group having 6 to 30 carbon atoms, or a heteroaryl group having 3 to 30 carbon atoms. Each substituent is more specifically a substitute described later in "Specific examples of substituent."

Each substituent is more preferably an alkyl group having 1 to 20 carbon atoms, an aralkyl group having 7 to 40 carbon atoms, an alkoxy group having 1 to 20 carbon atoms, an aryloxy group having 6 to 20 carbon atoms, or an aryl group having 6 to 30 carbon atoms.

### <Specific examples of substituent>

Specific examples of the substituents on the structures of the compounds described above and the substituents in the substituent group Q are as follows.

The alkyl group having 1 to 20 carbon atoms may be any of linear, branched, and cyclic alkyl groups. More specific examples include a methyl group, an ethyl group, a n-propyl group, a n-butyl group, a n-pentyl group, a n-hexyl group, a n-octyl group, an isopropyl group, an isobutyl group, an isopentyl group, a t-butyl group, and a cyclohexyl group. In particular, a linear alkyl group having 1 to 8 carbon atoms such as a methyl group, an ethyl group, a n-butyl group, a n-hexyl group, or a n-octyl group is preferred.

The (hetero)aralkyl group having 7 to 40 carbon atoms is a group in which some of the hydrogen atoms included in a linear, branched, or cyclic alkyl group are each replaced with an aryl group or a heteroaryl group. More specific examples include a 2-phenyl-1-ethyl group, a cumyl group, a 5-phenyl-1-pentyl group, a 6-phenyl-1-hexyl group, a 7-phenyl-1-heptyl group, and a tetrahydronaphthyl group. Of these, a 5-phenyl-1-pentyl group, a 6-phenyl-1-hexyl group, and a 7-phenyl-1-heptyl group are preferred.

Specific examples of the alkoxy group having 1 to 20 carbon atoms include a methoxy group, an ethoxy group, a propyloxy group, an isopropyloxy group, a hexyloxy group, a cyclohexyloxy group, and an octadecyloxy group. Of these, a hexyloxy group is preferred.

Specific examples of the (hetero)aryloxy group having 3 to 20 carbon atoms include a phenoxy group and a 4-methylphenyloxy group. Of these, a phenoxy group is preferred.

In the alkylsilyl group having 1 to 20 carbon atoms, any alkyl group may be replaced with an aryl group. Specific examples thereof include a trimethylsilyl group, a triethylsilyl group, a triisopropylsilyl group, a dimethylphenylsilyl group, a t-butyldimethylsilyl group, and a t-butyldiphenylsilyl group. Of these, a triisopropylsilyl group, a t-butyldimethylsilyl group, and a t-butyldiphenylsilyl group are preferred.

Specific examples of the arylsilyl group having 6 to 20 carbon atoms include a diphenylpyridylsilyl group and a triphenylsilyl group. Of these, a triphenylsilyl group is preferred.

Specific examples of the alkylcarbonyl group having 2 to 20 carbon atoms include an acetyl group, a propionyl group, a pivaloyl group, a caproyl group, a decanoyl group, and a cyclohexylcarbonyl group. Of these, an acetyl group and a pivaloyl group are preferred.

Specific examples of the arylcarbonyl group having 7 to 20 carbon atoms include a benzoyl group, a naphthoyl group, and an anthroyl group. Of these, a benzoyl group is preferred.

Specific examples of the alkylamino group having 1 to 20 carbon atoms include a methylamino group, a dimethylamino group, a diethylamino group, an ethylmethylamino group, a dihexylamino group, a dioctylamino group, and a dicyclohexylamino group. Of these, a dimethylamino group and a dicyclohexylamino group are preferred.

Specific examples of the arylamino group having 6 to 20 carbon atoms include a phenylamino group, a diphenylamino group, a di(4-tolyl)amino group, and a di(2,6-dimethylphenyl)amino group. Of these, a diphenylamino group and a di(4-tolyl)amino group are preferred.

The (hetero)aryl group having 3 to 30 carbon atoms means an aromatic hydrocarbon group, an aromatic heterocyclic group, a linked aromatic hydrocarbon group including a plurality of aromatic hydrocarbons linked together, a linked aromatic heterocyclic group including a plurality of aromatic heterocyclic groups linked together, or a group in which at least one aromatic hydrocarbon and at least one aromatic heterocyclic ring are linked together, each of which has a free valence of 1.

Specific examples thereof include a benzene ring, a naphthalene ring, an anthracene ring, a phenanthrene ring, a perylene ring, a tetracene ring, a pyrene ring, a benzpyrene ring, a chrysene ring, a triphenylene ring, a fluoranthene ring, a furan ring, a benzofuran ring, a dibenzofuran ring, a thiophene ring, a benzothiophene ring, a dibenzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a cinnoline ring, a quinoxaline ring, a perimidine ring, a quinazoline ring, a quinazolinone ring, and an azulene ring, each of which has a free valence of 1.

Examples of the linked aromatic hydrocarbon group including a plurality of aromatic hydrocarbons linked together include a biphenyl group and a terphenyl group.

From the viewpoint of durability, the (hetero)aryl group is preferably a benzene ring, a naphthalene ring, a dibenzofuran ring, a dibenzothiophene ring, a carbazole ring, a pyridine ring, a pyrimidine ring, or a triazine ring each having a free valence of 1, more preferably an aryl group having 6 to 18 carbon atoms such as a benzene, naphthalene, or phenanthrene ring having a free valence of 1 and optionally substituted with an alkyl group having 1 to 8 carbon atoms or a pyridine ring having a free valence of 1 and optionally substituted with an alkyl group having 1 to 4 carbon atoms, and still more preferably an aryl group having 6 to 18 carbon atoms such a benzene, naphthalene, or phenanthrene ring having a free valence of 1 and optionally substituted with an alkyl group having 1 to 8 carbon atoms.

Each group in the compound may have a plurality of substituents. Examples of the combination of the substituents used include, but not limited to, a combination of an aryl group and an alkyl group, a combination of an aryl group and an aralkyl group, and a combination of an aryl group, an alkyl group, and an aralkyl group. Examples of the combination of an aryl group and an aralkyl group include a combination of a phenyl group, a biphenyl group, or a terphenyl group and a 5-phenyl-1-pentyl group or a 6-phenyl-1-hexyl group.

Preferred specific examples of the compound represented by formula (31) and used as the light-emitting dopant contained in the organic electroluminescent element composition in the present embodiment are shown below, but the invention is not limited thereto. These groups are examples other than those shown in Examples.

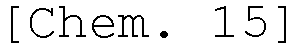

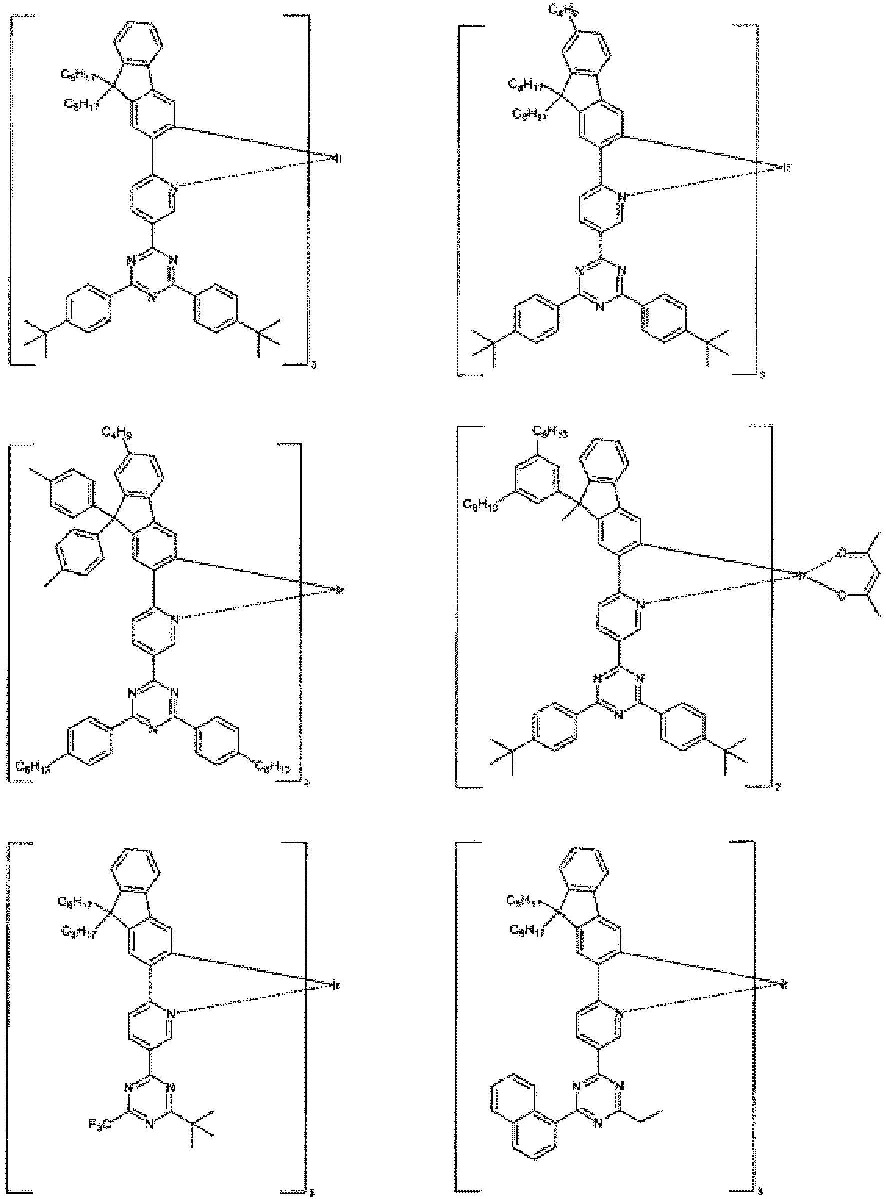

### [Assist dopant]

The assist dopant is a dopant that has a shorter maximum emission wavelength than the light-emitting dopant and that, when excited, gives energy to the light-emitting dopant having lower excitation energy.

The organic electroluminescent element composition in the present embodiment contains the compound represented by formula (32) below or the compound represented by formula (1) below, and these compounds each mainly function as the assist dopant. The compound represented by formula (32) or the compound represented by formula (1) below has a shorter maximum emission wavelength than the compound represented by formula (31) serving as the light-emitting dopant described above. Therefore, when the assist dopant represented by formula (32) or (1) is excited, energy transfer to the light-emitting dopant represented by formula (31) and having lower excitation energy occurs. In this case, the light-emitting dopant is excited, and then light emission from the light-emitting dopant is observed.

The organic electroluminescent element composition in the present embodiment may contain only one compound represented by formula (32) or a plurality of compounds represented by formula (32).

The organic electroluminescent element composition in the present embodiment may contain only one compound represented by formula (1) or a plurality of compounds represented by formula (1).

In the following description, when the organic electroluminescent element composition in the present embodiment contains the compound represented by formula (31) as the light-emitting dopant and the compound represented by formula (32) as the assist dopant, this composition is referred to as "embodiment I." When the organic electroluminescent element composition in the present embodiment contains the compound represented by formula (31) as the light-emitting dopant and the compound represented by formula (1) as the assist dopant, this composition is referred to as "embodiment II."

The organic electroluminescent element composition in the present embodiment may contain one or two or more compounds represented by formula (32) and one or two or more compounds represented by formula (1).

The compound serving as the assist dopant may include a compound serving as the assist dopant other than the compound represented by formula (32) and/or the compound represented by formula (1). In this case, the total content of the compound represented by formula (32) and/or the compound represented by formula (1) with respect to the total amount of the compounds serving as the assist dopant is preferably 50% by mass or more and more preferably 100% by mass. Specifically, it is more preferable that the compound serving as the assist dopant includes only the compound represented by formula (32) and/or the compound represented by formula (1).

### [Compound represented by formula (32)]

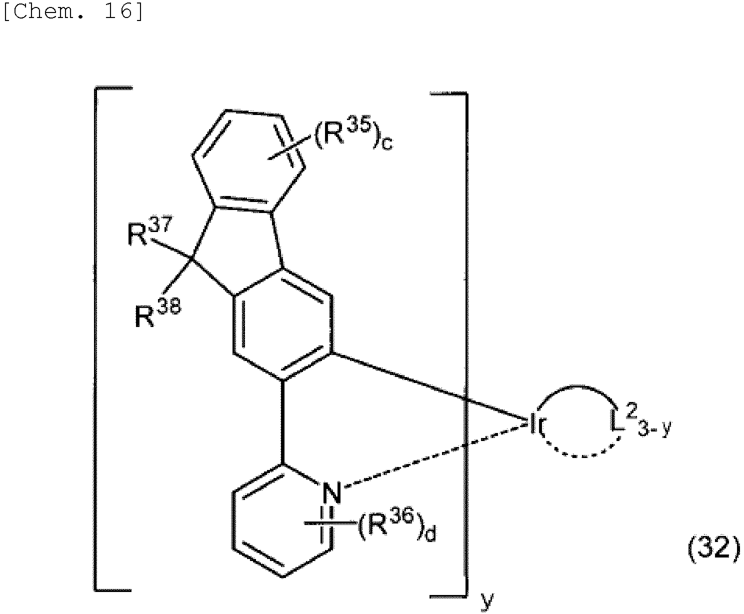

In the above formula, Ir represents an iridium atom.

R³⁵ to R³⁸ are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms. Each of which may optionally have a substituent.

When a plurality of R³⁵'s, R³⁶'s, R³⁷'s, or R³⁸'s are present, they may be the same or different.

When a plurality of R³⁵'s are present, adjacent R³⁵'s may be bonded together to form a ring.

c and d are each independently an integer of 0 to 4.

L² represents an organic ligand. y is an integer of 1 to 3.

From the viewpoint of durability, R³⁵, R³⁷, and R³⁸ are each independently more preferably an alkyl group having 1 to 20 carbon atoms, a (hetero)aralkyl group having 7 to 40 carbon atoms, an arylamino group having 6 to 20 carbon atoms, a (hetero)aryl group having 3 to 30 carbon atoms, or a (hetero)aryl group having 3 to 20 carbon atoms, still more preferably an alkyl group having 1 to 20 carbon atoms, a (hetero)aralkyl group having 7 to 40 carbon atoms, or a (hetero)aryl group having 3 to 20 carbon atoms, and yet more preferably an alkyl group having 1 to 20 carbon atoms, an aralkyl group having 7 to 40 carbon atoms, or an aryl group having 6 to 20 carbon atoms.

The optional substituents on R³⁵, R³⁷, and R³⁸ are each preferably a substituent selected from the substituent group Q described above.

When c is 2 or more, two adjacent R³⁵'s may be bonded together to form a ring.

From the viewpoint of durability, R³⁶ is more preferably an alkyl group having 1 to 20 carbon atoms, a (hetero)aralkyl group having 7 to 40 carbon atoms, an arylamino group having 6 to 20 carbon atoms, or a (hetero)aryl group having 3 to 30 carbon atoms. The (hetero)aryl group having 3 to 30 carbon atoms is a monocyclic group, a bicyclic, tricyclic, or tetracyclic condensed ring, or a group in which a plurality of monocyclic rings or bicyclic to tetracyclic condensed rings are linked together. R³⁶ is still more preferably a group including a plurality of rings linked together.

y is preferably 2 or 3 and still more preferably 3 because many triazine ring-containing structures having high electron acceptability are present and the LIMO is further stabilized.

L² is an organic ligand, and no particular limitation is imposed on the organic ligand. However, L² is preferably a monovalent bidentate ligand, and more preferred examples thereof are the same as those shown as the preferred examples of L¹. When two organic ligands L² are present, the organic ligands L² may have mutually different structures. When y is 3, no L² is present.

When y in formula (32) is 2 or less, it is preferable that L² has at least one structure selected from the group consisting of formulas (33), (34), and (35) above.

Preferred specific examples of the compound represented by formula (32) serving as the assist dopant contained in the organic electroluminescent element composition in the present embodiment are shown below, but the invention is not limited thereto. These groups are examples other than those shown in Examples.

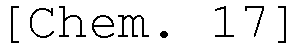

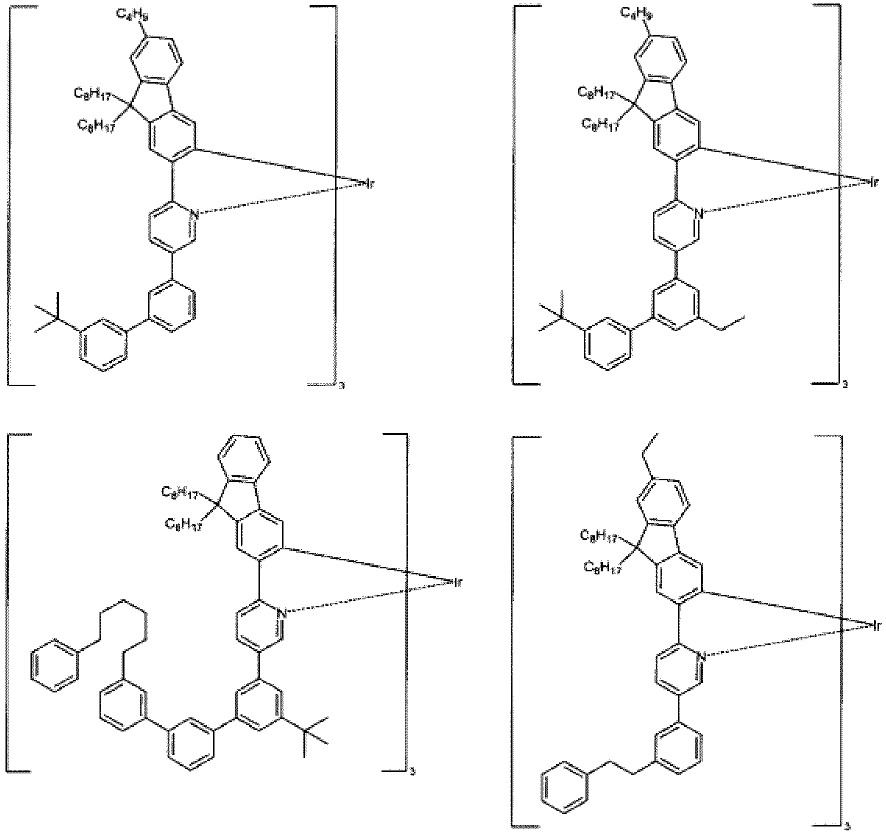

### [Maximum emission wavelength in embodiment I]

A method for measuring the maximum emission wavelength of the compound in embodiment I will be shown below.

The maximum emission wavelength of the compound can be determined from the photoluminescence spectrum of a solution of the material in an organic solvent or from the photoluminescence spectrum of a thin film formed only of the material.

When the photoluminescence of the solution is used, the solution is prepared by dissolving the compound in 2-methyltetrahydrofuran at a concentration of 1 × 10⁻⁴ mol/L or less, and the phosphorescence spectrum of the solution is measured at room temperature using a spectrophotometer (organic EL quantum yield measurement device C9920-02 manufactured by Hamamatsu Photonics K.K.). The wavelength at which the intensity of the phosphorescence spectrum obtained is maximum is used as the maximum emission wavelength.

When the photoluminescence of the thin film is used, the thin film is produced by vacuum vapor deposition of the material or the application of the solution of the material, and the photoluminescence is measured using a spectrophotometer (spectrophotofluorometer F-7000 manufactured by Hitachi, Ltd.). The wavelength at which the intensity of the emission spectrum obtained is maximum is used as the maximum emission wavelength.

It is necessary that the maximum emission wavelength of the compound represented by formula (31) and used as the light-emitting dopant and the maximum emission wavelength of the compound represented by formula (32) and used as the assist dopant be determined by the same method for comparison purposes.

The compound represented by formula (32) contained in the organic electroluminescent element composition in the present embodiment and serving as the assist dopant has a shorter maximum emission wavelength than the compound represented by formula (31) and serving as the light-emitting dopant.

The maximum emission wavelength of the compound represented by formula (31) and serving as the light-emitting dopant is preferably 580 nm or more, more preferably 590 nm or more, and still more preferably 600 nm or more and is preferably 700 nm or less and more preferably 680 nm or less. When the maximum emission wavelength of the compound represented by formula (31) is within the above range, a red light-emitting material suitable for the organic electroluminescent element tends to emit a preferred color.

When the difference between the maximum emission wavelength of the compound represented by formula (32) and serving as the assist dopant and the maximum emission wavelength of the compound represented by formula (31) and serving as the light-emitting dopant is 10 nm or more, e.g., 10 nm or more and 100 nm or less, energy can be transferred efficiently, which is preferred.

From this point of view, the maximum emission wavelength of the compound represented by formula (32) and serving as the assist dopant is preferably 670 nm or less, more preferably 650 nm or less, and still more preferably 610 nm or less. The maximum emission wavelength is preferably 480 nm or more and more preferably 530 nm or more. When the maximum emission wavelength of the compound represented by formula (32) is within the above range, the red light-emitting material suitable for the organic electroluminescent element tends to emit a preferred color.

### [Methods for synthesizing iridium complex compound in embodiment I]

The compound represented by formula (32) and serving as the assist dopant and the compound represented by formula (31) and serving as the light-emitting dopant that are contained in the organic electroluminescent element composition in embodiment I are each an iridium complex compound. Methods for synthesizing these iridium complex compounds will be shown below.

A ligand of an iridium complex compound can be synthesized by, for example, a combination of known methods. The ligand can be synthesized by a known method such as the Suzuki-Miyaura coupling reaction of an aryl boronic acid and a heteroaryl halide or the Friedlaender cyclization reaction with 2-formyl or acyl aniline or with acyl-amino pyridine at ortho positions to each other (Chem. Rev. 2009, 109, 2652 or Organic Reactions, 1982, 28(2), 37-201).

Each iridium complex compound can be synthesized by a combination of known methods using the ligand obtained as described above and iridium chloride n-hydrate etc. This will be described below.

Examples of the method for synthesizing the iridium complex compound include, but not limited to, a method shown in formula [A] below in which phenylpyridine ligands are used as an example for ease of understanding and the iridium complex compound is synthesized by way of a chloro-bridged iridium binuclear complex (M. G. Colombo, T. C. Brunold, T. Riedener, H. U. Gudel, Inorg. Chem., 1994, 33, 545-550) and a method shown in formula [B] below in which the binuclear complex is converted to a mononuclear complex by exchanging the chloro-bridge for acetylacetonate and then the target compound is obtained (S. Lamansky, P. Djurovich, D. Murphy, F. Abdel-Razzaq, R. Kwong, I. Tsyba, M. Borz, B. Mui, R. Bau, M. Thompson, Inorg. Chem., 2001, 40, 1704-1711).

For example, typical conditions for the reaction represented by formula [A] below are as follows. In the present description, Et in chemical formulas means an ethyl group, and Tf means a trifluoromethylsulfonyl group.

In a first stage, a chloro-bridged iridium binuclear complex is synthesized through the reaction of 2 equivalents of a first ligand and 1 equivalent of iridium chloride n-hydrate. Generally, a solvent mixture of 2-ethoxyethanol and water is used. However, no solvent may be used, or a different solvent may be used. The reaction can be facilitated by using an excess amount of the ligand or by using an additive such as a base. Instead of chlorine, other crosslinkable anionic ligands such as bromine can be used.

No particular limitation is imposed on the reaction temperature. The reaction temperature is generally preferably 0°C or higher and more preferably 50°C or higher. The reaction temperature is preferably 250°C or lower and more preferably 150°C or lower. When the reaction temperature is within this range, only the intended reaction proceeds without any by-products and decomposition reactions, and high selectivity tends to be achieved.

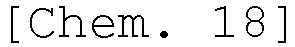

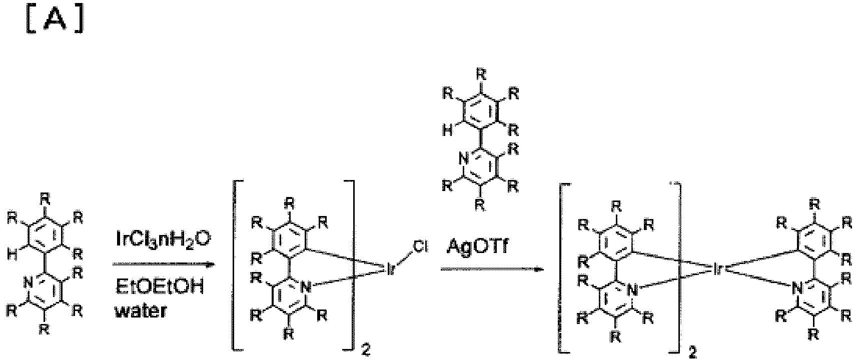

In a second stage, a halogen ion scavenger such as silver trifluoromethanesulfonate is added and brought into contact with a second ligand to thereby obtain the target complex. The solvent used is generally ethoxyethanol or diglyme. However, no solvent may be used, or a different solvent or a mixture of a plurality of solvents may be used according to the type of ligand. Since the reaction may proceed with no halogen ion scavenger added, the halogen ion scavenger is not always essential. However, it is advantageous to add the scavenger because the reaction yield can be increased and a facial isomer having a higher quantum yield can be selectively synthesized. No particular limitation is imposed on the reaction temperature, but the reaction temperature is generally in the range of 0°C to 250°C.

Typical conditions for the reaction represented by formula [B] below will be described.

The binuclear complex in a first stage can be synthesized in the same manner as in formula [A].

In a second stage, the binuclear complex is allowed to react with 1 equivalent or more of a 1,3-dione compound such as acetylacetone and 1 equivalent or more of a basic compound such as sodium carbonate capable of abstracting active hydrogen from the 1,3-dione compound to convert the binuclear complex to a mononuclear complex coordinated with a 1,3-dionate ligand. Generally, a solvent capable of dissolving the raw material binuclear complex such as ethoxyethanol or dichloromethane is used. When the ligand is a liquid, the above procedure can be performed without using a solvent. No particular limitation is imposed on the reaction temperature. The reaction temperature is generally in the range of 0°C to 200°C.

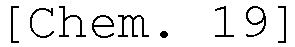

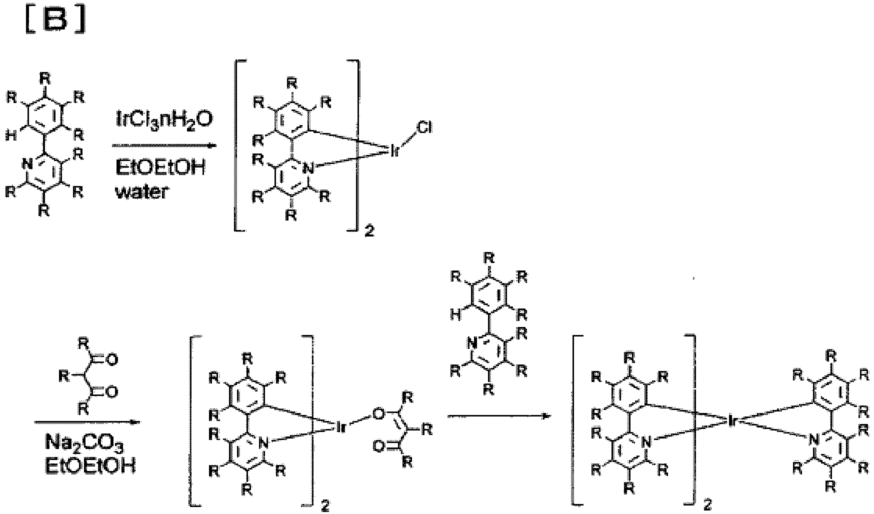

In a third stage, 1 equivalent or more of a second ligand is allowed to react. No particular limitation is imposed on the type and amount of solvent. When the second ligand is a liquid at the reaction temperature, no solvent may be used. No particular limitation is imposed on the reaction temperature. However, since the reactivity is somewhat low, the reaction is often allowed to proceed at a relatively high temperature of 100°C to 300°C. Therefore, a high-boiling solvent such as glycerin is preferably used.

After the final reaction, the product is purified to remove unreacted raw materials, by-products, and the solvent. While any standard purification procedure in synthetic organic chemistry can be used, purification by normal silica gel column chromatography is mainly performed as described in the non-patent literature described above. The eluent used may be a single eluent such as hexane, heptane, dichloromethane, chloroform, ethyl acetate, toluene, methyl ethyl ketone, or methanol or a mixture thereof. A plurality of purification operations may be performed under different conditions. If necessary, other chromatography techniques such as reversed-phase silica gel chromatography, size exclusion chromatography, and paper chromatography and purification operations such as separation and washing, reprecipitation, recrystallization, suspension washing of powder, and drying under reduced pressure may be performed.

### [Compound represented by formula (1)]

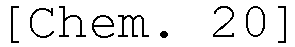

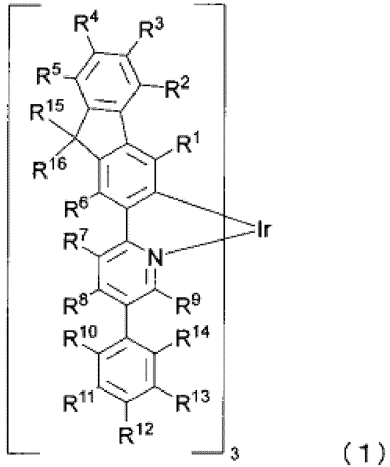

In formula (1) above, Ir represents an iridium atom.

R¹ to R¹⁶ each represent a substituent within any of the following ranges; adjacent two of R¹ to R¹⁶ may be bonded together to form a ring while losing respective hydrogen atoms.

R² to R⁵ are each selected from a [substituent group W] shown below.

R¹, R⁶ to R¹⁰, and R¹⁴ are each independently a hydrogen atom, F, a methyl group, a trifluoromethyl group, an ethyl group, a vinyl group, or an ethynyl group.

R¹⁵ and R¹⁶ are each independently a linear, branched, or cyclic alkyl group having 1 to 30 carbon atoms, an aromatic hydrocarbon group having 5 to 60 carbon atoms, an aromatic heterocyclic group having 5 to 60 carbon atoms, an aralkyl group having 5 to 60 carbon atoms, or a heteroaralkyl group having 5 to 60 carbon atoms. Each of which may optionally have a substituent, which is the same as R' in the "substituent group W" shown below.

One of R¹¹ to R¹³ has a structure represented by formula (2) below; and the remaining two are each selected from a [substituent group Z] shown below.

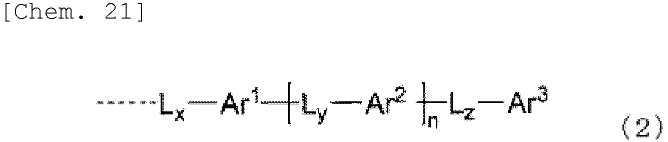

In formula (2) above, a broken line represents a bond to formula (1).

n represents an integer of 1 to 10.

When a plurality of L_{y}'s and a plurality of Ar²'s are present, they may be the same or different.

Lₓ, L_{y}, and L_{z} are each independently a direct bond or selected from -O-, -S-, -NR'-, -Si(R')₂-, -B(R')-, -C(=O)-, -P(=O) (R')-, -S(=O)₂-, -OSO₂-, and alkylene groups having 1 to 30 carbon atoms. Each of the alkylene groups may be optionally substituted with at least one R', wherein one - CH₂- group or 2 or more non-adjacent -CH₂- groups in each alkylene group may be replaced with -C(-R')=C(-R')-, -C=C-, -Si(-R')₂-, -C(=O)-, -NR'-, -O-, -S-, or -CONR'-. R' is the same as R' in the [substituent group W] shown below. At least one hydrogen atom in these groups may be replaced with F, Cl, Br, I, or -CN.

Ar¹ and Ar² each independently represent a divalent 5- or 6-membered aromatic hydrocarbon group or a divalent 5- or 6-membered aromatic heterocyclic group. Ar¹ and Ar² may each optionally have a substituent selected from the [substituent group Z] shown below.

Ar³ represents a monovalent 5- or 6-membered aromatic hydrocarbon group or a monovalent 5- or 6-membered aromatic heterocyclic group. Ar³ may optionally have a substituent selected from the [substituent group Z] shown below.

### [Substituent group W]

The substituent is selected from a hydrogen atom, F, Cl, Br, I, -N(R')₂, -CN, -NO₂, -OH, -SH, -COOR', -C(=O)R', - C(=O)NR', -P(=O) (R')₂, -S(=O)R', -S(=O)₂R', -OS(=O)₂R', - SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms.

The alkyl groups, the alkoxy groups, the alkylthio groups, the alkenyl groups, and the alkynyl groups may each be optionally substituted with at least one R', wherein one -CH₂- group or 2 or more non-adjacent -CH₂- groups in each of these groups may be optionally replaced with -C(-R')=C(-R')-, -C=C-, -Si(-R')₂, -C(=O)-, -NR'-, -O-, -S-, -CONR'-, a divalent aromatic hydrocarbon group, or a divalent aromatic heterocyclic group. At least one hydrogen atom in each of these groups may be optionally replaced with F, Cl, Br, I, or -CN.

The aromatic hydrocarbon groups, the aromatic heterocyclic groups, the aryloxy groups, the arylthio groups, the aralkyl groups, the heteroaralkyl groups, the diarylamino groups, the arylheteroarylamino groups. The diheteroarylamino groups may each independently be optionally substituted with at least one R'.

R's are each independently selected from a hydrogen atom, F, Cl, Br, I, -N(R'')₂, -OH, -SH, -CN, -NO₂, -Si(R'')₃, -B(OR'')₂, -C(=O)R'', -P(=O)(R")₂, -S(=O)₂R'', -OSO₂R'', linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms.

The alkyl groups, the alkoxy groups, the alkylthio groups, the alkenyl groups, and the alkynyl groups may each be optionally substituted with at least one R'', wherein one -CH₂- group or 2 or more non-adjacent -CH₂- groups in each of these groups may be optionally replaced with -C(-R'')=C(-R'')-, -C=C-, -Si(-R'')₂-, -C(=O)-, -NR''-, -O-, -S-, - CONR''-, a divalent aromatic hydrocarbon group, or a divalent aromatic heterocyclic group. At least one hydrogen atom in each of these groups may be replaced with F, Cl, Br, I, or -CN.

The aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each be optionally substituted with at least one R'', and wherein two or more adjacent R's may be bonded together while losing respective hydrogen atoms to thereby form an aliphatic, aromatic hydrocarbon, or aromatic heterocyclic monocyclic or condensed ring.

R''s are each independently selected from a hydrogen atom, F, -CN, aliphatic hydrocarbon groups having 1 to 20 carbon atoms, aromatic hydrocarbon groups having 1 to 20 carbon atoms, and aromatic heterocyclic groups having 1 to 20 carbon atoms. Two or more adjacent R''s may be bonded together while losing respective hydrogen atoms to form an aliphatic, aromatic hydrocarbon, or aromatic heterocyclic monocyclic or condensed ring.

### [Substituent group Z]

The substituent is selected from a hydrogen atom, F, Cl, Br, I, -N(R')₂, -CN, -NO₂, -OH, -SH, -COOR', -C(=O)R', - C(=O)NR', -P(=O) (R')₂, -S(=O)R', -S(=O)₂R', -OS(=O)₂R', - SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms. The alkyl groups, the alkoxy groups, the alkylthio groups, the aryloxy groups, the arylthio groups, the aralkyl groups, the heteroaralkyl groups, the diarylamino groups, the arylheteroarylamino groups, and the diheteroarylamino groups may each be optionally substituted with at least one R'. R' is the same as R' in the [substituent group W] above.

### <Mechanism>

The iridium complex compound represented by formula (1) has higher solvent solubility than conventional materials and can improve the luminous efficiency and driving lifetime of a red organic EL element using the iridium complex compound. The reason for this may be as follows.

The linearity of the 2-fluorenyl-5-phenylpyridine skeleton serving as the main structure of the ligands of the compound represented by formula (1) is high, and the overlap between the HOMO and the LUMO may be very large. In this iridium complex compound, it is expected that the relaxation rate from the excited state is high. In fact, the PL quantum yield of the solution is equivalent to those of similar structures. Moreover, the half-value width of the light emission spectrum of the iridium complex compound is significantly smaller than those of similar structures.

This suggests that the transition from the excited state to the lowest ground state, which is the basis of the main peak, occurs more frequently, and energy transfer to the red dopant may be faster and more effective. When the energy transfer is slow, quenching processes different from light emission such as the collision of excited triplets (triplet-triplet annihilation) and the collision of an excited triplet and a hole (triplet-polaron quenching) occur on the assist dopant when the organic EL element is driven. In this case, the excited state is converted to heat, and a reduction in efficiency occurs. At the same time, a decomposition reaction involving the dissociation of a chemical bond from a higher energy state produced occurs, and this causes a reduction in driving lifetime. However, this problem is eliminated with the iridium complex compound of the invention. Moreover, by introducing the structure represented by formula (2) into a specific position, influences on the main structure can be minimized, and the preferred features of the invention and high solvent solubility may be achieved simultaneously.

### <Substituents R¹ to R¹⁶>

The types of substituents R¹ to R¹⁶ in formula (1) differ from each other because the influences of substitution positions on the characteristic differ from each other. Optimal substituents can be selected in consideration of precise control of the intended emission wavelength, the compatibility with the solvent used, and the compatibility with a host compound and a red light-emitting compound when an organic EL element is produced. Two adjacent substituents each losing one hydrogen atom may be bonded together to form a ring, as shown by the following formula.

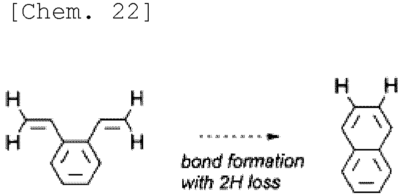

### <Substituents R² to R⁵>

The structure of the ligand is not largely distorted by the influences of the substituents at positions R² to R⁵, and the electron state of the fluorene ring on which the HOMO is distributed can be largely changed by the substituents R² to R⁵. It is therefore very important to select the substituents R² to R⁵. Generally, the types of substituents R² to R⁵ are selected from the following "substituent group W."

### [Substituent group W]

The substituent is selected from a hydrogen atom, F, Cl, Br, I, -N(R')₂, -CN, -NO₂, -OH, -SH, -COOR', -C(=O)R', - C(=O)NR', -P(=O) (R')₂, -S(=O)R', -S(=O)₂R', -OS(=O)₂R', - SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms.

The alkyl groups, the alkoxy groups, the alkylthio groups, the alkenyl groups, and the alkynyl groups may each be optionally substituted with at least one R', wherein one -CH₂- group or 2 or more non-adjacent -CH₂- groups in each of these groups may be optionally replaced with -C(-R')=C(-R')-, -C=C-, -Si(-R')₂, -C(=O)-, -NR'-, -O-, -S-, -CONR'-, a divalent aromatic hydrocarbon group, or a divalent aromatic heterocyclic group. At least one hydrogen atom in each of these groups may be optionally replaced with F, Cl, Br, I, or -CN.

The aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each independently be optionally substituted with at least one R'.

R' will be described later.

Examples of the linear, branched, or cyclic alkyl group having 1 to 30 carbon atoms include a methyl group, an ethyl group, a n-propyl group, an isopropyl group, a n-butyl group, an n-pentyl group, an n-hexyl group, an n-octyl group, a 2-ethylhexyl group, an isopropyl group, an isobutyl group, a cyclopentyl group, a cyclohexyl group, a n-octyl group, a norbornyl group, and an adamantyl group. The number of carbon atom in the alkyl group is preferably 1 or more and is preferably 30 or less, more preferably 20 or less, still more preferably 12 or less, and most preferably 8 or less because, when the number of carbon atoms is excessively large, the complex is highly shielded and its durability is impaired. When the alkyl group is a branched alkyl group, the shielding effect is higher than that of linear and cyclic alkyl groups, and the number of carbon atom is most preferably 8 or less.

Examples of the linear, branched, or cyclic alkoxy group having 1 to 30 carbon atoms include a methoxy group, an ethoxy group, a n-propyloxy group, a n-butoxy group, a n-hexyloxy group, an isopropyloxy group, a cyclohexyloxy group, a 2-ethoxyethoxy group, and a 2-ethoxyethoxyethoxy group. From the viewpoint of durability, the number of carbon atoms is preferably 1 or more and is preferably 30 or less, more preferably 20 or less, and most preferably 12 or less.

Examples of the linear, branched, or cyclic alkylthio group having 1 to 30 carbon atoms include a methylthio group, an ethylthio group, a n-propylthio group, a n-butylthio group, a n-hexylthio group, an isopropylthio group, a cyclohexylthio group, a 2-methylbutylthio group, and a n-hexylthio group. From the viewpoint of durability, the number of carbon atoms is preferably 1 or more and is preferably 30 or less, more preferably 20 or less, and most preferably 12 or less.

Examples of the linear, branched, or cyclic alkenyl group having 2 to 30 carbon atoms include a vinyl group, an allyl group, a propenyl group, a heptenyl group, a cyclopentenyl group, a cyclohexenyl group, and a cyclooctene group. From the viewpoint of durability, the number of carbon atoms is preferably 2 or more and is preferably 30 or less, more preferably 20 or less, and most preferably 12 or less.

Examples of the linear, branched, or cyclic alkynyl group having 2 to 30 carbon atoms include an ethynyl group, a propionyl group, a butynyl group, a pentynyl group, a hexynyl group, a heptynyl group, and an octynyl group. From the viewpoint of durability, the number of carbon atoms is preferably 2 or more and is preferably 30 or less, more preferably 20 or less, and most preferably 12 or less.

The aromatic hydrocarbon group having 5 to 60 carbon atoms and the aromatic heterocyclic group having 5 to 60 carbon atoms may each be present as a monocyclic ring or a condensed ring or may each be a group in which one ring is bonded to or condensed with another aromatic hydrocarbon or aromatic heterocyclic group.

Examples of such a group include a phenyl group, a naphthyl group, an anthracenyl group, a benzanthracenyl group, a phenanthrenyl group, a benzophenanthrenyl group, a pyrenyl group, a chrysenyl group, a fluoranthenyl group, a perylenyl group, a benzopyrenyl group, a benzofluoranthenyl group, a naphthacenyl group, a pentacenyl group, a biphenyl group, a terphenyl group, a fluorenyl group, a spirobifluorenyl group, a dihydrophenanthrenyl group, a dihydropyrenyl group, a tetrahydropyrenyl group, an indenofluorenyl group, a furyl group, a benzofuryl group, an isobenzofuryl group, a dibenzofuranyl group, a thiophene group, a benzothiophenyl group, a dibenzothiophenyl group, a pyrrolyl group, an indolyl group, an isoindolyl group, a carbazolyl group, a benzocarbazolyl group, an indolocarbazolyl group, an indenocarbazolyl group, a pyridyl group, a cinnolyl group, an isocinnolyl group, an acridyl group, a phenanthridyl group, a phenothiazinyl group, a phenoxazyl group, a pyrazolyl group, an indazolyl group, an imidazolyl group, a benzimidazolyl group, a naphthoimidazolyl group, a phenanthroimidazolyl group, a pyridineimidazolyl group, an oxazolyl group, a benzoxazolyl group, a naphthoxazolyl group, a thiazolyl group, a benzothiazolyl group, a pyrimidyl group, a bonzopyrimidyl group, a pyridazinyl group, a quinoxalinyl group, a diazaanthracenyl group, a diazapyrenyl group, a pyrazinyl group, a phenoxazinyl group, a phenothiazinyl group, a naphthyridinyl group, an azacarbazolyl group, a benzocarbolinyl group, a phenanthrolinyl group, a triazolyl group, a benzotriazolyl group, an oxadiazolyl group, a thiadiazolyl group, a triazinyl group, a 2,6-diphenyl-1,3,5-triazin-4-yl group, a tetrazolyl group, a purinyl group, and a benzothiadiazolyl group.

From the viewpoint of the balance between the solvent solubility and durability, the number of carbon atoms in each of these groups is 5 or more and is preferably 50 or less, more preferably 40 or less, and most preferably 30 or less.

Examples of the aryloxy group having 5 to 40 carbon atoms include a phenoxy group, a methylphenoxy group, a naphthoxy group, and a methoxyphenoxy group. From the viewpoint of the balance between the solubility and durability, the number of carbon atoms in each of these aryloxy groups is 5 or more and is preferably 30 or less, more preferably 25 or less, and most preferably 20 or less.

Examples of the arylthio group having 5 to 40 carbon atoms include a phenylthio group, a methylphenylthio group, a naphthylthio group, and a methoxyphenylthio group. From the viewpoint of the balance between the solubility and durability, the number of carbon atoms in each of the arylthio groups is 5 or more and is preferably 30 or less, more preferably 25 or less, and most preferably 20 or less.

Examples of the aralkyl group having 5 to 60 carbon atoms include a 1,1-dimethyl-1-phenylmethyl group, a 1,1-di(n-butyl)-1-phenylmethyl group, a 1,1-di(n-hexyl)-1-phenylmethyl group, a 1,1-di(n-octyl)-1-phenylmethyl group, a phenylmethyl group, a phenylethyl group, a 3-phenyl-1-propyl group, a 4-phenyl-1-n-butyl group, a 1-methyl-1-phenylethyl group, a 5-phenyl-1-n-propyl group, a 6-phenyl-1-n-hexyl group, a 6-naphthyl-1-n-hexyl group, a 7-phenyl-1-n-heptyl group, an 8-phenyl-1-n-octyl group, and a 4-phenylcyclohexyl group. From the viewpoint of the balance between the solubility and durability, the number of carbon atoms in each of these aralkyl groups is 5 or more and is more preferably 40 or less.

Examples of the heteroaralkyl group having 5 to 60 carbon atoms include a 1,1-dimethyl-1-(2-pyridyl)methyl group, a 1,1-di(n-hexyl)-1-(2-pyridyl)methyl group, a (2-pyridyl)methyl group, a (2-pyridyl)ethyl group, a 3-(2-pyridyl)-1-propyl group, a 4-(2-pyridyl)-1-n-butyl group, a 1-methyl-1-(2-pyridyl)ethyl group, a 5-(2-pyridyl)-1-n-propyl group, a 6-(2-pyridyl)-1-n-hexyl group, a 6-(2-pyrimidyl)-1-n-hexyl group, a 6-(2,6-diphenyl-1,3,5-triazin-4-yl)-1-n-hexyl group, a 7-(2-pyridyl)-1-n-heptyl group, an 8-(2-pyridyl)-1-n-octyl group, and a 4-(2-pyridyl)cyclohexyl group. From the viewpoint of the balance between the solubility and durability, the number of carbon atoms in each of these heteroaralkyl groups is 5 or more and is preferably 50 or less, more preferably 40 or less, and most preferably 30 or less.

Examples of the diarylamino group having 10 to 40 carbon atoms include a diphenylamino group, a phenyl(naphthyl)amino group, a di(biphenyl)amino group, and a di(p-terphenyl)amino group. From the viewpoint of the balance between the solubility and durability, the number of carbon atoms in each of these diarylamino groups is 10 or more and is preferably 36 or less, more preferably 30 or less, and most preferably 25 or less.

Examples of the arylheteroarylamino group having 10 to 40 carbon atoms include phenyl(2-pyridyl)amino and a phenyl(2,6-diphenyl-1,3,5-triazin-4-yl)amino group. From the viewpoint of the balance between the solubility and durability, the number of carbon atoms in each of these arylheteroarylamino groups is 10 or more and is preferably 36 or less, more preferably 30 or less, and most preferably 25 or less.

Examples of the diheteroarylamino group having 10 to 40 carbon atoms include a di(2-pyridyl)amino group and a di(2,6-diphenyl-1,3,5-triazin-4-yl)amino group. From the viewpoint of the balance between the solubility and durability, the number of carbon atoms in each of these diheteroarylamino groups is 10 or more and is preferably 36 or less, more preferably 30 or less, and most preferably 25 or less.

### <R'>

R' is selected from a hydrogen atom, F, Cl, Br, I, - N(R'')₂, -OH, -SH, -CN, -NO₂, -Si(R'')₃, -B(OR'')₂, - C(=O)R", -P(=O)(R")₂, -S(=O)₂R'', -OSO₂R'', linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms.

When a plurality of R's are present, they may be the same or different.

The alkyl groups, the alkoxy groups, the alkylthio groups, the alkenyl groups, and the alkynyl groups may each be optionally substituted with at least one R'', wherein one -CH₂- group or 2 or more non-adjacent -CH₂- groups in each of these groups may be optionally replaced with -C(-R'')=C(-R'')-, -C=C-, -Si(-R'')₂-, -C(=O)-, -NR''-, -O-, -S-, - CONR''-, a divalent aromatic hydrocarbon group, or a divalent aromatic heterocyclic group. At least one hydrogen atom in each of these groups may be replaced with F, Cl, Br, I, or -CN.

The aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each be optionally substituted with at least one R''.

R'' will be described later.

Two or more adjacent R's may be bonded together while losing respective hydrogen atoms to thereby form an aliphatic, aromatic hydrocarbon, or aromatic heterocyclic monocyclic or condensed ring.

### <R">

R'' is selected from a hydrogen atom, F, -CN, aliphatic hydrocarbon groups having 1 to 20 carbon atoms, aromatic hydrocarbon groups having 5 to 20 carbon atoms, and aromatic heterocyclic groups having 5 to 20 carbon atoms.

Two or more adjacent R''s may be bonded together while losing respective hydrogen atoms to form an aliphatic, aromatic hydrocarbon, or aromatic heterocyclic monocyclic or condensed ring. When a plurality of R''s are present, they may be the same or different.

From the viewpoint of durability, the substituents R² to R⁵ are each more preferably a hydrogen atom, a linear, branched, or cyclic alkyl group having 1 to 30 carbon atoms, a linear, branched, or cyclic alkenyl group having 2 to 30 carbon atoms, an aromatic hydrocarbon group having 5 to 60 carbon atoms, an aromatic heterocyclic group having 5 to 60 carbon atoms, an aralkyl group having 5 to 60 carbon atoms, a heteroaralkyl group having 5 to 60 carbon atoms, a diarylamino group having 10 to 40 carbon atoms, an arylheteroarylamino group having 10 to 40 carbon atoms, or a diheteroarylamino group having 10 to 40 carbon atoms, still more preferably a hydrogen atom, a linear, branched, or cyclic alkyl group having 1 to 30 carbon atoms, an aromatic hydrocarbon group having 5 to 60 carbon atoms, an aromatic heterocyclic group having 5 to 60 carbon atoms, a diarylamino group having 10 to 40 carbon atoms, an arylheteroarylamino group having 10 to 40 carbon atoms, or a diheteroarylamino group having 10 to 40 carbon atoms, and most preferably a hydrogen atom, a linear, branched, or cyclic alkyl group having 1 to 30 carbon atoms, or an aromatic hydrocarbon group having 5 to 60 carbon atoms.

### <Substituents R¹, R⁶ to R¹⁰, and R¹⁴>

If bulky substituents are introduced as the substituents R¹, R⁶ to R¹⁰, and R¹⁴, the planarity of the fluorene-pyridine-benzene ring is impaired significantly, and the planarity of the π conjugation is lost. Therefore, these substituents are each independently a hydrogen atom, F, a methyl group, a trifluoromethyl group, an ethyl group, a vinyl group, or an ethynyl group, preferably a hydrogen atom or F, and most preferably a hydrogen atom.

### <Substituents R¹⁵ and R¹⁶>

The substituents R¹⁵ and R¹⁶ are substituents at the bridgehead position of the fluorene. Therefore, by selecting appropriate substituents, the solubility of the iridium complex compound can be improved, and also the HOMO distributed on the iridium atom and the fluorene moiety can be appropriately shielded. Moreover, by introducing an electron donating or electron withdrawing group to control the HOMO energy state, the performance as the assist dopant can be significantly improved.

The substituents R¹⁵ and R¹⁶ are each independently a linear, branched, or cyclic alkyl group having 1 to 30 carbon atoms, an aromatic hydrocarbon group having 5 to 60 carbon atoms, an aromatic heterocyclic group having 5 to 60 carbon atoms, an aralkyl group having 5 to 60 carbon atoms, or a heteroaralkyl group having 5 to 60 carbon atoms. The optional substituents on these substituents are each the same as R' in the [substituent group W].

If the number of carbon atoms in each of the substituents R¹⁵ and R¹⁶ is excessively large, the HOMO is largely shielded, and holes and electrons tend not to be received. When R¹⁵ and R¹⁶ are each a hydrogen atom, the highly reactive bridgehead position is likely to be oxidized and deteriorate. Therefore, R¹⁵ and R¹⁶ are each more preferably a linear, branched, or cyclic alkyl group having 1 to 10 carbon atoms, an aromatic hydrocarbon group having 5 to 20 carbon atoms, an aromatic heterocyclic group having 5 to 20 carbon atoms, an aralkyl group having 5 to 20 carbon atoms, or a heteroaralkyl group having 5 to 20 carbon atoms, particularly preferably a linear, branched, or cyclic alkyl group having 1 to 8 carbon atoms, an aralkyl group having 5 to 12 carbon atoms, or a heteroaralkyl group having 5 to 12 carbon atoms, and most preferably a linear, branched, or cyclic alkyl group having 1 to 8 carbon atoms. Of these, a methyl group is most preferred.

### <Substituents R¹¹ to R¹³>

One of the substituents R¹¹ to R¹³ is a structure represented by formula (2) described later. From the viewpoint of increasing the number of bent structures to improve the solubility, it is more preferable that any of R¹¹ and R¹³ is the structure represented by formula (2), and it is most preferable that R¹¹ is the structure represented by formula (2). The details of formula (2) will be described later. The remaining two substituents are each selected from the following substituent group Z.

### [Substituent group Z]

The substituent is selected from a hydrogen atom, F, Cl, Br, I, -N(R')₂, -CN, -NO₂, -OH, -SH, -COOR', -C(=O)R', - C(=O)NR', -P(=O)(R')₂, -S(=O)R', -S(=O)₂R', -OS(=O)₂R', - SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms. The alkyl groups, the alkoxy groups, the alkylthio groups, the aryloxy groups, the arylthio groups, the aralkyl groups, the heteroaralkyl groups, the diarylamino groups, the arylheteroarylamino groups, and the diheteroarylamino groups may each be optionally substituted with at least one R'. R' is the same as R' in the [substituent group W] above.

From the viewpoint of the durability and solubility, each substituent is preferably a hydrogen atom, F, -N(R')₂, -CN, -OH, -SH, a linear, branched, or cyclic alkyl group having 1 to 30 carbon atoms, a linear, branched, or cyclic alkoxy group having 1 to 30 carbon atoms, a linear, branched, or cyclic alkylthio group having 1 to 30 carbon atoms, an aryloxy group having 5 to 40 carbon atoms, an arylthio group having 5 to 40 carbon atoms, or a diarylamino group having 10 to 40 carbon atoms, more preferably a hydrogen atom, F, -N(R')₂, -CN, or a linear, branched, or cyclic alkyl group having 1 to 30 carbon atoms, and particularly preferably a hydrogen atom or a linear, branched, or cyclic alkyl group having 1 to 30 carbon atoms.

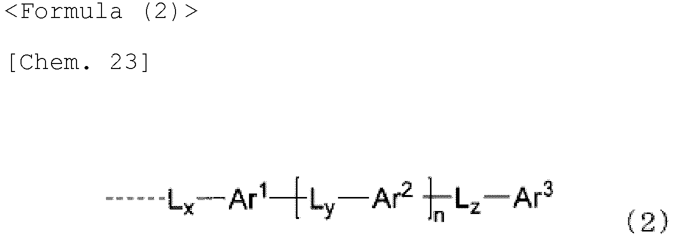

In formula (2), a broken line represents a bond to formula (1). n represents an integer of 1 to 10, preferably 1 to 8, and more preferably 1 to 5. When n is 5 or less, the iridium complex compound of the present invention can maintain a sufficiently high hole transport property, which is a preferable property when used as an assist dopant. When a plurality of L_{y}'s and a plurality of Ar²'s are present, they may be the same or different.

### <Lₓ, L_{y}, L_{z}>

Lₓ, L_{y}, and L_{z} are each independently a direct bond or selected from -O-, -S-, -NR'-, -Si(R')₂-, -B(R')-, -C(=O)-, -P(=O) (R')-, -S(=O)₂-, -OSO₂-, and alkylene groups having 1 to 30 carbon atoms.

Each of the alkylene groups may be optionally substituted with at least one R', wherein one -CH₂- group or 2 or more non-adjacent -CH₂- groups in each alkylene group may be replaced with -C(-R')=C(-R')-, -C=C-, -Si(-R')₂-, -C(=O)-, - NR'-, -O-, -S-, or -CONR'-. At least one hydrogen atom in these groups may be replaced with F, Cl, Br, I, or -CN. Specific types of the alkylene group are those which have the same carbon number range as the alkyl groups exemplified in [substituent group W] and are divalent groups obtained by removing one hydrogen atom from such monovalent groups.

### < Ar¹, Ar²>

Ar¹ and Ar² each independently represent a divalent 5- or 6-membered aromatic hydrocarbon group or a divalent 5- or 6-membered aromatic heterocyclic group.

Each of the rings used is generally a furan ring, a pyrrole ring, a thiophene ring, an imidazole ring, a triazole ring, a benzene ring, a pyridine ring, a pyrimidine ring, or a triazine ring. From the viewpoint of durability, each ring is preferably a 6-membered ring, more preferably a benzene ring or a pyridine ring, and still more preferably a benzene ring. Specifically, Ar¹ and Ar² are each preferably a phenylene group. From the viewpoint of the solubility, preferred bonding positions of each benzene ring are 1,2-bonds or 1,3-bonds and most preferably 1,3-bonds.

Optional substituents on Ar¹ and Ar² are selected from the [substituent group Z]. From the viewpoint of improving the solubility without impairing the durability, each substituent is more preferably a hydrogen atom, F, a linear, branched, or cyclic alkyl group having 1 to 30 carbon atoms, or an aralkyl group having 5 to 60 carbon atoms. The substituent is most preferably a hydrogen atom or a linear, branched, or cyclic alkyl group having 1 to 30 carbon atoms.

### <Ar³>

Ar³ represents a monovalent 5- or 6-membered aromatic hydrocarbon group or a monovalent 5- or 6-membered aromatic heterocyclic group. The ring used is generally a furan ring, a pyrrole ring, a thiophene ring, an imidazole ring, a triazole ring, a benzene ring, a pyridine ring, a pyrimidine ring, or a triazine ring. From the viewpoint of durability, the ring is preferably a 6-membered ring, more preferably a benzene ring or a pyridine ring, and still more preferably a benzene ring. Specifically, Ar³ is preferably a phenyl group. Ar³ may optionally have one or two or more substituents selected from the [substituent group Z]. From the viewpoint of improving the solubility without impairing the durability, the substituent is more preferably a hydrogen atom, F, a linear, branched, or cyclic alkyl group having 1 to 30 carbon atoms, or an aralkyl group having 5 to 60 carbon atoms. The substituent is most preferably a hydrogen atom or a linear, branched, or cyclic alkyl group having 1 to 30 carbon atoms.

### <Preferred embodiment>

In particular, it is preferable that the formula (1) is represented by the following formula (3), the following formula (4), or the following formula (5).

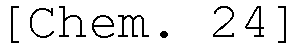

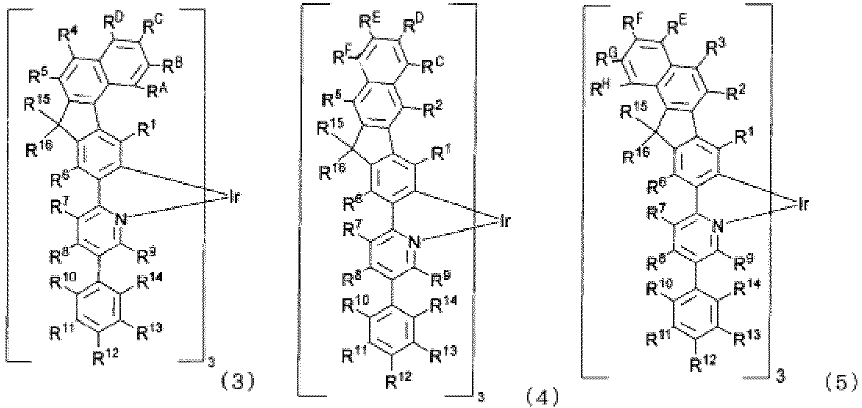

In formulas (3) to (5),
R¹ to R¹⁶ are the same as R¹ to R¹⁶ in formula (1'),
R^{A} and R^{B} are each the same as R²,
R^{C} and R^{D} are each the same as R³,
R^{E} and R^{F} are each the same as R⁴, and
R^{G} and R^{H} are each the same as R⁵.

### <Specific examples>

Specific examples of the compound represented by formula (1) in the invention are shown below, but the invention is not limited thereto. These groups are examples other than those shown in Examples.

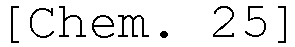

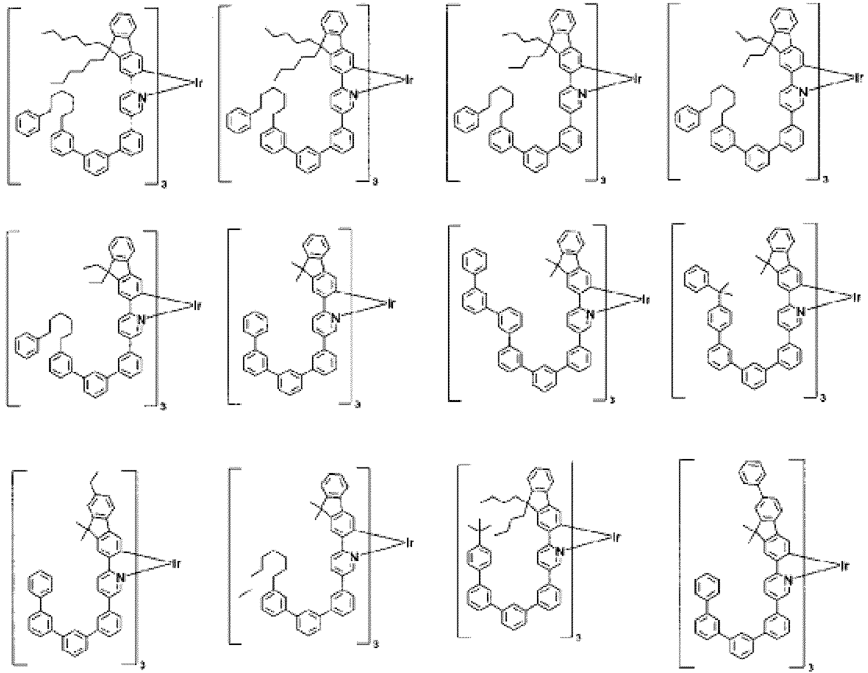

The required physical properties of the assist dopant may vary depending on the type of light-emitting dopant such as a red light-emitting material used in combination with the assist dopant. The physical properties can be adjusted by introducing substituents as shown in the following specific examples.

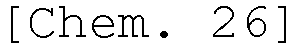

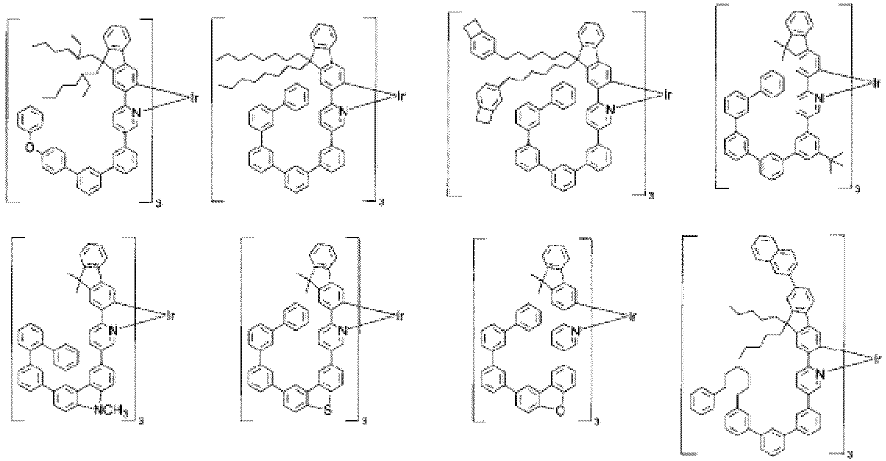

### <Method for measuring maximum emission wavelength of solution in embodiment II>

A method for measuring the maximum emission wavelength of a solution of the compound represented by formula (1) is as follows.

The solution is prepared by dissolving the iridium complex compound in toluene at a concentration of 1 × 10⁻⁴ mol/L or lower at room temperature. The phosphorescence spectrum of the prepared solution is measured using a spectrophotometer (organic EL quantum yield measurement device C9920-02 manufactured by Hamamatsu Photonics K.K.). The wavelength at which the phosphorescence spectrum intensity is maximum is regarded as the maximum emission wavelength in the invention.

The lower limit of the maximum emission wavelength of the compound represented by formula (1) is generally 530 nm or more, preferably 550 nm or more, and more preferably 570 nm or more. Preferably, the upper limit is equal to or less than the maximum emission wavelength of the red light-emitting dopant used in combination.

### <Methods for synthesizing compound represented by formula (1) in embodiment II>

The ligands of the compound represented by formula (1) can be synthesized as follows. Building blocks such as halogenated fluorene and 2-bromo-5-iodopyridine are used and converted to borates by the Miyaura-Ishiyama borylation reaction or the Hartwig-Miyaura C-H borylation reaction. These intermediates and an aryl halide are subjected to the Suzuki-Miyaura coupling reaction to construct the skeleton. By combining other known methods, ligands with various substituents introduced thereinto can be synthesized.

Examples of the method for synthesizing the compound represented by formula (1) include: a method shown in formula [C] below in which the compound is synthesized by way of a chloro-bridged iridium binuclear complex (phenylpyridine ligands are used for the sake of ease of understanding) (M. G. Colombo, T. C. Brunold, T. Riedener, H. U. Gudel, Inorg. Chem., 1994, 33, 545-550); and a method shown in formula [D] below in which the binuclear complex is converted to a mononuclear complex by exchanging the chloro-bridge for acetylacetonate and then the target compound is obtained (S. Lamansky, P. Djurovich, D. Murphy, F. Abdel-Razzaq, R. Kwong, I. Tsyba, M. Borz, B. Mui, R. Bau, M. Thompson, Inorg. Chem., 2001, 40, 1704-1711). Other examples include a method including reacting a ligand with a tris(acetylacetonato iridium(III)) complex in glycerin at middle or high temperature to directly obtain a homo-triscyclometallated iridium complex (K. Dedeian, P. I. Djurovich, F. O. Garces, G. Carlson, R. J. Watts, Inorg. Chem., 1991, 30, 1685-1687). However, the synthesis method is not limited to these methods.

For example, typical conditions for the reaction represented by formula [C] below are as follows. In a first stage, a chloro-bridged iridium binuclear complex is synthesized through the reaction of 2 equivalents of a ligand and 1 equivalent of iridium chloride n-hydrate. Generally, a solvent mixture of 2-ethoxyethanol and water is used. However, no solvent may be used, or a different solvent may be used. The reaction can be facilitated by using an excess amount of the ligand or using an additive such as a base. Instead of chlorine, other crosslinkable anionic ligands such as bromine can be used.

No particular limitation is imposed on the reaction temperature. The reaction temperature is generally preferably 0°C or higher and more preferably 50°C or higher. The reaction temperature is preferably 250°C or lower and more preferably 150°C or lower. When the reaction temperature is within this range, only the intended reaction proceeds without any by-products and decomposition reactions, and high selectivity tends to be achieved.

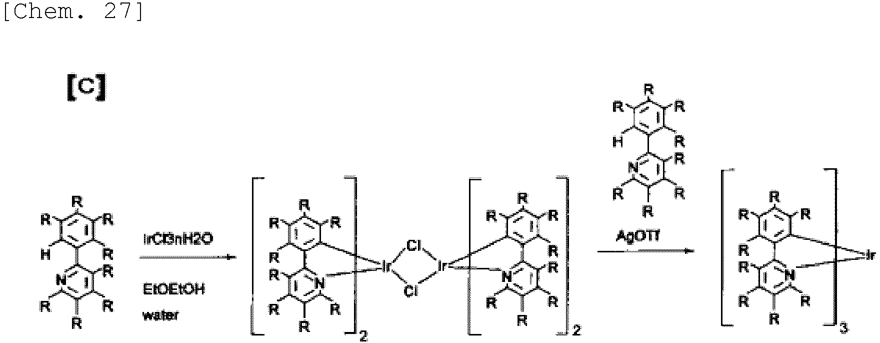

In a second stage, a halogen ion scavenger such as silver trifluoromethanesulfonate is added and brought into contact with a newly added ligand to thereby obtain the target complex. The solvent used is generally ethoxyethanol or diglyme. However, no solvent may be used, or a different solvent or a mixture of a plurality of solvents may be used according to the type of ligand. Since the reaction may proceed with no halogen ion scavenger added, the halogen ion scavenger is not always essential. However, it is advantageous to add the scavenger because the reaction yield can be increased and a facial isomer having a higher quantum yield can be selectively synthesized. No particular limitation is imposed on the reaction temperature, but the reaction temperature is generally in the range of 0°C to 250°C.

Typical conditions for the reaction represented by formula [D] below will be described. The binuclear complex in a first stage can be synthesized in the same manner as in formula [C]. In a second stage, the binuclear complex is allowed to react with 1 equivalent or more of a 1,3-dione compound such as acetylacetone and 1 equivalent or more of a basic compound such as sodium carbonate capable of abstracting active hydrogen from the 1,3-dione compound to convert the binuclear complex to a mononuclear complex coordinated with a 1,3-dionate ligand. Generally, a solvent capable of dissolving the raw material binuclear complex such as ethoxyethanol or dichloromethane is used. When the ligand is a liquid, the above procedure can be performed without using a solvent. No particular limitation is imposed on the reaction temperature. The reaction temperature is generally in the range of 0°C to 200°C.

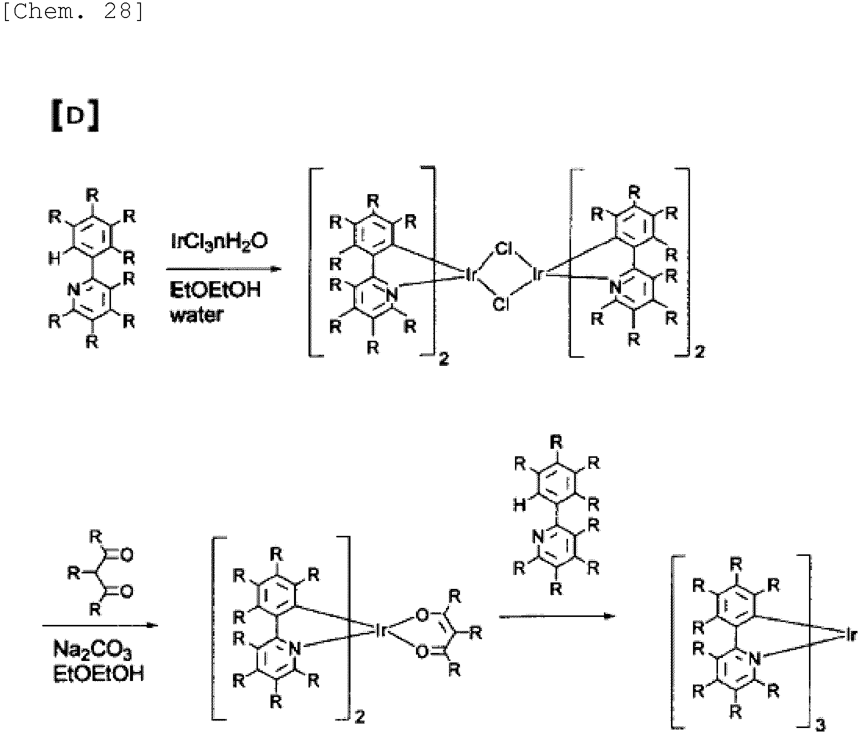

In a third stage, 1 equivalent or more of the ligand is allowed to react. No particular limitation is imposed on the type and amount of solvent. When the ligand is a liquid at the reaction temperature, no solvent may be used. No particular limitation is imposed on the reaction temperature. However, since the reactivity is somewhat low, the reaction is often allowed to proceed at a relatively high temperature of 100°C to 300°C. Therefore, a high-boiling solvent such as glycerin is preferably used.

After the final reaction, the product is purified to remove unreacted raw materials, by-products, and the solvent. While any standard purification procedure in synthetic organic chemistry can be used, purification by normal silica gel column chromatography is mainly performed as described in the non-patent literature described above. The eluent used may be a single eluent such as hexane, heptane, dichloromethane, chloroform, ethyl acetate, toluene, methyl ethyl ketone, or methanol or a mixture thereof. A plurality of purification operations may be performed under different conditions. If necessary, other chromatography techniques (such as reversed-phase silica gel chromatography, size exclusion chromatography, and paper chromatography) and purification operations such as separation and washing, reprecipitation, recrystallization, suspension washing of powder, and drying under reduced pressure may be performed.

### [Compositional ratio of compound represented by formula (31) and compound represented by formula (32) or compound represented by formula (1)]

Generally, the organic electroluminescent element composition in the present embodiment is used to form a layer or a film by a wet deposition method and is particularly preferably used to form a light-emitting layer of an organic electroluminescent element.

The content of the light-emitting dopant in the organic electroluminescent element composition is generally 0.01% by mass or more and preferably 0.1% by mass or more and is generally 20% by mass or less and preferably 10% by mass or less. When the content of the light-emitting dopant is within this range, the luminous efficiency when the composition is used for an organic electroluminescent element application can be improved because the amount of excitation energy transferred to an adjacent layer, e.g., a hole transport layer or a hole blocking layer, is small and the quenching of light due to the interaction between excitons is small. The content of the light-emitting dopant is generally the total content of compounds represented by formula (31).

The content of the assist dopant in the organic electroluminescent element composition is generally 0.005% by mass or more and preferably 0.05% by mass or more and is generally 10% by mass or less and preferably 5% by mass or less. When the content of the assist dopant is within this range, the driving voltage when the composition is used for an organic electroluminescent element application can be reduced because holes or electrons are efficiently injected from an adjacent layer, e.g., a hole transport layer or a hole blocking layer, to the light-emitting layer.

The content of the assist dopant is generally the total content of the compound represented by formula (32) and/or the compound represented by formula (1).

The organic electroluminescent element composition may contain only one compound represented by formula (32) and serving as the assist dopant or may contain a combination of two or more compounds. When two or more compounds are contained, the maximum emission wavelengths of all the compounds serving as the assist dopants are shorter than the maximum emission wavelength of the compound represented by formula (31) and serving as the light-emitting dopant. When two or more compounds represented by formula (31) and serving as light-emitting dopants are contained, the maximum emission wavelengths of the compounds serving as the assist dopants are shorter than the maximum emission wavelengths of all the compounds serving as the light-emitting dopants.

The organic electroluminescent element composition may contain only one compound represented by formula (1) and serving as the assist dopant or may contain a combination of two or more compounds represented by formula (1). When two or more compounds are contained, the maximum emission wavelengths of all the compounds serving as the assist dopants are shorter than the maximum emission wavelength of the compound represented by formula (31) and serving as the light-emitting dopant. When two or more compounds represented by formula (31) and serving as the light-emitting dopants are contained, the maximum emission wavelengths of all the compounds serving as the assist dopants are shorter than the maximum emission wavelengths of all the compounds serving as the light-emitting dopants.

In the organic electroluminescent element composition in the present embodiment, the compositional ratio (% by mass) of the compound represented by formula (31) and serving as the light-emitting dopant is preferably equal to or more than one-fifth of the compositional ratio (% by mass) of the compound represented by formula (32) and/or the compound represented by formula (1) and serving as the assist dopant. By increasing the compositional ratio of the compound serving as the light-emitting dopant, the width of the light emission spectrum of the organic electroluminescent element to be prepared is reduced, and more vivid light emission is obtained. Therefore, the organic electroluminescent element is suitable for a display device application. When two or more compounds serving as the assist dopants are contained, the total compositional ratio (% by mass) of the compounds serving as the assist dopants is preferably equal to or more than 1/5 of the total compositional ratio (% by mass) of the compound serving as the light-emitting dopant.

To efficiently transfer energy from the assist dopant to the light-emitting dopant to obtain light emission from the light-emitting dopant, it is preferable that a large amount of the light-emitting dopant is contained. Specifically, it is preferable that the compositional ratio of the parts by mass of the compound represented by formula (31) in the organic electroluminescent element composition in the present embodiment is equal to or more than 1/5 of that of the compound represented by formula (32) and/or the compound represented by formula (1). Particularly preferably, the compositional ratio of the compound represented by formula (31) is 1/4 to 2 times that of the compound represented by formula (32) and/or the compound represented by formula (1). In this case, the energy can be more efficiently transferred from the assist dopant to the light-emitting dopant, and higher luminous efficiency is obtained. The compositional ratio (% by mass) of the compound serving as the light-emitting dopant is more preferably equal to or more than 2 times, e.g., equal to or more than 2 times and less than 4 times, the compositional ratio (% by mass) of the compound serving as the assist dopant because more vivid light emission is obtained. However, from the viewpoint that the performance of the element can be improved, the compositional ratio (% by mass) of the compound serving as the light-emitting dopant is preferably less than 2 times, e.g., equal to or more than 1/5 and less than 2 times, the compositional ratio (% by mass) of the compound serving as the assist dopant.

### [Additional compounds]

The organic electroluminescent element composition according to the invention may contain additional compounds other than the compounds described above, as needed. For example, a solvent other than the solvent described above may be contained. Examples of such a solvent include amides such as N,N-dimethylformamide and N,N-dimethylacetamide and dimethyl sulfoxide. Only one of these solvents may be used alone, or a combination of two more may be used in any ratio.

### [Solvent]

The organic electroluminescent element composition in the present embodiment contains a solvent.

The solvent contained in the organic electroluminescent element composition in the present embodiment is a volatile liquid component used to form a layer containing the assist dopant and the light-emitting dopant by wet deposition.

No particular limitation is imposed on the solvent so long as it can well dissolve the solute compound serving as the assist dopant and the solute compound serving as the light-emitting dopant. The solvent is preferably a solvent that can dissolve a charge transport compound described later.

Preferred examples of the solvent include: alkanes such as n-decane, cyclohexane, ethylcyclohexane, decalin, and bicyclohexane; aromatic hydrocarbons such as toluene, xylene, mesitylene, phenylcyclohexane, and tetralin; halogenated aromatic hydrocarbons such as chlorobenzene, dichlorobenzene, and trichlorobenzene; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic esters such as phenyl acetate, phenyl propionate, methyl benzoate, ethyl benzoate, propyl benzoate, and n-butyl benzoate; alicyclic ketones such as cyclohexanone, cyclooctanone, and fenchone; alicyclic alcohols such as cyclohexanol and cyclooctanol; aliphatic ketones such as methyl ethyl ketone and dibutyl ketone; aliphatic alcohols such as butanol and hexanol; and aliphatic ethers such as ethylene glycol dimethyl ether, ethylene glycol diethyl ether, and propylene glycol-1-monomethyl ether acetate (PGMEA). Of these, alkanes and aromatic hydrocarbons are more preferred, and phenylcyclohexane is particularly preferred because it has a viscosity and a boiling point preferred for a wet deposition process.

One of these solvents may be used alone, or a combination of two or more may be used in any ratio.

The boiling point of the solvent is generally 80°C or higher, preferably 100°C or higher, more preferably 150°C or higher, and particularly preferably 200°C or higher. When the boiling point of the solvent is equal to or higher than the above lower limit, a reduction in deposition stability caused by evaporation of the solvent from the organic electroluminescent element composition during wet deposition can be prevented. The boiling point of the solvent is generally 270°C or lower, preferably 250°C or lower, and more preferably 240°C or lower. When the boiling point of the solvent is equal to or lower than the above upper limit, the solvent is prevented from remaining in the film, and a reduction in deposition stability can be prevented.

The content of the solvent with respect to 100 parts by mass of the organic electroluminescent element composition is preferably 10 parts by mass or more, more preferably 50 parts by mass or more, and particularly preferably 80 parts by mass or more and is preferably 99.95 parts by mass or less, more preferably 99.9 parts by mass or less, and particularly preferably 99.8 parts by mass or less.

When a light-emitting layer of an organic electroluminescent element is formed using the organic electroluminescent element composition, the thickness of the light-emitting layer is generally about 3 to about 200 nm. When the content of the solvent is equal to or more than the above lower limit, the viscosity of the composition is not excessively high, and a reduction of deposition workability can be prevented. When the content is equal to or less than the above upper limit, the deposited film obtained by removing the solvent has a certain thickness or more, and film formability is good.

### [Charge transport compound]

Preferably, the organic electroluminescent element composition in the present embodiment further contains a charge transport compound.

The charge transport compound used may be a material conventionally used for an organic electroluminescent element. Examples of the charge transport compound include charge transport materials shown as examples of a host material of a light-emitting layer described later. More specific examples include: triarylamine, biscarbazole, triaryltriazine, triarylpyrimidine, and derivatives thereof; and condensed aromatic ring compounds such as naphthalene, perylene, pyrene, anthracene, chrysene, naphthacene, phenanthrene, coronene, fluoranthene, benzophenanthrene, fluorene, and acetonaphthofluoranthene, each of which is substituted with an arylamino group or a carbazolyl group.

The charge transport compound may be a high-molecular weight compound, and examples of the high-molecular weight charge transport compound include: polyfluorene-based materials such as poly(9,9-dioctylfluorene-2,7-diyl), poly[(9,9-dioctylfluorene-2,7-diyl)-co-(4,4'-(N-(4-sec-butylphenyl))diphenylamine)], and poly[(9,9-dioctylfluorene-2,7-diyl)-co-(1,4-benzo-2{2,1'-3}-triazole)]; and polyphenylenevinylene-based materials such as poly[2-methoxy-5-(2-ethylhexyloxy)-1,4-phenylenevinylene].

One of these charge transport compounds may be used alone, or a combination of two or more may be used in any ratio.

When the organic electroluminescent element composition in the present embodiment contains any of these charge transport compounds, the content of the charge transport compound is preferably 5 to 100 times the amount of the light-emitting dopant and particularly preferably 5 to 20 times. When the content of the charge transport compound is equal to or more than the above lower limit, the quenching of light in the light-emitting dopant can be effectively prevented. When the content is equal to or less than the above upper limit, vivid light can be emitted from the light-emitting dopant highly efficiently.

### [Iridium complex compound]

An iridium complex compound according to another embodiment of the invention will be described.

The iridium complex compound of the invention is a compound represented by formula (1') below.

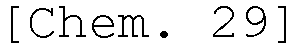

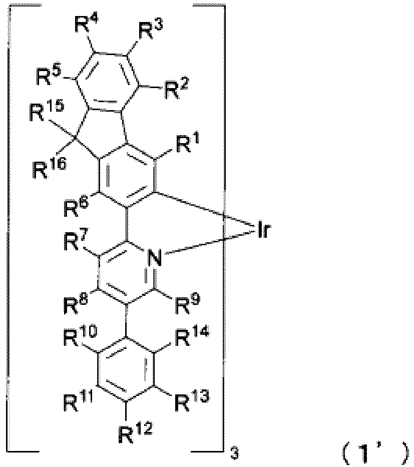

In formula (1') above, Ir represents an iridium atom.

R¹ to R¹⁶ each represent a substituent within any of the following ranges; adjacent two of R¹ to R¹⁶ may be bonded together to form a ring while losing respective hydrogen atoms.

R² to R⁵ are each selected from a [substituent group W] shown above.

R¹, R⁶ to R¹⁰, and R¹⁴ are each independently a hydrogen atom, F, a methyl group, a trifluoromethyl group, an ethyl group, a vinyl group, or an ethynyl group.

R¹⁵ and R¹⁶ are each independently a linear, branched, or cyclic alkyl group having 1 to 30 carbon atoms, an aralkyl group having 5 to 60 carbon atoms, or a heteroaralkyl group having 5 to 60 carbon atoms. Each of which may optionally have a substituent, which is the same as R' in the "substituent group W" shown above.

One of R¹¹ to R¹³ has a structure represented by formula (2) below; and the remaining two are each selected from a [substituent group Z] shown above.

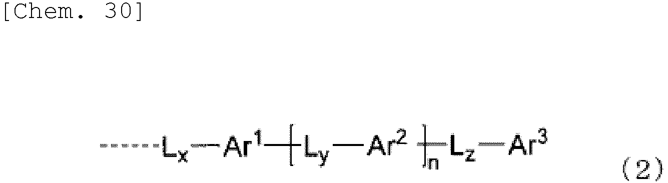

In formula (2) above, a broken line represents a bond to formula (1').

n represents an integer of 1 to 10.

When a plurality of L_{y}'s and a plurality of Ar²'s are present, they may be the same or different.

Lₓ, L_{y}, and L_{z} are each independently a direct bond or selected from -O-, -S-, -NR'-, -Si(R')₂-, -B(R')-, -C(=O)-, -P(=O) (R')-, -S(=O)₂-, -OSO₂-, and alkylene groups having 1 to 30 carbon atoms. Each of the alkylene groups may be optionally substituted with at least one R', wherein one - CH₂- group or 2 or more non-adjacent -CH₂- groups in each alkylene group may be replaced with -C(-R')=C(-R')-, -C=C-, -Si(-R')₂-, -C(=O)-, -NR'-, -O-, -S-, or -CONR'-. R' is the same as R' in the [substituent group W] shown above. At least one hydrogen atom in these groups may be replaced with F, Cl, Br, I, or -CN.

Ar¹ and Ar² each independently represent a divalent 5- or 6-membered aromatic hydrocarbon group or a divalent 5- or 6-membered aromatic heterocyclic group. Ar¹ and Ar² may each optionally have a substituent selected from the [substituent group Z] shown above.

Ar³ represents a monovalent 5- or 6-membered aromatic hydrocarbon group or a monovalent 5- or 6-membered aromatic heterocyclic group. Ar³ may optionally have a substituent selected from the [substituent group Z] shown above.

The iridium complex compound of the invention represented by formula (1') is the same as the compound represented by formula (1) and contained in the organic electroluminescent element composition in the preceding embodiment except that R¹⁵ and R¹⁶ are each independently a linear, branched, or cyclic alkyl group having 1 to 30 carbon atoms, an aralkyl group having 5 to 60 carbon atoms, or a heteroaralkyl group having 5 to 60 carbon atoms. The mechanism for obtaining its effects, preferred examples, specific examples, a production method, etc. are also the same as those of the compound represented by formula (1).

### <Applications of iridium complex compound>

The iridium complex compound of the invention represented by formula (1') can be preferably used as materials for organic EL elements, particularly as an assist dopant in a red organic EL element. The iridium complex compound can also be preferably used for light-emitting materials of yellowish green to orange organic EL elements.

### [Red light-emitting material]

Preferably, the iridium complex compound of the invention represented by formula (1') is used for a light-emitting layer-forming composition together with a red light-emitting material. The light-emitting material is a component of the composition of the invention that mainly emits light.

The maximum emission wavelength of the red light-emitting material depends on the shape of its spectrum but is generally 580 nm or more, preferably 600 nm or more, and more preferably 620 nm or more and is generally 700 nm or less, preferably 650 nm or less, and more preferably 640 nm or less. No particular limitation is imposed on the method for measuring the maximum emission wavelength. Different methods may be used for different measurement samples having different concentrations and having different states such as solution samples and solid film samples. However, by using a maximum emission wavelength measurement method for a solution described later, the maximum emission wavelength can be measured with high reproducibility.

A well-known red light-emitting material can be used. One fluorescent light-emitting material or one phosphorescent light-emitting material may be used alone, or a mixture a plurality of light-emitting materials may be used. From the viewpoint of internal quantum efficiency, a phosphorescent light-emitting material is preferred.

### <Phosphorescent light-emitting material>

Phosphorescent light-emitting materials emitting red light have various chemical structures, and it is difficult to identify their chemical structures. The type of ligand bonded directly to the central atom has a large influence on the emission wavelength. The emission wavelength can also be changed largely by changing a substituent introduced into the ligand. Therefore, a general structure of a phosphorescent light-emitting material will be first described, and then more preferred types of structure of the red light-emitting material will be described.

The phosphorescent light-emitting material is a material that emits light from an excited triplet state. Typical examples thereof include metal complex compounds containing Ir, Pt, Eu, etc., and it is preferable that the structure of the material contains a metal complex.

Among the metal complexes are phosphorescent light-emitting organic metal complexes that emit light through a triplet state, and examples thereof include Werner-type complex and organometallic complex compounds that contain, as the central metal, a metal selected from groups 7 to 11 of the long-form periodic table (hereinafter, the term "periodic table" refers to the long-form periodic table unless otherwise specified). The phosphorescent light-emitting material is preferably a compound represented by formula (201) described later or a compound represented by formula (205) described later and is more preferably the compound represented by formula (201).

### [Compound represented by formula (201)]

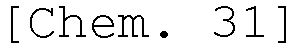

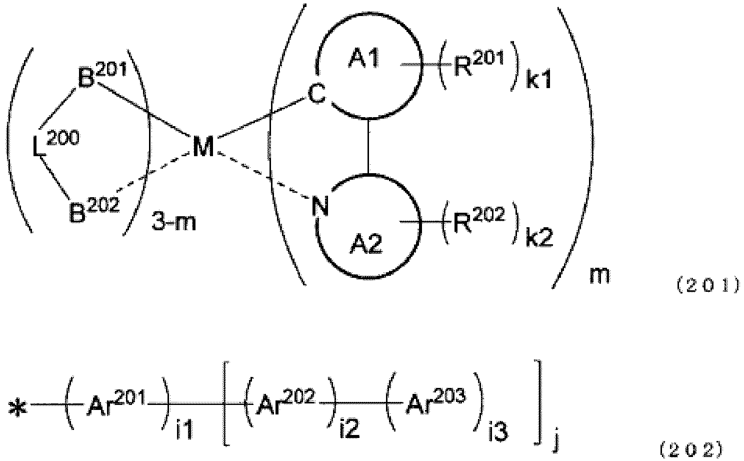

In formula (201) above, M is a metal selected from groups 7 to 11 of a periodic table. Examples thereof include ruthenium, rhodium, palladium, silver, rhenium, osmium, iridium, platinum, gold, and europium.

Ring A1 represents an aromatic hydrocarbon ring structure optionally having a substituent or an aromatic heterocyclic structure optionally having a substituent.

Ring A2 represents an aromatic heterocyclic structure optionally having a substituent.

R²⁰¹ and R²⁰² are each independently a structure represented by formula (202) above; "*" represents a bond to ring A1 or ring A2. R²⁰¹ and R²⁰² may be the same or different. When a plurality of R²⁰¹'s are present, they may be the same or different. When a plurality of R²⁰²'s are present, they may be the same or different.

Ar²⁰¹ represents a divalent aromatic hydrocarbon ring structure optionally having a substituent or a divalent aromatic heterocyclic structure optionally having a substituent. When a plurality of Ar²⁰¹'s are present, they may be the same or different;

Ar²⁰² represents a divalent aromatic hydrocarbon ring structure optionally having a substituent, a divalent aromatic heterocyclic structure optionally having a substituent, or a divalent aliphatic hydrocarbon structure optionally having a substituent. When a plurality of Ar²⁰²'s are present, they may be the same or different;

Ar²⁰³ represents a monovalent aromatic hydrocarbon ring structure optionally having a substituent or a monovalent aromatic heterocyclic structure optionally having a substituent. When a plurality of Ar²⁰³'s are present, they may be the same or different.

Substituents bonded to ring A1, substituents bonded to ring A2, or a substituent bonded to ring A1 and a substituent bonded to ring A2 may be bonded together to form a ring.

B²⁰¹-L²⁰⁰-B²⁰² represents an anionic bidentate ligand. B²⁰¹ and B²⁰² each independently represent a carbon atom, an oxygen atom, or a nitrogen atom. These atoms may each be an atom included in a ring. L²⁰⁰ represents a single bond or an atomic group that, together with B²⁰¹ and B²⁰², forms the bidentate ligand. When a plurality of B²⁰¹-L²⁰⁰-B²⁰² moieties are present, they may be the same or different.

i1 and i2 are each independently an integer of 0 or more and 12 or less.

i3 is an integer of 0 or more, with the upper limit thereof being the number of substituents that Ar²⁰² can have.

j is an integer of 0 or more, with the upper limit thereof being the number of substituents that Ar²⁰¹ can have.

k1 and k2 are each independently an integer of 0 or more, with the upper limit thereof being the number of substituents that ring A1 or A2 can have.

m is an integer of 1 to 3.

### (Ring A1)

The aromatic hydrocarbon ring in ring A1 is preferably an aromatic hydrocarbon ring having 6 to 30 carbon atoms. Specifically, the aromatic hydrocarbon ring is preferably a benzene ring, a naphthalene ring, an anthracene ring, a triphenylyl ring, an acenaphthene ring, a fluoranthene ring, or a fluorene ring.

The aromatic heterocycle in ring A1 is preferably an aromatic heterocycle having 3 to 30 carbon atoms and containing, as a heteroatom, a nitrogen atom, an oxygen atom, or a sulfur atom and more preferably a furan ring, a benzofuran ring, a thiophene ring, or a benzothiophene ring.

Ring A1 is more preferably a benzene ring, a naphthalene ring, or a fluorene ring, particularly preferably a benzene ring or a fluorene ring, and most preferably a benzene ring.

### (Ring A2)

The aromatic heterocycle in ring A2 is preferably an aromatic heterocyclic monocyclic or condensed ring having 3 to 30 carbon atoms and containing, as a heteroatom, a nitrogen atom, an oxygen atom, or a sulfur atom or a structure including monocyclic rings linked together.

Specific examples of the monocyclic or condensed ring include a pyridine ring, a pyrimidine ring, a pyrazine ring, a triazine ring, an imidazole ring, an oxazole ring, a thiazole ring, a benzothiazole ring, a benzoxazole ring, a benzimidazole ring, a quinoline ring, an isoquinoline ring, a quinoxaline ring, a quinazoline ring, a naphthyridine ring, and a phenanthridine ring. The monocyclic or condensed ring is more preferably a pyridine ring, a pyrazine ring, a pyrimidine ring, an imidazole ring, a benzothiazole ring, a benzoxazole ring, a quinoline ring, an isoquinoline ring, a quinoxaline ring, or a quinazoline ring, still more preferably a pyridine ring, an imidazole ring, a benzothiazole ring, a quinoline ring, an isoquinoline ring, a quinoxaline ring, or a quinazoline ring, and most preferably a pyridine ring, a benzothiazole ring, a quinoline ring, an isoquinoline ring, a quinoxaline ring, or a quinazoline ring.

The structure including monocyclic rings linked together is a structure represented by formula (203) below in which a pyridine ring and a triazine ring are bonded together.

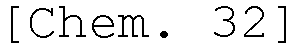

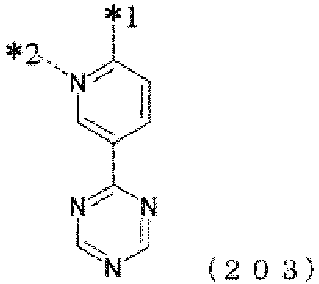

In formula (203), *1 represents a bond to ring A1 in formula (201), and *2 represents coordination to M in formula (201).

A preferred combination of ring A1 and ring A2 for the red phosphorescent light-emitting material, which is denoted as (ring A1-ring A2), is (benzene ring-pyridine ring-triazine ring), (benzene ring-quinoline ring), (benzene ring-isoquinoline ring), (benzene ring-quinoxaline ring), (benzene ring-quinazoline ring), or (benzene ring-benzothiazole ring).

The optional substituents on rings A1 and A2 can be freely selected but are each preferably one or a plurality of substituents selected from [Substituent group S] described later.

### (Ar²⁰¹, Ar²⁰², and Ar²⁰³)

When any of Ar²⁰¹, Ar²⁰², and Ar²⁰³ is an aromatic hydrocarbon ring structure optionally having a substituent, the aromatic hydrocarbon ring structure is preferably an aromatic hydrocarbon ring having 6 to 30 carbon atoms. Specifically, the aromatic hydrocarbon ring structure is preferably a benzene ring, a naphthalene ring, an anthracene ring, a triphenylyl ring, an acenaphthene ring, a fluoranthene ring, or a fluorene ring, more preferably a benzene ring, a naphthalene ring, or a fluorene ring, and most preferably a benzene ring.

When any of Ar²⁰¹, Ar²⁰², and Ar²⁰³ is a fluorene ring optionally having a substituent, it is preferable that the fluorene ring has substituents at the 9- and 9'-positions or is bonded to adjacent structures at the 9- and 9'-positions.

When any of Ar²⁰¹, Ar²⁰², and Ar²⁰³ is a benzene ring optionally having a substituent, it is preferable that at least one benzene ring is bonded to adjacent structures at ortho or meta positions, and it is more preferable that at least one benzene ring is bonded to adjacent structures at meta positions.

When any of Ar²⁰¹, Ar²⁰², and Ar²⁰³ is an aromatic heterocyclic structure optionally having a substituent, the aromatic heterocyclic structure is preferably an aromatic heterocycle having 3 to 30 carbon atoms and containing, as a heteroatom, a nitrogen atom, an oxygen atom, or a sulfur atom. Specific examples include a pyridine ring, a pyrimidine ring, a pyrazine ring, a triazine ring, an imidazole ring, an oxazole ring, a thiazole ring, a benzothiazole ring, a benzoxazole ring, a benzimidazole ring, a quinoline ring, an isoquinoline ring, a quinoxaline ring, a quinazoline ring, a naphthyridine ring, a phenanthridine ring, a carbazole ring, a dibenzofuran ring, and a dibenzothiophene ring. The aromatic heterocyclic structure is preferably a pyridine ring, a pyrimidine ring, a triazine ring, a carbazole ring, a dibenzofuran ring, or a dibenzothiophene ring.

When any of Ar²⁰¹, Ar²⁰², and Ar²⁰³ is a carbazole ring optionally having a substituent, it is preferable that the carbazole ring has a substituent at the N-position or is bonded to an adjacent structure at the N-position.

When Ar²⁰² is an aliphatic hydrocarbon structure optionally having a substituent, the aliphatic hydrocarbon structure is an aliphatic hydrocarbon structure having a linear, branched, or cyclic structure, preferably an aliphatic hydrocarbon structure having 1 to 24 carbon atoms, more preferably an aliphatic hydrocarbon structure having 1 to 12 carbon atoms, and still more preferably an aliphatic hydrocarbon structure having 1 to 8 carbon atoms.

### (i1, i2, i3, j, k1, and k2)

i1 and i2 are each independently preferably an integer of 1 to 12, more preferably an integer of 1 to 8, and still more preferably an integer of 1 to 6. When i1 and i2 are each within this range, it is expected that the solubility and charge transportability are improved.

i3 represents preferably an integer of 0 to 5 and is more preferably an integer of 0 to 2 and still more preferably 0 or 1.

j represents preferably an integer of 0 to 2 and is more preferably 0 or 1.

k1 and k2 each represent preferably an integer of 0 to 3 and are each more preferably an integer of 1 to 3, still more preferably 1 or 2, and particularly preferably 1.

### (Substituents)

The optional substituents on ring A1, ring A2, Ar²⁰¹, Ar²⁰², and Ar²⁰³ can each be freely selected. The substituents are each preferably one or a plurality of substituents selected from the following [Substituent group S], more preferably an alkyl group or an aryl group, and particularly preferably an alkyl group. Most preferably, ring A1, ring A2, Ar²⁰¹, Ar²⁰², and Ar²⁰³ are each unsubstituted.

### [Substituent group S]

- Alkyl groups, preferably alkyl groups having 1 to 20 carbon atoms, more preferably alkyl groups having 1 to 12 carbon atoms, still more preferably alkyl groups having 1 to 8 carbon atoms, and particularly preferably alkyl groups having 1 to 6 carbon atoms.
- Alkoxy groups, preferably alkoxy groups having 1 to 20 carbon atoms, more preferably alkoxy groups having 1 to 12 carbon atoms, and still more preferably alkoxy groups having 1 to 6 carbon atoms.
- Aryloxy groups, preferably aryloxy groups having 6 to 20 carbon atoms, more preferably aryloxy groups having 6 to 14 carbon atoms, still more preferably aryloxy groups having 6 to 12 carbon atoms, and particularly preferably aryloxy groups having 6 carbon atoms.
- Heteroaryloxy groups, preferably heteroaryloxy groups having 3 to 20 carbon atoms, and more preferably heteroaryloxy group having 3 to 12 carbon atoms.
- Alkylamino groups, preferably alkylamino groups having 1 to 20 carbon atoms, and more preferably alkylamino groups having 1 to 12 carbon atoms.
- Arylamino groups, preferably arylamino groups having 6 to 36 carbon atoms, and more preferably arylamino groups having 6 to 24 carbon atoms.
- Aralkyl groups, preferably aralkyl groups having 7 to 40 carbon atoms, more preferably aralkyl groups having 7 to 18 carbon atoms, and still more preferably aralkyl groups having 7 to 12 carbon atoms.
- Heteroaralkyl groups, preferably heteroaralkyl groups having 7 to 40 carbon atoms, and more preferably heteroaralkyl groups having 7 to 18 carbon atoms.
- Alkenyl groups, preferably alkenyl groups having 2 to 20 carbon atoms, more preferably alkenyl groups having 2 to 12 carbon atoms, still more preferably alkenyl groups having 2 to 8 carbon atoms, and particularly preferably alkenyl groups having 2 to 6 carbon atoms.
- Alkynyl groups, preferably alkynyl groups having 2 to 20 carbon atoms, and more preferably alkynyl groups having 2 to 12 carbon atoms.
- Aryl groups, preferably aryl groups having 6 to 30 carbon atoms, more preferably aryl groups having 6 to 24 carbon atoms, still more preferably aryl groups having 6 to 18 carbon atoms, and particularly preferably aryl groups having 6 to 14 carbon atoms.
- Heteroaryl groups, preferably heteroaryl groups having 3 to 30 carbon atoms, more preferably heteroaryl groups having 3 to 24 carbon atoms, still more preferably heteroaryl groups having 3 to 18 carbon atoms, and particularly preferably heteroaryl groups having 3 to 14 carbon atoms.
- Alkylsilyl groups, preferably alkylsilyl groups each including an alkyl group having 1 to 20 carbon atoms and more preferably alkylsilyl groups each including an alkyl group having 1 to 12 carbon atoms.
- Arylsilyl groups, preferably arylsilyl groups each including an aryl group having 6 to 20 carbon atoms and more preferably arylsilyl groups each including an aryl group having 6 to 14 carbon atoms.
- Alkylcarbonyl groups, preferably alkylcarbonyl groups having 2 to 20 carbon atoms.
- Arylcarbonyl groups, preferably arylcarbonyl groups having 7 to 20 carbon atoms.
- A hydrogen atom, a deuterium atom, a fluorine atom, a cyano group, and -SF₅.

In each of the above groups, at least one hydrogen atom may be replated with a fluorine atom, or at least one hydrogen atom may be replaced with a deuterium atom.

Each aryl group is an aromatic hydrocarbon group, and each heteroaryl group is an aromatic heterocyclic group, unless otherwise specified.

### (Preferred groups in [Substituent group S])

In the [Substituent group S],
preferred are alkyl groups, alkoxy groups, aryloxy groups, arylamino groups, aralkyl groups, alkenyl groups, aryl groups, heteroaryl groups, alkylsilyl groups, arylsilyl groups, groups obtained by replacing at least one hydrogen atom in any of the above groups with a fluorine atom, a fluorine atom, a cyano group, and -SF₅;
more preferred are alkyl groups, arylamino groups, aralkyl groups, alkenyl groups, aryl groups, heteroaryl groups, groups obtained by replacing at least one hydrogen atom in any of the above groups with a fluorine atom, a fluorine atom, a cyano group, and -SF₅;
still more preferred are alkyl groups, alkoxy groups, aryloxy groups, arylamino groups, aralkyl groups, alkenyl groups, aryl groups, heteroaryl groups, alkylsilyl groups, and arylsilyl groups;
particularly preferred are alkyl groups, arylamino groups, aralkyl groups, alkenyl groups, aryl groups, and heteroaryl groups; and
most preferred are alkyl groups, arylamino groups, aralkyl groups, aryl groups, and heteroaryl groups.

The substituents in the [Substituent group S] may each optionally have a substituent selected from the [Substituent group S]. Preferred optional substituents, more preferred optional substituents, still more preferred optional substituents, particularly preferred optional substituents, and most preferred optional substituents are the same as the preferred groups in the [Substituent group S].

### (B²⁰¹-L²⁰⁰-B²⁰²)

The structure represented by B²⁰¹-L²⁰⁰-B²⁰² is preferably a structure represented by formula (203) or (204) below.

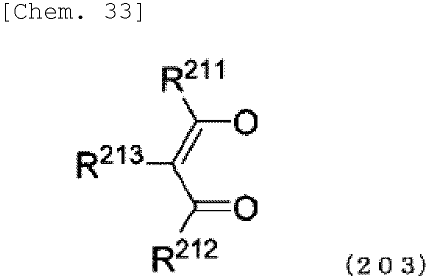

R²¹¹, R²¹², and R²¹³ each represent a substituent. No particular limitation is imposed on the substituent, but the substituent is preferably a group selected from the [Substituent group S].

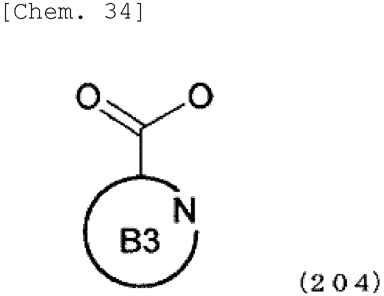

Ring B3 represents an aromatic heterocyclic structure containing a nitrogen atom and optionally having a substituent.

Ring B3 is preferably a pyridine ring.

No particular limitation is imposed on the optional substituent on ring B3, but the substituent is preferably a group selected from the [Substituent group S].

### (Preferred structure of formula (201))

The structure represented by formula (202) above in formula (201) above is preferably a structure having a group including benzene rings linked together, a structure including an aromatic hydrocarbon or aromatic heterocyclic group that has an alkyl or aralkyl group bonded thereto and is bonded to ring A1 or A2, or a structure including a dendron bonded to ring A1 or A2.

In the structure having a group including benzene rings linked together, Ar²⁰¹ is a benzene ring structure; i1 is 1 to 6; and at least one benzene ring is bonded to adjacent structures at ortho or meta positions.

With this structure, it is expected that the solubility is improved and the charge transportability is also improved.

In the structure including an aromatic hydrocarbon or aromatic heterocyclic group that has an alkyl or aralkyl group bonded thereto and is bonded to ring A1 or A2,
Ar²⁰¹ is an aromatic hydrocarbon structure or an aromatic heterocyclic structure; i1 is 1 to 6;
Ar²⁰² is an aliphatic hydrocarbon structure; i2 is 1 to 12 and preferably 3 to 8;
when Ar²⁰³ is present, Ar²⁰³ is a benzene ring structure; and i3 is 0 or 1.

In this structure, Ar²⁰¹ is preferably the aromatic hydrocarbon structure described above, more preferably a structure including 1 to 5 benzene rings linked together, and still more preferably one benzene ring.

With this structure, it is expected that the solubility is improved and the charge transportability is also improved.

In the structure including a dendron bonded to ring A1 or A2.
Ar²⁰¹ and Ar²⁰² are each a benzene ring structure;
Ar²⁰³ is a benzene ring structure, a biphenyl structure, or a terphenyl structure;
i1 and i2 are 1 to 6; i3 is 2; and j is 2.

With this structure, it is expected that the solubility is improved and the charge transportability is also improved.

### (Specific examples)

No particular limitation is imposed on the phosphorescent light-emitting material represented by formula (201) and emitting red light. Specific examples thereof include structures shown below.

Me means a methyl group, and Ph means a phenyl group.

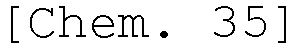

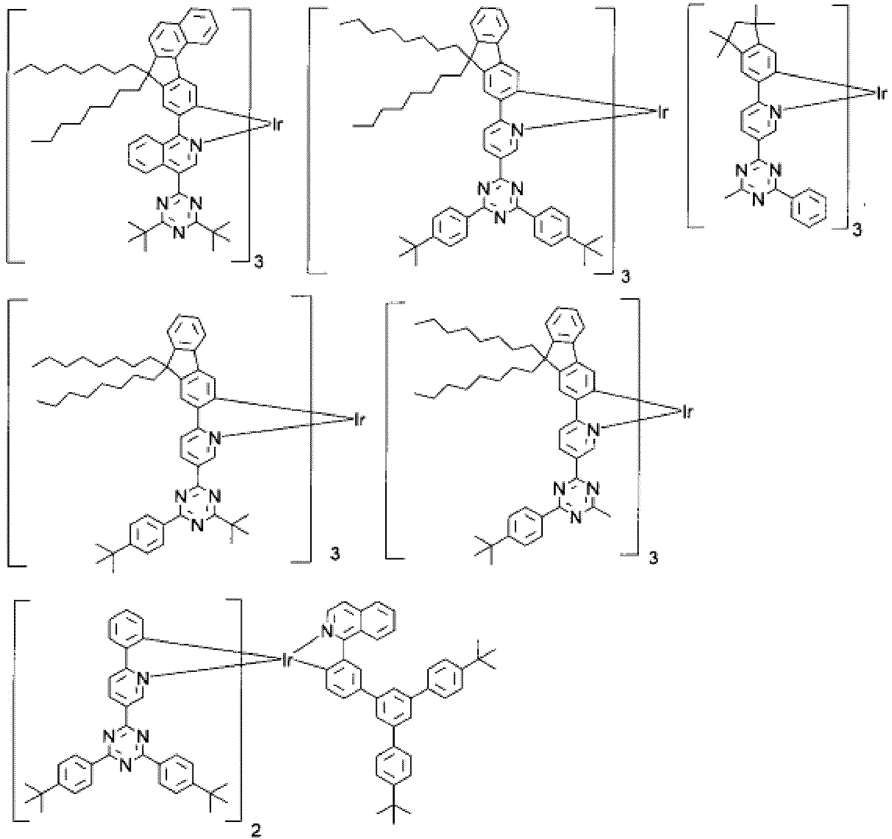

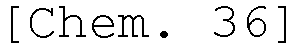

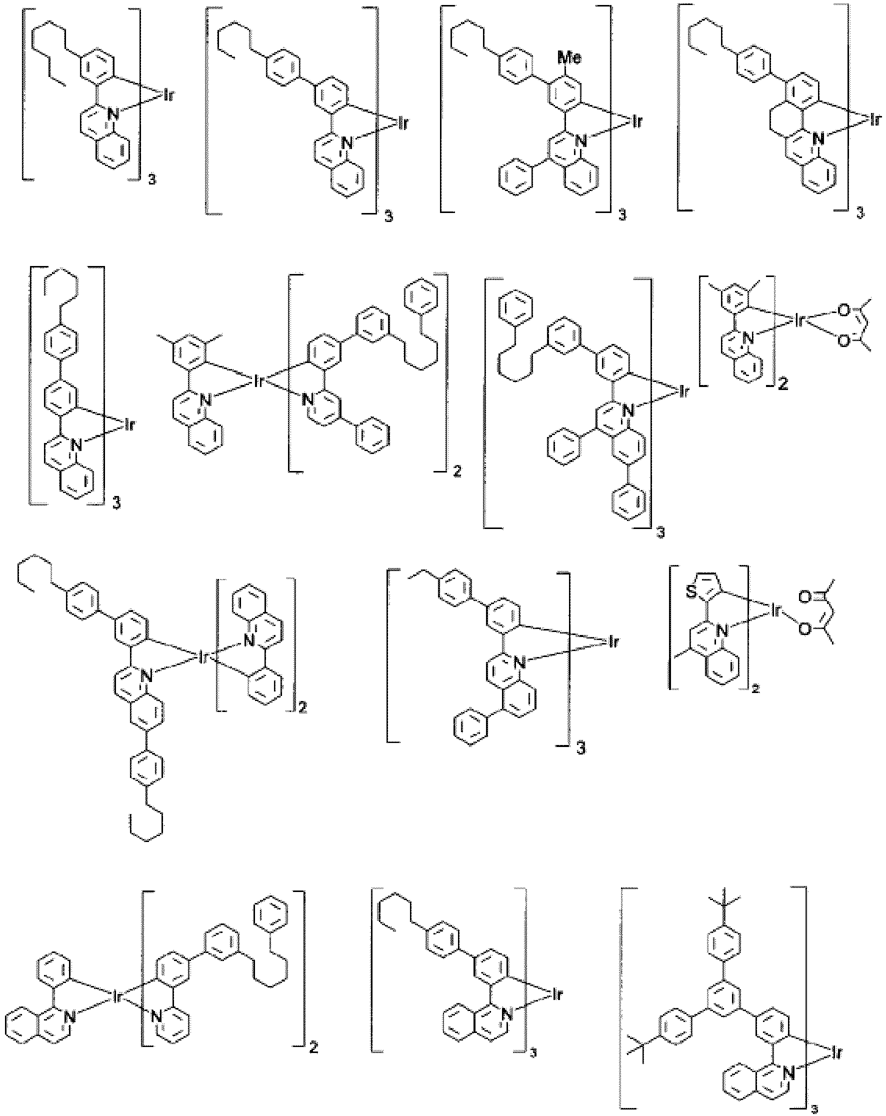

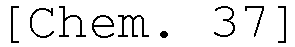

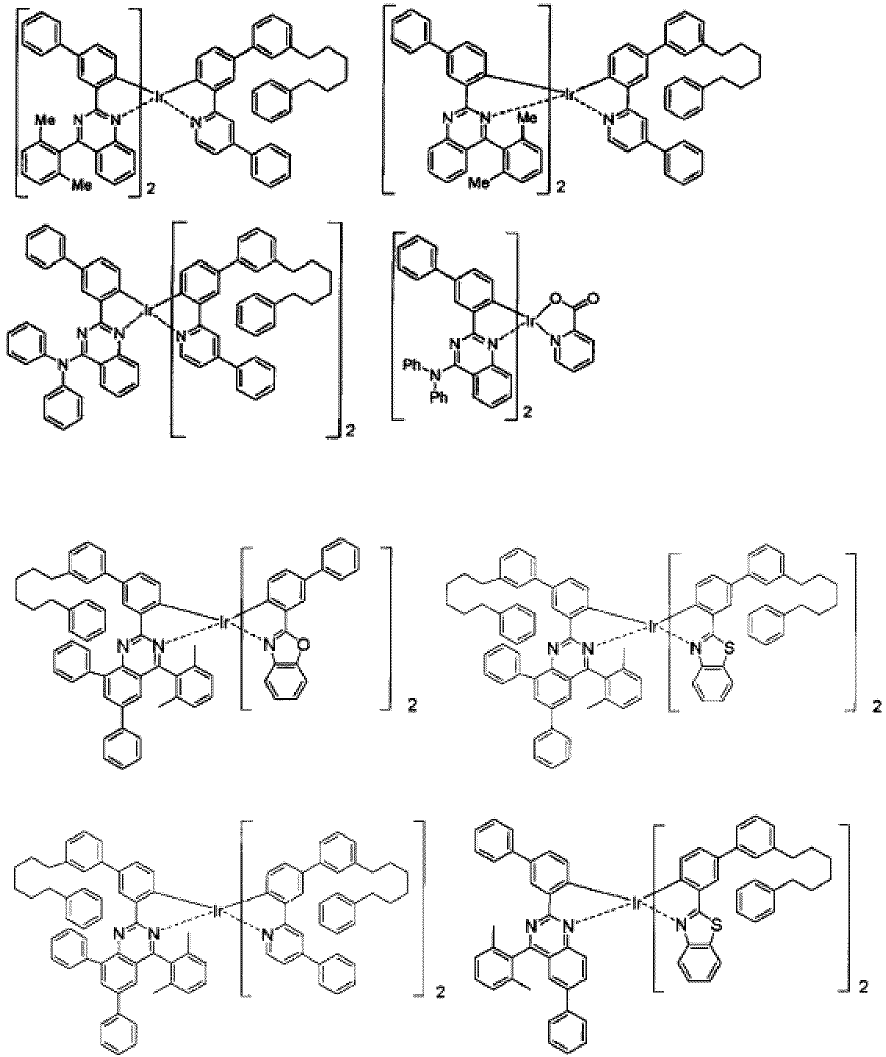

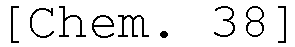

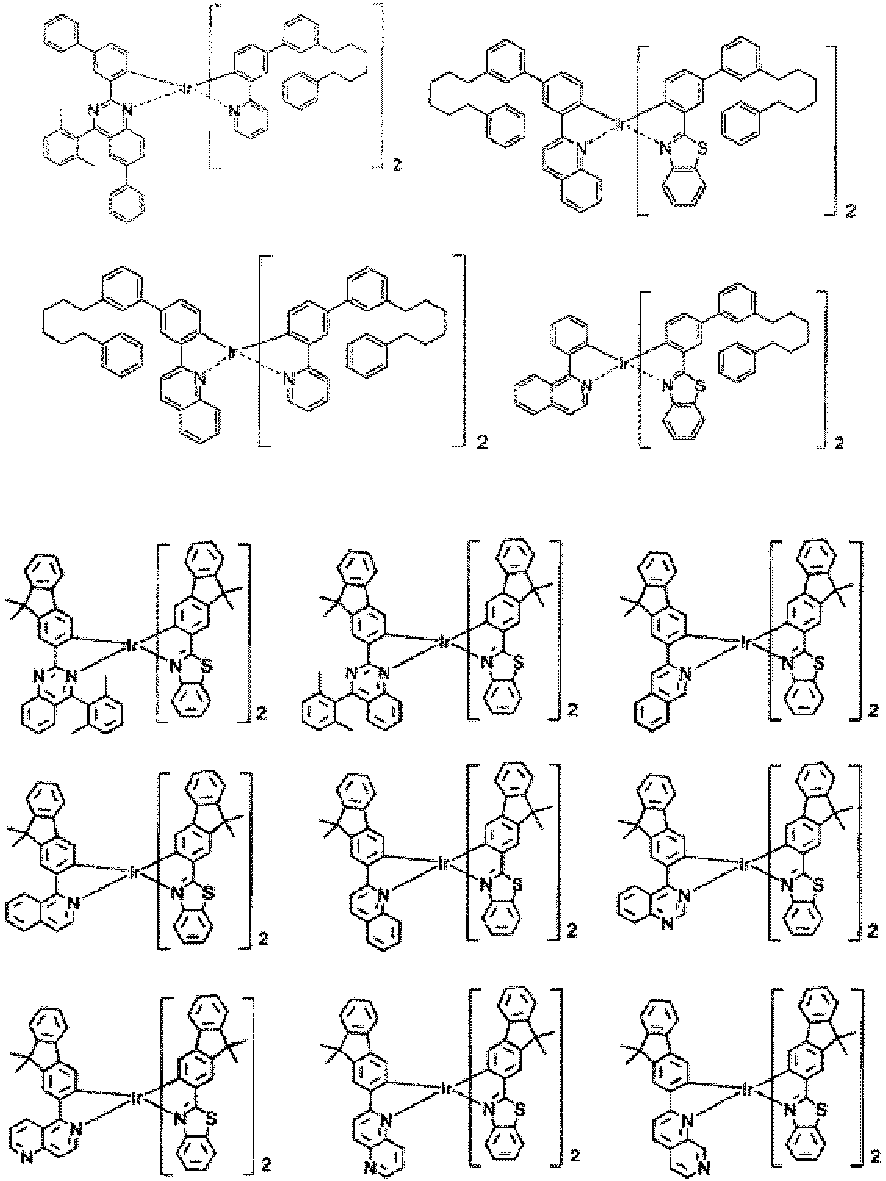

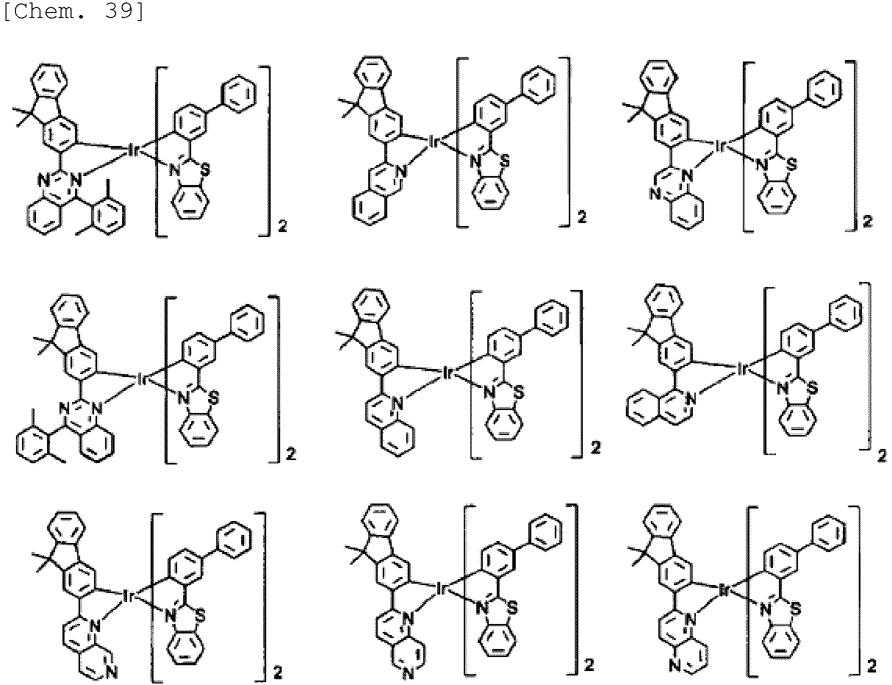

The organic electroluminescent element composition of the invention may contain only one compound represented by formula (201) above or may contain two or more compounds represented by formula (201).

### [Compound represented by formula (205)]

A compound represented by formula (205) below will be described.

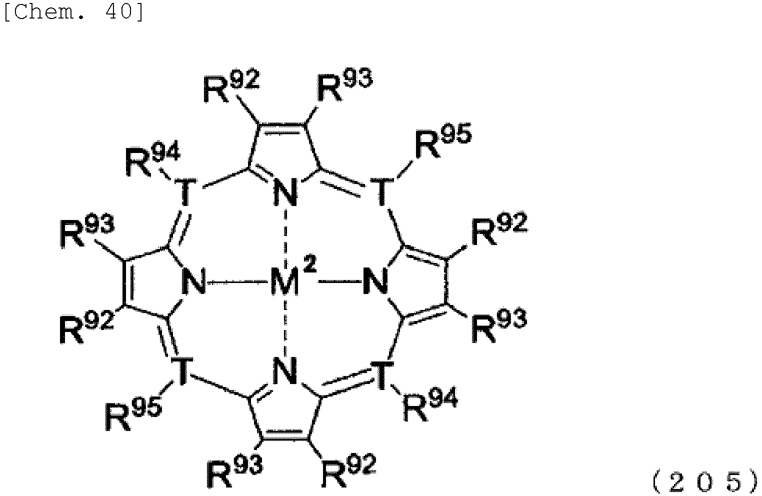

In formula (205), M² represents a metal, and T represents a carbon atom or a nitrogen atom. R⁹² to R⁹⁵ each independently represent a substituent. When T is a nitrogen atom, R⁹⁴ and R⁹⁵ are not present.

In formula (205), M² represents a metal. Specific examples include a metal selected from groups 7 to 11 of the periodic table. In particular, ruthenium, rhodium, palladium, silver, rhenium, osmium, iridium, platinum, or gold is preferred, and a divalent metal such as platinum or palladium is particularly preferred.

In formula (205), R⁹² and R⁹³ each independently represent a hydrogen atom, a halogen atom, an alkyl group, an aralkyl group, an alkenyl group, a cyano group, an amino group, an acyl group, an alkoxycarbonyl group, a carboxyl group, an alkoxy group, an alkylamino group, an aralkylamino group, a haloalkyl group, a hydroxy group, an aryloxy group, an aromatic hydrocarbon group, or an aromatic heterocyclic group.

When T is a carbon atom, R⁹⁴ and R⁹⁵ each independently represent the same substituent as any of those exemplified for R⁹² and R⁹³. When T is a nitrogen atom, no R⁹⁴ or R⁹⁵ is bonded directly to T.

R⁹² to R⁹⁵ may each optionally have a substituent. The substituent may be the same substituent as any of those shown for R⁹² and R⁹³. Two or more groups selected from R⁹² to R⁹⁵ may be linked together to form a ring.

### [Molecular weight]

The molecular weight of the phosphorescent light-emitting material such as the compound represented by formula (201) or (205) is preferably 5000 or less, more preferably 4000 or less, and particularly preferably 3000 or less. The molecular weight of the phosphorescent light-emitting material is generally 1000 or more, preferably 1100 or more, and more preferably 1200 or more. When the molecular weight of the phosphorescent light-emitting material is within the above range, molecules of the phosphorescent light-emitting material are not aggregated, and the phosphorescent light-emitting material is mixed uniformly with the iridium complex compound of the invention and/or another charge transfer material, so that a light-emitting layer having high luminous efficiency may be obtained.

It is preferable that the phosphorescent light-emitting material has a large molecular weight, from the viewpoint that Tg, the melting point, and the decomposition temperature are high, that the phosphorescent light-emitting material and a light-emitting layer to be formed have high heat resistance, that a reduction in film quality due to generation of gas, recrystallization, migration of molecules, etc. is unlikely to occur, and that an increase in the concentration of impurities due to thermal decomposition of the material is unlikely to occur. It is preferable that the phosphorescent light-emitting material has a small molecular weight, from the viewpoint that the organic compound can be easily purified.

### [Iridium complex compound-containing composition]

The iridium complex compound of the invention has high solvent solubility and is preferably used in combination with a solvent. A composition containing the iridium complex compound of the invention and a solvent (this composition may be hereinafter referred to as an "iridium complex compound-containing composition") will be described.

The iridium complex compound-containing composition in the invention contains the iridium complex compound of the invention and a solvent. The iridium complex compound-containing composition in the invention is generally used to form a layer or film by a wet deposition method and is particularly preferably used to form an organic layer in an organic electroluminescent element. The organic layer is particularly preferably a light-emitting layer. Specifically, the iridium complex compound-containing composition is preferably an organic electroluminescent element composition, i.e., the organic electroluminescent element composition of the invention, and is particularly preferably used as a light-emitting layer-forming composition.

The content of the iridium complex compound of the invention in the iridium complex compound-containing composition is generally 0.001% by mass or more and preferably 0.01% by mass or more and is generally 99.9% by mass or less and preferably 99% by mass or less. When the content of the iridium complex compound in the composition is within the above range, holes or electrons are injected efficiently from an adjacent layer (such as a hole transport layer or a hole blocking layer) to the light-emitting layer, and the driving voltage can be reduced. The iridium complex compound-containing composition may contain only one iridium complex compound of the invention or may contain a

combination of two or more iridium complex compounds.

When the iridium complex compound-containing composition in the invention is used as an organic electroluminescent element composition for, for example, an organic electroluminescent element, the iridium complex compound-containing composition may contain, in addition to the iridium complex compound and the solvent described above, a charge transport compound and the above-described red light-emitting material, preferably the phosphorescent light-emitting material, used for an organic electroluminescent element, in particular for a light-emitting layer.

When the iridium complex compound-containing composition in the invention is used to form a light-emitting layer of an organic electroluminescent element, the iridium complex compound of the invention can be used as the assist dopant in combination with the red light-emitting material as described above. Since the iridium complex compound of the invention itself emits yellowish green to yellow to orange light, the complex compound itself is used as a light-emitting material, and an additional charge transport compound may be contained as a charge transport host material.

The solvent contained in the iridium complex compound-containing composition is a volatile liquid component used to form a layer containing the iridium complex compound by wet deposition.

No particular limitation is imposed on the solvent so long as it is an organic solvent in which a charge transport compound described later can well dissolve because the iridium complex compound of the invention serving as the solute has high solvent solubility. Preferred examples of the solvent include: alkanes such as n-decane, cyclohexane, ethylcyclohexane, decalin, and bicyclohexane; aromatic hydrocarbons such as toluene, xylene, mesitylene, phenylcyclohexane, and tetralin; halogenated aromatic hydrocarbons such as chlorobenzene, dichlorobenzene, and trichlorobenzene; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic esters such as phenyl acetate, phenyl propionate, methyl benzoate, ethyl benzoate, propyl benzoate, and n-butyl benzoate; alicyclic ketones such as cyclohexanone, cyclooctanone, and fenchone; alicyclic alcohols such as cyclohexanol and cyclooctanol; aliphatic ketones such as methyl ethyl ketone and dibutyl ketone; aliphatic alcohols such as butanol and hexanol; and aliphatic ethers such as ethylene glycol dimethyl ether, ethylene glycol diethyl ether, and propylene glycol-1-monomethyl ether acetate (PGMEA).

Of these, alkanes and aromatic hydrocarbons are more preferred, and phenylcyclohexane is particularly preferred because it has a viscosity and a boiling point preferred for a wet deposition process.

One of these solvents may be used alone, or a combination of two or more may be used in any ratio.

The boiling point of the solvent used is generally 80°C or higher, preferably 100°C or higher, and more preferably 120°C or higher and is generally 270°C or lower, preferably 250°C or lower, and more preferably 230°C or lower. If the boiling point is lower than the above range, the deposition stability may decrease due to the evaporation of the solvent from the composition during wet deposition.

The content of the solvent in the iridium complex compound-containing composition is preferably 1% by mass or more, more preferably 10% by mass or more, and particularly preferably 50% by mass or more and is preferably 99.99% by mass or less, more preferably 99.9% by mass or less, and particularly preferably 99% by mass or less. The thickness of the light-emitting layer is generally about 3 to about 200 nm. If the content of the solvent is lower than the lower limit, the viscosity of the composition is excessively high, and the deposition workability may decrease. If the content of the solvent is higher than the upper limit, the deposited film obtained by removing the solvent from the film may not have a sufficient thickness, so that the film tends not to be easily formed.

The content of the red light-emitting material such as the above-described phosphorescent light-emitting material contained in the iridium complex compound-containing composition used as the organic electroluminescent element composition with respect to 1 part by mass of the iridium complex compound of the invention in the iridium complex compound-containing composition is generally 0.01 parts by mass or more, preferably 0.2 parts by mass or more, and more preferably 0.25 parts by mass or more and is generally 10 parts by mass or less, preferably 4 parts by mass or less, and more preferably 2 parts by mass or less. If the content of the red light-emitting material is lower than the above lower limit, the iridium complex compound of the invention itself emits light, and the purity of the red color may decrease. If the content of the red light-emitting material is higher than the above upper limit, the ratio of the red light-emitting material that can be assisted by the assist dopant is excessively small, so that the performance of the element may decrease.

A charge transport compound conventionally used as an organic electroluminescent element material can be used as the additional charge transport compound that can be contained in the iridium complex compound-containing composition in the invention. Examples thereof include pyridine, carbazole, naphthalene, perylene, pyrene, anthracene, chrysene, naphthacene, phenanthrene, coronene, fluoranthene, benzophenanthrene, fluorene, acetonaphthofluoranthene, coumarin, p-bis(2-phenylethenyl)benzene and derivatives thereof, quinacridone derivatives, DCM (4-(dicyanomethylene)-2-methyl-6-(p-dimethylaminostyryl)-4H-pyran)-based compounds, benzopyran derivatives, rhodamine derivatives, benzothioxanthene derivatives, azabenzothioxanthene, condensed aromatic cyclic compounds substituted with an arylamino group, and styryl derivatives substituted with an arylamino group.

One of them may be used alone, or a combination of two or more may be used in any ratio.

The content of the additional charge transport compound in the iridium complex compound-containing composition with respect to 1 part by mass of the iridium complex compound of the invention in the iridium complex compound-containing composition is generally 1000 parts by mass or less, preferably 100 parts by mass or less, and more preferably 50 parts by mass or less and is generally 0.01 parts by mass or more, preferably 0.1 parts by mass or more, and more preferably 1 part by mass or more.

The iridium complex compound-containing composition in the invention may optionally contain additional compounds in addition to the compounds described above. For example, an additional solvent may be contained in addition to the solvent described above. Examples of such a solvent include amides such as N,N-dimethylformamide and N,N-dimethylacetamide and dimethyl sulfoxide. One of these solvents may be used alone, or a combination of two or more may be used in any ratio.

### [Organic electroluminescent element]

The organic electroluminescent element in the present embodiment includes a layer formed using the organic electroluminescent element composition in the preceding embodiment (containing the iridium complex compound-containing composition described above) preferably by a wet deposition method.

Since the organic electroluminescent element composition contains the iridium complex compound of the invention, the layer contains the iridium complex compound of the invention.

Preferably, the organic electroluminescent element includes at least an anode and a cathode that are disposed on a substrate and further includes at least one organic layer between the anode and the cathode. At least one of the at least one organic layer is a layer formed using the organic electroluminescent element composition in the preceding embodiment. More preferably, this layer is formed by a wet deposition method using the organic electroluminescent element composition containing the organic solvent. The organic layer includes a light-emitting layer, and it is more preferable that the light-emitting layer is a layer formed using the organic electroluminescent element composition in the preceding embodiment.

In the present description, the wet deposition method is a film forming method including using a wet deposition process, i.e., a coating process, to form a film and then drying the film. Examples of the coating process include a spin coating method, a dip coating method, a die coating method, a bar coating method, a blade coating method, a roll coating method, a spray coating method, a capillary coating method, an inkjet method, a nozzle printing method, a screen printing method, a gravure printing method, and a flexographic printing method.

Fig. 1 is a schematic illustration of a cross section showing a preferred structural example of the organic electroluminescent element 10 of the invention. In Fig. 1, reference numeral 1 represents a substrate; reference numeral 2 represents an anode; reference numeral 3 represents a hole injection layer; reference numeral 4 represents a hole transport layer; reference numeral 5 represents a light-emitting layer; reference numeral 6 represents a hole blocking layer; reference numeral 7 represents an electron transport layer; reference numeral 8 represents an electron injection layer; and reference numeral 9 represents a cathode.

The materials applied to these structures can be publicly known materials and are not particularly limited. Representative materials and manufacturing methods for each layer are described below as examples. When publications, papers, and the like are cited below, it is assumed that the relevant contents can be applied and adapted as appropriate within the scope of common sense of those skilled in the art.

### [Substrate 1]

The substrate 1 is a support member for supporting the organic electroluminescent element. Usually, the substrate 1 is a quartz or glass plate, a metal plate, a metal foil, or a synthetic resin, that is a plastic film or a plastic sheet, etc. Among these, a glass plate or a film of a transparent synthetic resin such as polyester, polymethacrylate, polycarbonate, or polysulfone is preferred. It is preferable that the substrate 1 is made of a material having high gas barrier properties because deterioration of the organic electroluminescent element due to outside air passing through the substrate is suppressed. When a material having low gas barrier properties such as a synthetic resin substrate is used, it is preferable to provide a dense silicon oxide film or the like on at least one side of the substrate 1 to improve the gas barrier properties.

### [Anode 2]

The anode 2 has a function of injecting holes into the layers on the light-emitting layer side. The anode 2 is usually made of metals such as aluminum, gold, silver, nickel, palladium, platinum, and the like; metal oxides such as indium and/or tin oxide, and the like; metal halides such as copper iodide, and the like; carbon black; and conductive polymers such as poly(3-methylthiophene), polypyrrole, polyaniline, and the like.

The anode 2 is usually formed by a dry method such as sputtering method, vacuum vapon deposition method, and the like. When forming the anode 2 using fine metal particles such as silver, and the like; fine particles such as copper iodide, and the like; carbon black; fine electrically conductive metal oxide particles; fine conductive polymer particles; and the like, it can also be formed by dispersing them in a suitable binder resin solution and applying it to the substrate. In the case of conductive polymers, a thin film can be formed directly on the substrate by electrolytic polymerization, or the anode 2 can be formed by applying the conductive polymer to the substrate (Appl. Phys. Lett., Vol. 60, p. 2711, 1992).

The anode 2 has generally a monolayer structure but may have a layered structure. When the anode 2 has a layered structure, a different conductive material may be laminated on the first anode layer.

The thickness of the anode 2 may be determined according to the required transparency and material. When particularly high transparency is required, a thickness that provides a visible light transmittance of 60% or more is preferable, and a thickness that provides a visible light transmittance of 80% or more is even more preferable. The thickness of the anode 2 is usually 5 nm or more, and preferably 10 nm or more, and usually 1000 nm or less, and preferably 500 nm or less.

When transparency is unnecessary, the thickness of the anode 2 can be freely selected according to the required strength etc. In this case, the thickness of the anode 2 may be the same as the thickness of the substrate 1.

After the formation of the anode 2, another layer may be formed on the surface of the anode 2. In this case, it is preferable that the surface of the anode 2 is treated with UV rays + ozone, oxygen plasma, argon plasma, etc. before the formation of the other layer to remove impurities on the anode and to control its ionization potential to thereby improve hole injectability.

### [Hole injection layer 3]

A layer having the function of transporting holes from the anode 2 side to the light-emitting layer 5 side is generally referred to as a hole injection-transport layer or a hole transport layer. When the number of layers having the function of transporting holes from the anode 2 side to the light-emitting layer 5 side is two or more, the layer closer to the anode 2 may be referred to as a hole injection layer 3.

The hole injection layer 3 will next be described. The hole injection-transport layer or the hole transport layer when the number of layers having the function of transporting holes from the anode 2 side to the light-emitting layer 5 side is one is also described as the hole injection layer 3. Specifically, the hole transport layer 4 described later differs from the hole transport layer when the number of layers having the function of transporting holes is one, is the name of the layer closer to the light-emitting layer 5 when the number of layers is 2 or more, and is an optional layer.

It is preferable to use the hole injection layer 3 in order to enhance the function of transporting holes from the anode 2 to the light-emitting layer 5. When the hole injection layer 3 is used, the hole injection layer 3 is generally formed on the anode 2.

The thickness of the hole injection layer 3 is generally 1 nm or more and preferably 5 nm or more and is generally 1000 nm or less and preferably 500 nm or less.

The method for forming the hole injection layer 3 may be a vacuum vapor deposition method or a wet deposition method. It is preferable to use the wet deposition method because of its good film formability.

The hole injection layer 3 contains preferably a hole transport compound and contains more preferably a hole transport compound and an electron accepting compound. Moreover, the hole injection layer 3 contains preferably a cation radical compound and contains particularly preferably a cation radical compound and a hole transport compound.

### (Hole transport compound)

A hole injection layer-forming composition generally contains the hole transport compound that forms the hole injection layer 3.

When a wet deposition method is used, the hole injection layer-forming composition generally further contains a solvent. Preferably, the hole transport compound in the hole injection layer-forming composition has high hole transportability and can transport the injected holes efficiently. Therefore, it is preferable that the mobility of holes is high and impurities serving as traps are unlikely to be generated during production and use. It is also preferable that the hole transport compound is highly stable, has a small ionization potential, and is highly transparent to visible light. In particular, when the hole injection layer 3 is in contact with the light-emitting layer 5, i.e., when the layer having the function of transporting holes from the anode 2 side to the light-emitting layer 5 side is the hole injection layer 3 only, it is preferable that the hole transport compound does not attenuate the light emitted from the light-emitting layer 5 and does not cause the formation of exciplexes in the light-emitting layer 5 so that the luminous efficiency is not reduced.

The hole transport compound is preferably a compound having an ionization potential of 4.5 eV to 6.0 eV, from the viewpoint of the charge injection barrier from the anode 2 to the hole injection layer 3. Examples of the hole transport compound include aromatic amine-based compounds, phthalocyanine-based compounds, porphyrin-based compounds, oligothiophene-based compounds, polythiophene-based compounds, benzylphenyl-based compounds, compounds including tertiary amines linked via a fluorene group, hydrazone-based compounds, silazane-based compounds, and quinacridone-based compounds.

Among the exemplified compounds, aromatic amine compounds are preferred, and aromatic tertiary amine compounds are particularly preferred in terms of non-crystallinity and visible light transparency. The aromatic tertiary amine compound is a compound having an aromatic tertiary amine structure and is intended to include a compound having a group derived from an aromatic tertiary amine.

No particular limitation is imposed on the type of aromatic tertiary amine compound. However, it is preferable to use a high-molecular weight compound (a polymerized compound including repeating units linked together) having a weight average molecular weight of 1000 or more and 1000000 or less because uniform light emission can be easily obtained due to its surface smoothing effect. Preferred examples of the high-molecular weight aromatic tertiary amine compound include high-molecular weight compounds having a repeating unit represented by formula (I) below.

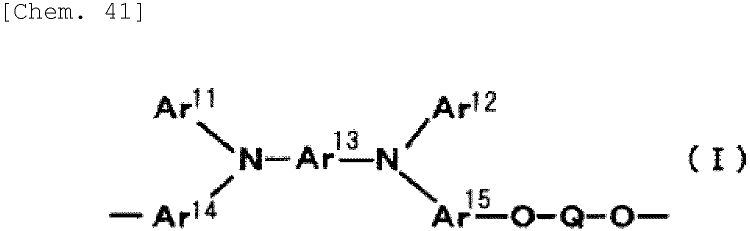

In formula (I), Ar¹¹ and Ar¹² each independently represent a monovalent aromatic group optionally having a substituent or a monovalent heteroaromatic group optionally having a substituent. Ar¹³ to Ar¹⁵ each independently represent a divalent aromatic group optionally having a substituent or a divalent heteroaromatic group optionally having a substituent. Q represents a linking group selected from the following group of linking groups. Two of Ar¹¹ to Ar¹⁵ that are bonded to the same N atom may be bonded together to form a ring.

The linking groups are shown below.

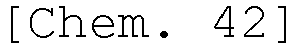

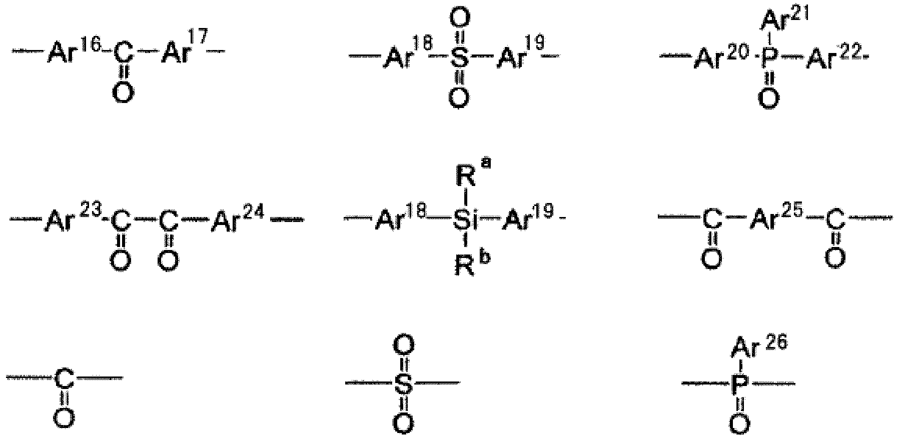

In the above formulas, Ar¹⁶ to Ar²⁶ each independently represent an aromatic group optionally having a substituent or a heteroaromatic group optionally having a substituent. R^{a} and R^{b} each independently represent a hydrogen atom or an optional substituent.

The aromatic and heteroaromatic groups in Ar¹¹ to Ar²⁶ are each more preferably a group derived from a benzene ring, a naphthalene ring, a phenanthrene ring, a thiophene ring, or a pyridine ring and more preferably a group derived from a benzene ring or a naphthalene ring because the high-molecular weight compound can have good solubility, heat resistance, hole injectability, and hole transportability.

Specific examples of the high-molecular weight aromatic tertiary amine compound having the repeating unit represented by formula (I) include those described in WO2005/089024.

### (Electron accepting compound)

It is preferable that the hole injection layer 3 contains an electron accepting compound because the hole transport compound is oxidized and the electric conductivity of the hole injection layer 3 can thereby be improved.

The electron accepting compound is preferably an oxidative compound having the ability to receive one electron from the hole transport compound described above. Specifically, a compound having an electron affinity of 4 eV or more is preferred, and a compound having an electron affinity of 5 eV or more is more preferred.

The electron accepting compound is, for example, one or two or more compounds selected from the group consisting of triarylboron compounds, metal halides, Lewis acids, organic acids, onium salts, salts of arylamines and metal halides, and salts of arylamines and Lewis acids. Specific examples include: onium salts substituted with organic groups such as 4-isopropyl-4'-methyldiphenyliodonium tetrakis(pentafluorophenyl)borate and triphenylsulfonium tetrafluoroborate (WO2005/089024); high-valence inorganic compounds such as iron chloride(III) (JP11-251067A) and ammonium peroxodisulfate; cyano compounds such as tetracyanoethylene; aromatic boron compounds such as tris(pentafluorophenyl)borane (JP2003-31365A); fullerene derivatives; and iodine.

### (Cation radical compound)

The cation radical compound is preferably an ionic compound including a cation radical that is a chemical species obtained by removing one electron from a hole transport compound and a counter anion. When the cation radical is derived from a high-molecular weight hole transport compound, the cation radical has a structure obtained by removing one electron from a repeating unit of the high-molecular weight compound.

The cation radical is preferably a chemical species obtained by removing one electron from any of the above-described compounds serving as the hole transport compound, from the viewpoint of non-crystallinity, visible light transparency, heat resistance, and solubility.

The cation radical compound can be formed by mixing the above-described hole transport compound and the above-described electron accepting compound. When the hole transport compound and the electron accepting compound are mixed, electron transfer occurs from the hole transport compound to the electron accepting compound, and a cation radical compound including the cation radical of the hole transport compound and the counter anion is formed.

For example, cation radical compounds derived from high-molecular weight compounds such as poly(3,4-ethylenedioxythiophene) doped with poly(4-styrene sulfonic acid) (PEDOT/PSS) (Adv. Mater., 2000, Vol. 12, pp. 481) and emeraldine hydrochloride (J. Phys. Chem., 1990, Vol. 94, pp. 7716) can also be formed through oxidative polymerization (dehydrogenation polymerization).

The oxidative polymerization is chemical or electrochemical oxidation of a monomer in an acidic solution using, for example, peroxodisulfate. With the oxidative polymerization (dehydrogenation polymerization), the monomer is oxidized and polymerized, and a cation radical obtained by removing one electron from the repeating unit of the polymer and a counter anion that is an anion derived from the acidic solution are formed.

### (Formation of hole injection layer 3 by wet deposition method)

Generally, when the hole injection layer 3 is formed by a wet deposition method, materials forming the hole injection layer 3 and a solvent (hole injection layer solvent) capable of dissolving these materials are mixed to prepare a film-forming composition (hole injection layer-forming composition), and the hole injection layer-forming composition is formed into a coating film on a layer corresponding to a layer disposed below the hole injection layer 3, generally the anode 2, by the wet deposition method, and the coating film is dried. The formed film can be dried in the same manner as the method for drying the light-emitting layer 5 formed by the wet deposition method.

The concentration of the hole transport compound in the hole injection layer-forming composition can be freely set so long as the effects of the invention are not significantly impaired. The lower the concentration, the better from the viewpoint of the uniformity of the film thickness. The higher the concentration, the better from the viewpoint that defects are unlikely to be formed in the hole injection layer 3. The concentration of the hole transport compound in the hole injection layer-forming composition is preferably 0.01% by mass or more, more preferably 0.1% by mass or more, and particularly preferably 0.5% by mass or more and is preferably 70% by mass or less, more preferably 60% by mass or less, and particularly preferably 50% by mass or less.

Examples of the solvent include ether-based solvents, ester-based solvents, aromatic hydrocarbon-based solvents, and amide-based solvents.

Examples of the ether-based solvent include: aliphatic ethers such as ethylene glycol dimethyl ether, ethylene glycol diethyl ether, and propylene glycol-1-monomethyl ether acetate (PGMEA); and aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole.

Examples of the ester-based solvent include aromatic esters such as phenyl acetate, phenyl propionate, methyl benzoate, ethyl benzoate, propyl benzoate, and n-butyl benzoate.

Examples of the aromatic hydrocarbon-based solvent include toluene, xylene, cyclohexylbenzene, 3-isopropylbiphenyl, 1,2,3,4-tetramethylbenzene, 1,4-diisopropylbenzene, and methylnaphthalene.

Examples of the amide-based solvent include N,N-dimethylformamide and N,N-dimethylacetamide.

In addition to these solvents, dimethyl sulfoxide etc. can also be used.

The hole injection layer 3 is generally formed by the wet deposition method as follows. The hole injection layer-forming composition is prepared and applied to a layer corresponding to a layer disposed below the hole injection layer 3, generally the anode 2, to form a coating film, and then the coating film is dried. Generally, after the formation of the coating film, the coating film is dried by heating or under reduced pressure to thereby obtain the hole injection layer 3.

### (Formation of hole injection layer 3 by vacuum vapor deposition method)

Generally, when the hole injection layer 3 is formed by a vacuum vapor deposition method, materials forming the hole injection layer 3, i.e., one or two or more materials such as the hole transport compound and the electron accepting compound, are placed in crucibles disposed in a vacuum container. In this case, when two or more materials are used, they are placed in different crucibles. Then the vacuum container is evacuated to about 10⁻⁴ Pa using a vacuum pump, and the crucibles are heated to evaporate the materials in the crucibles while the evaporation amounts are controlled. Generally, when two or more materials are used, the crucibles are heated to evaporate the materials while the evaporation amounts are controlled independently. Through the above operation, the hole injection layer 3 is formed on the anode 2 on the substrate placed so as to face the crucibles. When two or more materials are used, a mixture of the materials may be placed in a crucible, heated, and evaporated to form the hole injection layer 3.

No limitation is imposed on the degree of vacuum during evaporation so long as the effect of the invention are not significantly impaired. The degree of vacuum is generally 0.1 × 10⁻⁶ Torr (0.13 × 10⁻⁴ Pa) or more and 9.0 × 10⁻⁶ Torr (12.0 × 10⁻⁴ Pa) or less.

No limitation is imposed on the evaporation rate so long as the effect of the invention are not significantly impaired. The evaporation rate is generally 0.1 Å/second or more and 5.0 Å/second or less.

No limitation is imposed on the deposition temperature during evaporation so long as the effect of the invention are not significantly impaired. The deposition temperature is preferably 10°C or higher and 50°C or lower.

### [Hole transport layer 4]

The hole transport layer 4 is a layer having the function of transporting holes from the anode 2 side to the light-emitting layer 5 side. In the organic electroluminescent element in the present embodiment, the hole transport layer 4 is not an essential layer. However, to enhance the function of transportation holes from the anode 2 to the light-emitting layer 5, it is preferable to provide the hole transport layer 4. When the hole transport layer 4 is provided, the hole transport layer 4 is generally formed between the anode 2 and the light-emitting layer 5. When the hole injection layer 3 is present, the hole transport layer 4 is formed between the hole injection layer 3 and the light-emitting layer 5.

The thickness of the hole transport layer 4 is generally 5 nm or more and preferably 10 nm or more and is generally 300 nm or less and preferably 100 nm or less.

The hole transport layer 4 may be formed by a vacuum vapor deposition method or may be formed by a wet deposition method. It is preferable to use the wet deposition method for the formation because of its good film formability.

Generally, the hole transport layer 4 contains a hole transport compound forming the hole transport layer 4.

Examples of the hole transport compound contained in the hole transport layer 4 include: aromatic diamines typified by 4,4'-bis[N-(1-naphthyl)-N-phenylamino]biphenyl and containing two or more tertiary amines with two or more condensed aromatic rings substituted on the nitrogen atoms (JP5-234681A); aromatic amine compounds having a starburst structure such as 4,4',4'-tris(1-naphthylphenylamino)triphenylamine (J. Lumin., Vol. 72-74, pp. 985, 1997); aromatic amine compounds including a tetramer of triphenylamine (Chem. Commun., pp. 2175, 1996); spiro compounds such as 2,2',7,7'-tetrakis-(diphenylamino)-9,9'-spirobifluorene (Synth. Metals, Vol. 91, pp. 209, 1997); and carbazole derivatives such as 4,4'-N,N'-dicarbazolebiphenyl. In addition, polyvinylcarbazole, polyvinyltriphenylamine (JP7-53953A), and tetraphenylbenzidine-containing polyarylene ether sulfone (Polym. Adv. Tech., Vol. 7, pp. 33, 1996) can also be preferably used.

### (Formation of hole transport layer 4 by wet deposition method)

Generally, when the hole transport layer 4 is formed by a wet deposition method, the hole transport layer 4 is formed in the same manner as in the formation of the hole injection layer 3 by the wet deposition method except that a hole transport layer-forming composition is used instead of the hole injection layer-forming composition.

Generally, when the hole transport layer 4 is formed by the wet deposition method, the hole transport layer-forming composition further contains a solvent. The solvent used for the hole transport layer-forming composition is the same as the solvent used for the hole injection layer-forming composition described above.

The concentration of the hole transport compound in the hole transport layer-forming composition can be within the same range as that of the concentration of the hole transport compound in the hole injection layer-forming composition.

The hole transport layer 4 can be formed by the wet deposition method in the same manner as in the method for forming the hole injection layer 3 described above.

### (Formation of hole transport layer 4 by vacuum vapor deposition method)

When the hole transport layer 4 is formed by a vacuum vapor deposition method, the hole transport layer 4 can be generally formed in the same manner as that described for the formation of the hole injection layer 3 by the vacuum vapor deposition method except that materials forming the hole transport layer 4 are used instead of the materials forming the hole injection layer 3. The film deposition conditions such as the degree of vacuum during evaporation, the evaporation rate, and temperature during film formation can be the same as those during the vacuum vapor deposition of the hole injection layer 3.

### [Light-emitting layer 5]

The light-emitting layer 5 is a layer having the function of emitting light when it is excited by the recombination of holes injected from the anode 2 and electrons injected from the cathode 9 under the application of an electric field between the pair of electrodes.

The light-emitting layer 5 is a layer formed between the anode 2 and the cathode 9. When the hole injection layer 3 is present on the anode 2, the light-emitting layer 5 is formed between the hole injection layer 3 and the cathode 9. When the hole transport layer 4 is present on the anode 2, the light-emitting layer 5 is formed between the hole transport layer 4 and the cathode 9.

The thickness of the light-emitting layer 5 can be freely set so long as the effect of the invention are not significantly impaired. The larger the thickness, the better from the viewpoint that defects are unlikely to be formed. The smaller the thickness, the better from the viewpoint of reducing the driving voltage. The thickness of the light-emitting layer 5 is preferably 3 nm or more and more preferably 5 nm or more and is generally preferably 200 nm or less and more preferably 100 nm or less.

The light-emitting layer 5 is formed preferably using the organic electroluminescent element composition in the present embodiment and more preferably by a wet application method.

The above light-emitting layer is formed by the wet application method using the organic electroluminescent element composition in the present embodiment. The light-emitting layer of the organic electroluminescent element may further contain an additional light-emitting material and an additional charge transport material. The additional light-emitting material and the additional charge transport material will next be described in detail.

### (Light-emitting material)

No particular limitation is imposed on the light-emitting material so long as it emits light with a desired emission wavelength and the effects of the invention are not impaired, and any well-known light-emitting material can be used. The light-emitting material may be a fluorescent light-emitting material or a phosphorescent light-emitting material, but is preferably a material having good luminous efficiency and is preferably a phosphorescent light-emitting material in terms of internal quantum efficiency.

Examples of the fluorescent light-emitting material include the following materials.

Examples of the fluorescent light-emitting material that emits blue light (blue fluorescent light-emitting material) include naphthalene, perylene, pyrene, anthracene, coumarin, chrysene, p-bis(2-phenylethenyl)benzene, and derivatives thereof.

Examples of the fluorescent light-emitting material that emits green light (green fluorescent light-emitting material) include quinacridone derivatives, coumarin derivatives, aluminum complexes such as Al(C₉H₆NO)₃.

Examples of the fluorescent light-emitting material that emits yellow light (yellow fluorescent light-emitting material) include rubrene and perimidone derivatives.

Examples of the fluorescent light-emitting material that emits red light (red fluorescent light-emitting material) include DCM (4-(dicyanomethylene)-2-methyl-6-(p-dimethylaminostyryl)-4H-pyran)-based compounds, benzopyran derivatives, rhodamine derivatives, benzothioxanthene derivatives, and azabenzothioxanthene.

Examples of the phosphorescent light-emitting material include organic metal complexes that contain a metal selected from groups 7 to 11 of the long-form periodic table (hereinafter, the term "periodic table" refers to the long-form periodic table unless otherwise specified). Preferred examples of the metal selected from groups 7 to 11 of the periodic table include ruthenium, rhodium, palladium, silver, rhenium, osmium, iridium, platinum, and gold.

The ligand of the organic metal complex is preferably a ligand including a (hetero)aryl group and pyridine, pyrazole, or phenanthroline linked together such as a (hetero)arylpyridine ligand or a (hetero)arylpyrazole ligand and particularly preferably a phenylpyridine ligand or a phenylpyrazole ligand. The (hetero)aryl group represents at least one of an aryl group and a heteroaryl group.

Preferred specific examples of the phosphorescent light-emitting material include: phenylpyridine complexes such as tris(2-phenylpyridine)iridium, tris(2-phenylpyridine)ruthenium, tris(2-phenylpyridine)palladium, bis(2-phenylpyridine)platinum, tris(2-phenylpyridine)osmium, and tris(2-phenylpyridine)rhenium; and porphyrin complexes such as platinum octaethylporphyrin, platinum octaphenylporphyrin, palladium octaethylporphyrin, and palladium octaphenylporphyrin.

Examples of a polymer-based light-emitting material include: polyfluorene-based materials such as poly(9,9-dioctylfluorene-2,7-diyl), poly[(9,9-dioctylfluorene-2,7-diyl)-co-(4,4'-(N-(4-sec-butylphenyl))diphenylamine)], and poly[(9,9-dioctylfluorene-2,7-diyl)-co-(1,4-benzo-2f2,1'-31-triazole)]; and polyphenylenevinylene-based materials such as poly[2-methoxy-5-(2-ethylhexyloxy)-1,4-phenylenevinylene].

### (Charge transport material)

No particular limitation is imposed on the charge transport material so long as it is a material having positive charge (hole) or negative charge (electron) transportability and the effects of the invention are not impaired, and a known material can be used.

The charge transport material used can be, for example, a compound conventionally used for the light-emitting layer 5 of an organic electroluminescent element and is preferably a compound used as a host material of the light-emitting layer 5.

Specific examples of the charge transport material include the compounds shown as the examples of the hole transport compound for the hole injection layer 3 such as aromatic amine-based compounds, phthalocyanine-based compounds, porphyrin-based compounds, oligothiophene-based compounds, polythiophene-based compounds, benzylphenyl-based compounds, compounds including tertiary amines linked via a fluorene group, hydrazone-based compounds, silazane-based compounds, silanamine-based compounds, phosphamine-based compounds, and quinacridone-based compounds. Other examples include electron transport compounds such as anthracene-based compounds, pyrene-based compounds, carbazole-based compounds, pyridine-based compounds, phenanthroline-based compounds, oxadiazole-based compounds, and silole-based compounds.

Other preferred examples of the usable charge transport material include the compounds shown as the examples of the hole transport compound for the hole transport layer 4 such as: aromatic diamines typified by 4,4'-bis[N-(1-naphthyl)-N-phenylamino]biphenyl and containing two or more tertiary amines with two or more condensed aromatic rings substituted on the nitrogen atoms (JP5-234681A); aromatic amine-based compounds having a starburst structure such as 4,4',4''-tris(1-naphthylphenylamino)triphenylamine (J. Lumin., Vol. 72-74, pp. 985, 1997); aromatic amine-based compounds including a tetramer of triphenylamine (Chem. Commun., pp. 2175, 1996); fluorene-based compounds such as 2,2',7,7'-tetrakis-(diphenylamino)-9,9'-spirobifluorene (Synth. Metals, Vol. 91, pp. 209, 1997); and carbazole-based compounds such as 4,4'-N,N'-dicarbazolebiphenyl. Other examples include: oxadiazole-based compounds such as 2-(4-biphenylyl)-5-(p-tert-butylphenyl)-1,3,4-oxadiazole (tBu-PBD) and 2,5-bis(1-naphthyl)-1,3,4-oxadiazole (BND); silole-based compounds such as 2,5-bis(6'-(2',2'-bipyridyl))-1,1-dimethyl-3,4-diphenylsilole (PyPySPyPy); and phenanthroline-based compounds such as bathophenanthroline (BPhen) and 2,9-dimethyl-4,7-diphenyl-1,10-phenanthroline (BCP, bathocuproine).

### (Formation of light-emitting layer 5 by wet deposition method)

Preferably, the organic electroluminescent element in the present embodiment includes a light-emitting layer formed by a wet deposition method using the organic electroluminescent element composition in the present embodiment.

In addition to the light-emitting layer 5 formed using the organic electroluminescent element composition in the present embodiment, another light-emitting layer may be included. These light-emitting layers may be formed using a vacuum vapor deposition method or using a wet deposition method. However, the wet deposition method is preferred because of its good film formability.

When the light-emitting layer 5 is formed by the wet deposition method, the same procedure as that for the formation of the hole injection layer 3 by the wet deposition method is generally performed except that a light-emitting layer-forming composition prepared by mixing materials forming the light-emitting layer 5 and a solvent capable of dissolving these materials (light-emitting layer solvent) is used for the formation instead of the hole injection layer-forming composition.

Examples of the solvent include those shown for the formation of the hole injection layer 3 such as ether-based solvents, ester-based solvents, aromatic hydrocarbon-based solvents, and amide-based solvents. Other examples include alkane-based solvents, halogenated aromatic hydrocarbon-based solvents, aliphatic alcohol-based solvents, alicyclic alcohol-based solvents, aliphatic ketone-based solvents, and alicyclic ketone-based solvents. The solvent used is any of the solvents shown as the examples of the solvent for the organic electroluminescent element composition in the present embodiment. Specific examples of the solvent are shown below, but the solvent is not limited thereto so long as the effects of the invention are not impaired.

Examples of the solvent include: aliphatic ether-based solvents such as ethylene glycol dimethyl ether, ethylene glycol diethyl ether, and propylene glycol-1-monomethyl ether acetate (PGMEA); aromatic ether-based solvents such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic ester-based solvents such as phenyl acetate, phenyl propionate, methyl benzoate, ethyl benzoate, propyl benzoate, and n-butyl benzoate; aromatic hydrocarbon-based solvents such as toluene, xylene, mesitylene, cyclohexylbenzene, tetralin, 3-isopropylbiphenyl, 1,2,3,4-tetramethylbenzene, 1,4-diisopropylbenzene, and methylnaphthalene; amide-based solvents such as N,N-dimethylformamide and N,N-dimethylacetamide; alkane-based solvents such as n-decane, cyclohexane, ethylcyclohexane, decalin, and bicyclohexane; halogenated aromatic hydrocarbon-based solvents such as chlorobenzene, dichlorobenzene, and trichlorobenzene; aliphatic alcohol-based solvents such as butanol and hexanol; alicyclic alcohol-based solvents such as cyclohexanol and cyclooctanol; aliphatic ketone-based solvents such as methyl ethyl ketone and dibutyl ketone; and alicyclic ketone-based solvents such as cyclohexanone, cyclooctanone, and fenchone. Of these, alkane-based solvents and aromatic hydrocarbon-based solvents are particularly preferred.

To obtain a more uniform film, it is preferable that the solvent evaporates from the liquid film immediately after deposition at an appropriate rate. Therefore, the boiling point of the solvent used is generally 80°C or higher, preferably 100°C or higher, and more preferably 120°C or higher and is generally 270°C or lower, preferably 250°C or lower, and more preferably 230°C or lower, as described above.

The amount of the solvent used can be freely set so long as the effect of the invention are not significantly impaired. The larger the total amount of the solvent in the light-emitting layer-forming composition, the better from the viewpoint that the viscosity of the composition is low and the film forming operation can be easily performed. The lower the total amount, the better from the viewpoint that a thick film can be easily formed. As described above, the content of the solvent in the light-emitting layer-forming composition is preferably 1% by mass or more, more preferably 10% by mass or more, and particularly preferably 50% by mass or more and is preferably 99.99% by mass or less, more preferably 99.9% by mass or less, and particularly preferably 99% by mass or less.

To remove the solvent after the wet deposition, heating or decompression may be used. The heating means used for the heating method is preferably a clean oven or a hot plate because heat can be applied uniformly to the film.

The heating temperature in the heating step can be freely set so long as the effect of the invention are not significantly impaired. The higher the temperature, the better from the viewpoint of reducing the drying time. The lower the temperature, the better from the viewpoint that damage to the material is small. The upper limit of the heating temperature is generally 250°C or lower, preferably 200°C or lower, and more preferably 150°C or lower. The lower limit of the heating temperature is generally 30°C or higher, preferably 50°C or higher, and more preferably 80°C or higher. When the heating temperature is equal to or lower than the above upper limit, the temperature is lower than the heat resistant temperature of a commonly used charge transport material or a commonly used phosphorescent light-emitting material, and their decomposition and crystallization can be prevented. When the heating temperature is equal to or higher than the above lower limit, an increase in the time required to remove the solvent can be prevented.

The heating time in the heating step is appropriately determined according to the boiling point and vapor pressure of the solvent in the light-emitting layer-forming composition, the heat resistance of the materials, and the heating conditions.

### (Formation of light-emitting layer 5 by vacuum vapor deposition method)

Generally, when the light-emitting layer 5 is formed by a vacuum vapor deposition method, materials forming the light-emitting layer 5, i.e., one or two or more materials such as the light-emitting material and the charge transport compound, are placed in crucibles disposed in a vacuum container. In this case, when two or more materials are used, they are placed in different crucibles. Then the vacuum container is evacuated to about 10⁻⁴ Pa using a vacuum pump, and the crucibles are heated to evaporate the materials in the crucibles while the evaporation amounts are controlled. Generally, when two or more materials are used, the crucibles are heated to evaporate the materials while the evaporation amounts are controlled independently. Through the above operation, the light-emitting layer 5 is formed on the hole injection layer 3 or the hole transport layer 4 placed so as to face the crucibles. When two or more materials are used, a mixture of the materials may be placed in a crucible, heated, and evaporated to form the light-emitting layer 5.

No limitation is imposed on the degree of vacuum during evaporation so long as the effect of the invention are not significantly impaired. The degree of vacuum is generally 0.1 × 10⁻⁶ Torr (0.13 × 10⁻⁴ Pa) or more and 9.0 × 10⁻⁶ Torr (12.0 × 10⁻⁴ Pa) or less.

No limitation is imposed on the evaporation rate so long as the effect of the invention are not significantly impaired. The evaporation rate is generally 0.1 Å/second or more and 5.0 Å/second or less.

No limitation is imposed on the deposition temperature during evaporation so long as the effect of the invention are not significantly impaired. The deposition temperature is preferably 10°C or higher and 50°C or lower.

### [Hole blocking layer 6]

The hole blocking layer 6 may be disposed between the light-emitting layer 5 and the electron injection layer 8 described later. The hole blocking layer 6 is a layer disposed on the light-emitting layer 5 so as to be in contact with the cathode 9-side interface of the light-emitting layer 5.

The hole blocking layer 6 has the function of preventing holes moving from the anode 2 from reaching the cathode 9 and the function of efficiently transporting electrons injected from the cathode 9 toward the light-emitting layer 5. Examples of the physical properties required for the material forming the hole blocking layer 6 include high electron mobility, low hole mobility, a large energy gap (the difference between the HOMO and LUMO), and a high excited triplet energy level (T1).

Examples of the material of the hole blocking layer 6 that satisfies these requirements include: meatal complexes such as mixed ligand complexes such as bis(2-methyl-8-quinolinolato)(phenolato)aluminum and bis(2-methyl-8-quinolinolato)(triphenylsilanolato)aluminum and binuclear metal complexes such as bis(2-methyl-8-quinolato)aluminum-u-oxo-bis-(2-methyl-8-quinolinolato)aluminum; styryl compounds such as distyrylbiphenyl derivatives (JP11-242996A); triazole derivatives such as 3-(4-biphenylyl)-4-phenyl-5(4-tert-butylphenyl)-1,2,4-triazole (JP7-41759A); and phenanthroline derivatives such as bathocuproine (JP10-79297A). A compound having at least one pyridine ring substituted at the 2-, 4-, and 6-positions and described in WO2005/022962 is also preferred as the material of the hole blocking layer 6.

No limitation is imposed on the method for forming the hole blocking layer 6, and the hole blocking layer 6 can be formed in the same manner as in the method for forming the light-emitting layer 5 described above.

The thickness of the hole blocking layer 6 can be freely set so long as the effect of the invention are not significantly impaired but is generally 0.3 nm or more and preferably 0.5 nm or more and is generally 100 nm or less and preferably 50 nm or less.

### [Electron transport layer 7]

The electron transport layer 7 is disposed between the electron injection layer 8 and the light-emitting layer 5 or the hole blocking layer 6 for the purpose of further improving the current efficiency of the element.

The electron transport layer 7 is formed of a material that can efficiently transport electrons injected from the cathode 9 in the direction toward the light-emitting layer 5 in a region between the electrodes to which an electric field is applied. The electron transport compound used for the electron transport layer 7 must be a compound having high electron injection efficiency from the cathode 9 or the electron injection layer 8, having high electron mobility, and capable of transporting the injected electrons efficiently.

Examples of the electron transport compounds that satisfy these conditions include metal complexes such as an aluminum complex of 8-hydroxyquinoline (JP59-194393A), metal complexes of 10-hydroxybenzo[h]quinoline, oxadiazole derivatives, distyrylbiphenyl derivatives, silole derivatives, 3-hydroxyflavone metal complexes, 5-hydroxyflavone metal complexes, benzoxazole metal complexes, benzothiazole metal complexes, trisbenzimidazolylbenzene (US Patent No. 5645948), quinoxaline compounds (JP6-207169A), phenanthroline derivatives (JP5-331459A), 2-tert-butyl-9,10-N,N'-dicyanoanthraquinonediimine, n-type hydrogenated amorphous silicon carbide, n-type zinc sulfide, and n-type zinc selenide.

The thickness of the electron transport layer 7 is generally 1 nm or more and preferably 5 nm or more and is generally 300 nm or less and preferably 100 nm or less.

The electron transport layer 7 is stacked on the light-emitting layer 5 or the hole blocking layer 6 and formed by the wet deposition method or the vacuum vapor deposition method in the same manner as that for the light-emitting layer 5. Generally, the vacuum vapor deposition method is often used.

### [Electron injection layer 8]

The electron injection layer 8 functions to efficiently inject the electrons injected from the cathode 9 to the electron transport layer 7 or the light-emitting layer 5.

To inject electrons efficiently, it is preferable to use a material having a low work function as the material used to form the electron injection layer 8. Examples of such a material include alkali metals such as sodium and cesium and alkaline-earth metals such as barium and calcium.

The thickness of the electron injection layer 8 is preferably 0.1 to 5 nm.

One effective method for improving the efficiency of the element is to insert a very thin insulating film formed of LiF, MgF₂, Li₂O, Cs₂CO₃, etc. and having a thickness of about 0.1 to about 5 nm as the electron injection layer 8 at the interface between the cathode 9 and the electron transport layer 7 (Appl. Phys. Lett., Vol. 70, pp. 152, 1997; JP10-74586A; IEEE Trans. Electron. Devices, Vol. 44, pp. 1245, 1997; SID 04 Digest, 2004, pp. 154).

It is also preferable to dope an organic electron transport compound typified by a nitrogen-containing heterocyclic compound such as bathophenanthroline or a metal complex such as the aluminum complex of 8-hydroxyquinoline with an alkali metal such as sodium, potassium, cesium, lithium, or rubidium (described in JP10-270171A, JP2002-100478A, JP2002-100482A, etc.) because the election injectability and transportability are improved and also good film quality can be achieved. The film thickness in this case is generally 5 nm or more and preferably 10 nm or more and is generally 200 nm or less and preferably 100 nm or less.

The electron injection layer 8 is stacked on the light-emitting layer 5 or on the hole blocking layer 6 or the electron transport layer 7 on the light-emitting layer 5 and formed by the wet deposition method or the vacuum vapor deposition method in the same manner as that for the light-emitting layer 5.

The details of the wet deposition method are the same as those for the light-emitting layer 5 described above.

### [Cathode 9]

The cathode 9 functions to inject electrons into a layer on the light-emitting layer 5 side such as the electron injection layer 8 or the light-emitting layer 5. Any material used for the anode 2 can be used as the material of the cathode 9. To inject electrons efficiently, the material of the cathode 9 is preferably a metal having a low work function. For example, a metal such as tin, magnesium, indium, calcium, aluminum, or silver or an alloy thereof is used. Examples of the material of the cathode 9 include electrodes of low-work function alloys such as magnesium-silver alloys, magnesium-indium alloys, and aluminum-lithium alloys.

In terms of the stability of the element, it is preferable to stack a high-work function metal layer stable to air on the cathode 9 to protect the cathode 9 formed of the low-work function metal. Examples of the stacked metal include metals such as aluminum, silver, copper, nickel, chromium, gold, and platinum.

The thickness of the cathode is generally the same as that of the anode 2.

### [Additional constituent layers]

The element having the layer structure shown in Fig. 1 has been mainly described. An optional layer other than the layers described above may be disposed between the anode 2 and the light-emitting layer 5 or between the cathode 9 and the light-emitting layer 5 in the organic electroluminescent element in the present embodiment so long as the performance of the element is not impaired. Any layer other than the light-emitting layer 5 may be omitted.

For example, it is effective to dispose an electron blocking layer between the hole transport layer 4 and the light-emitting layer 5 for the same purpose as that of the hole blocking layer 6. The electron blocking layer has the function of preventing the electrons migrating from the light-emitting layer 5 from reaching the hole transport layer 4 so that the probability of recombination of electrons and holes in the light-emitting layer 5 is increased and that the generated excitons are confined in the light-emitting layer 5 and also has the function of efficiently transporting the holes injected from the hole transport layer 4 in the direction toward the light-emitting layer 5.

The characteristics required for the electron blocking layer include high hole transportability, a large energy gap, i.e., a large HOMO-LUMO difference, and a high excited triplet level (T1).

When the light-emitting layer 5 is formed by the wet deposition method, it is preferable to form the electron blocking layer by the wet deposition method, because the element can be produced easily.

Therefore, it is preferable that the electron blocking layer has suitability for wet deposition, and examples of the material used for the electron blocking layer include copolymers of dioctylfluorene and triphenylamine typified by F8-TFB (WO2004/084260).

A structure stacked in reverse order to that in Fig. 1 may be used. Specifically, the cathode 9, the electron injection layer 8, the electron transport layer 7, the hole blocking layer 6, the light-emitting layer 5, the hole transport layer 4, the hole injection layer 3, and the anode 2 may be stacked in this order on the substrate 1. The organic electroluminescent element in the present embodiment may be disposed between two substrates, at least one of which is highly transparent.

A structure including a plurality of layer structures shown in Fig. 1 stacked one on another, i.e., a structure including a plurality of light-emitting units stacked one on another, may be used. In this case, from the viewpoint of the luminous efficiency and driving voltage, it is more preferable to use V₂O₅, for example, as a charge generation layer between the light-emitting units, i.e., instead of as interface layers between the units because the barrier between the units is reduced. When the anode is ITO and the cathode is Al, the interface layers are these two layers.

The invention is applicable to a single organic electroluminescent element, an element including organic electroluminescent elements arranged in an array, and a structure in which anodes and cathodes are arranged in an X-Y matrix.

### [Display device and lighting device]

The organic electroluminescent element of the invention described above can be used to prepare a display device and a lighting device. No particular limitation is imposed on the types and structures of display devices and lighting devices using the organic electroluminescent element of the invention. They can be assembled by an ordinary method using the organic electroluminescent element of the invention.

The display device and the lighting device can be formed using, for example, a method described in "Yuki EL Disupurei (Organic EL Display)" (Ohmsha, Ltd. published on August 20, Heisei 16, written by TOKITO Shizuo, ADACHI Chihaya, and MURATA Hideyuki).

### EXAMPLES

The present invention will next be specifically described by way of Examples. However, the invention is not limited to the following Examples and can be embodied in various forms within the spirit of the invention.

In the following Synthesis Examples, all the reactions were performed in a nitrogen flow. Solvents and solutions used for the reactions had been degassed by an appropriate method such as nitrogen bubbling.

### [Synthesis of iridium complex compounds]

### <Synthesis Example 1: synthesis of compound (D-1)>

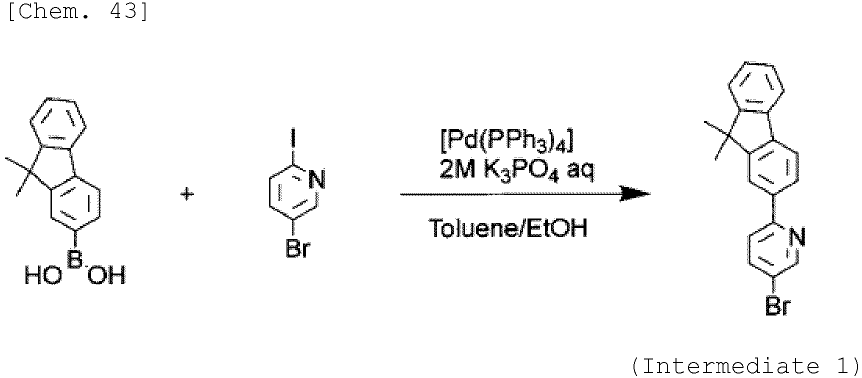

A 1 L round bottom flask was charged with 9,9-dimethylfluorene-2-boronic acid (manufactured by Tokyo Chemical Industry Co., Ltd., 26.04 g), 5-bromo-2-iodopyridine (manufactured by FUJIFILM Wako Pure Chemical Corporation, 34.61 g), tetrakis(triphenylphosphine)palladium(0) (5.20 g), a 2M aqueous tripotassium phosphate solution (120 mL), toluene (200 mL), and ethanol (100 mL), and the mixture was stirred at reflux for 8 hours. The resulting mixture was cooled to room temperature, and the aqueous phase was removed. The solvents were removed under reduced pressure, and the residue obtained was purified by silica gel column chromatography (dichloromethane / hexane = 1 / 1) to thereby obtain 37.58 g of intermediate 1 as an orange-brown solid.

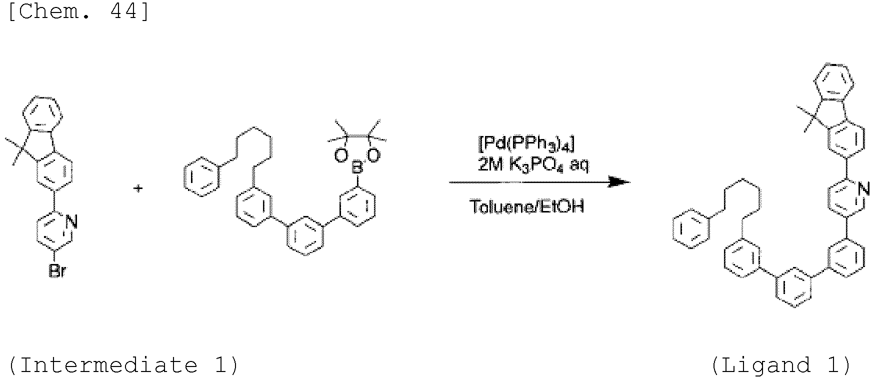

A 1 L round bottom flask was charged with intermediate 1 (17.75 g), 4,4,5,5-tetramethyl-2-[3''-(6-phenylhexyl)[1,1':3',1"-terphenyl]-3-yl]-1,3,2-dioxaborolane (synthesized by a method described in WO2016/194784, 27.70 g), tetrakis(triphenylphosphine)palladium(0) (1.16 g), a 2M aqueous tripotassium phosphate solution (70 mL), toluene (160 mL), and ethanol (80 mL), and the mixture was stirred at reflux for 6.5 hours. The mixture was cooled to room temperature, and the aqueous phase was removed. The solvents were removed under reduced pressure, and the residue obtained was purified by silica gel column chromatography (dichloromethane / hexane = 1 / 1) to thereby obtain 27.03 g of ligand 1 in a colorless amorphous form.

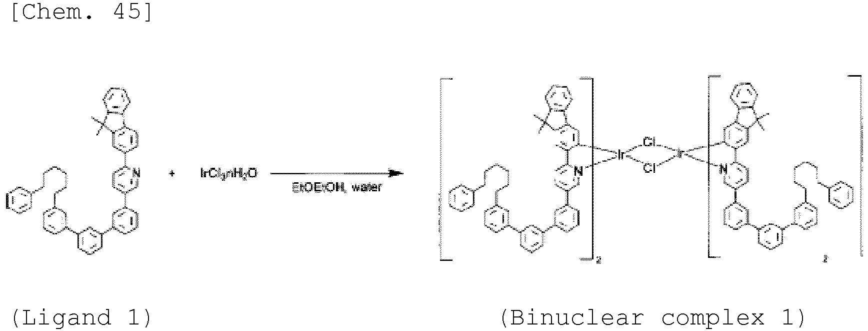

A 1 L round bottom flask equipped with a Dimroth condenser having a side tube was charged with ligand 1 (25.89 g), iridium chloride (iridium complex compound-containing composition) n-hydrate (manufactured by Furuya Metal Co., Ltd., 6.80 g), water (40 mL), and 2-ethoxyethanol (260 mL), and the mixture was stirred in an oil bath at 135°C for 4.5 hour while the solvents were distilled off and was then stirred at 145°C for 1.5 hours. 2-Ethoxyethanol (70 mL) was added, and the resulting mixture was stirred for 3.5 hours. The volume of the liquid removed by distillation from the side tube during the reaction was 164 mL. After the mixture was cooled to room temperature, the solvent was removed under reduced pressure, and the residue obtained was purified by silica gel column chromatography (dichloromethane / hexane = 1 / 1) to thereby obtain 26.95 g of binuclear complex 1 in a bright yellow amorphous form.

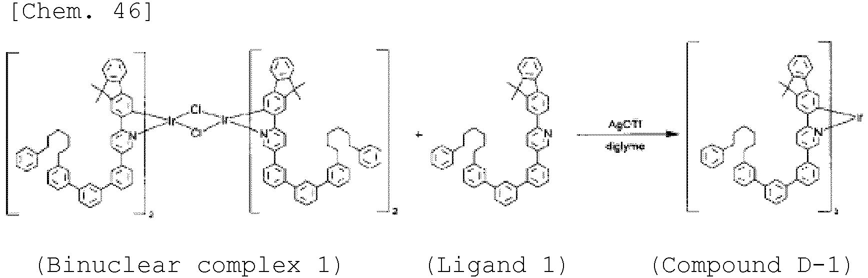

A 300 mL round bottom flask was charged with binuclear complex 1 (26.44 g), ligand 1 (25.74 g), and diglyme (125 mL), and the mixture was stirred in an oil bath at 150°C until dissolution. Then silver(I) trifluoromethanesulfonate (5.28 g) was added, and the resulting mixture was stirred for 7 hours. Then the solvent was removed under reduced pressure, and the residue obtained was purified by silica gel column chromatography (dichloromethane / hexane = 1 / 1) to thereby obtain 29.72 g of compound (D-1) as an orange-yellow solid.

### <Synthesis Example 2: synthesis of compound (D-2)>

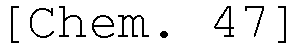

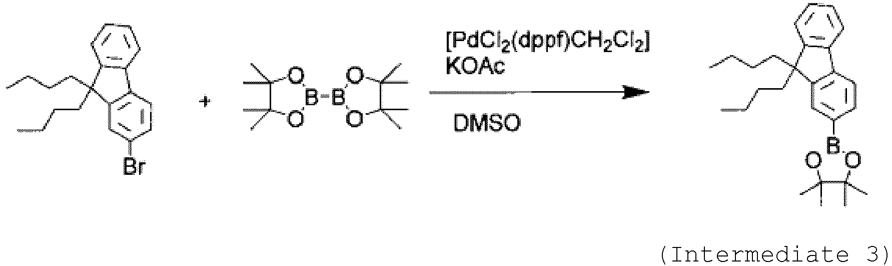

A 300 mL round bottom flask was charged with 2-bromo-9,9-di-n-butylfluorene (manufactured by Tokyo Chemical Industry Co., Ltd., 10.30 g), bispinacolato diboron (8.35 g), potassium acetate (8.89 g), [Pd(dppf)₂Cl₂]CH₂Cl₂ (0.78 g), and dimethyl sulfoxide (80 mL), and the mixture was stirred in an oil bath at 90°C for 6 hours. The mixture was cooled to room temperature and separated by adding water (0.3 L) and dichloromethane (0.15 L). After washing with saturated brine (50 mL) and drying over magnesium sulfate, filtration was performed. The solvents were removed from the filtrate under reduced pressure, and the residue obtained was purified by silica gel column chromatography (ethyl acetate / hexane = 2 / 8) to thereby obtain intermediate 3 (11.91 g, containing 5.5% by weight of hexane, which was checked by ¹H-NMR) as a yellow oily substance.

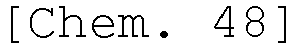

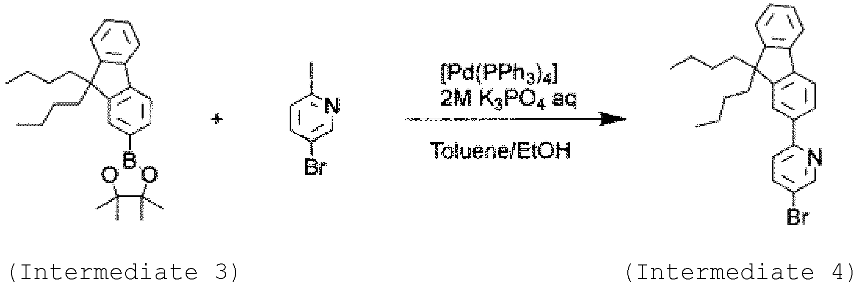

A 1 L round bottom flask was charged with intermediate 3 (11.91 g, containing 5.5% by weight of hexane), 5-bromo-2-iodopyridine (8.80 g), tetrakis(triphenylphosphine)palladium(0) (1.14 g), a 2M aqueous tripotassium phosphate solution (30 mL), toluene (70 mL), and ethanol (40 mL), and the mixture was stirred at reflux for 18 hours. The mixture was cooled to room temperature, and the aqueous phase was removed. The solvents were removed under reduced pressure, and the residue obtained was purified by silica gel column chromatography (dichloromethane / hexane = 1 / 1) to thereby obtain 10.37 g of intermediate 4 as a white solid.

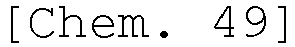

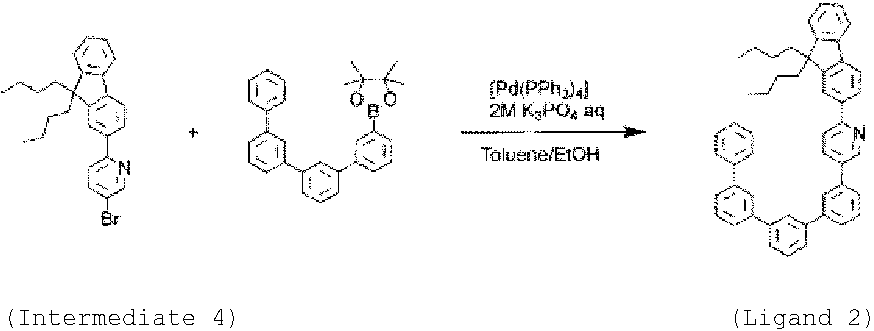

A 1 L round bottom flask was charged with intermediate 4 (10.37 g), 4,4,5,5-tetramethyl-2-[1,1':3',1":3",1‴-quaterphenyl]-3-yl-1,3,2-dioxaborolane (synthesized by a method described in WO2016/194784A1, 10.95 g), tetrakis(triphenylphosphine)palladium(0) (1.18 g), a 2M aqueous tripotassium phosphate solution (25 mL), toluene (65 mL), and ethanol (35 mL), and the mixture was stirred at reflux for 8 hours. The mixture was cooled to room temperature, and the aqueous phase was removed. The solvents were removed under reduced pressure, and the residue obtained was purified by silica gel column chromatography (dichloromethane / hexane = 4 / 6) to thereby obtain 15.79 g of ligand 2 in a light yellow amorphous form.

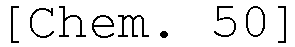

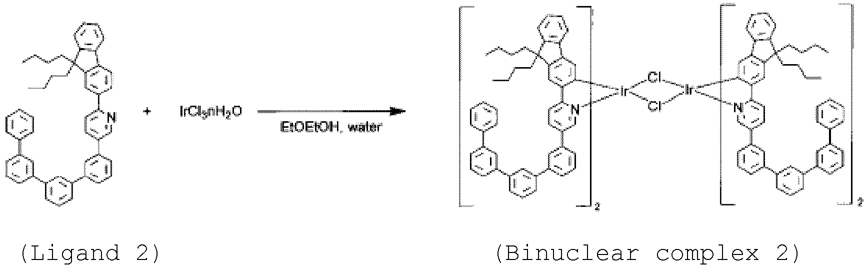

A 200 mL round bottom flask equipped with a Dimroth condenser having a side tube was charged with ligand 2 (9.43 g), iridium chloride (iridium complex compound-containing composition) n-hydrate (2.30 g), water (20 mL), and 2-ethoxyethanol (80 mL), and the mixture was stirred in an oil bath at 145°C for 4 hours while the solvents were distilled off. 2-Ethoxyethanol (70 mL) was added, and the resulting mixture was stirred at 150°C for 6 hours. The volume of the liquid removed by distillation from the side tube during the reaction was 100 mL. After the mixture was cooled to room temperature, the solvent was removed under reduced pressure, and the residue obtained was purified by silica gel column chromatography (dichloromethane / hexane = 1 / 1) to thereby obtain 9.66 g of binuclear complex 2 as a red-orange solid.

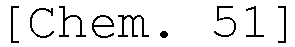

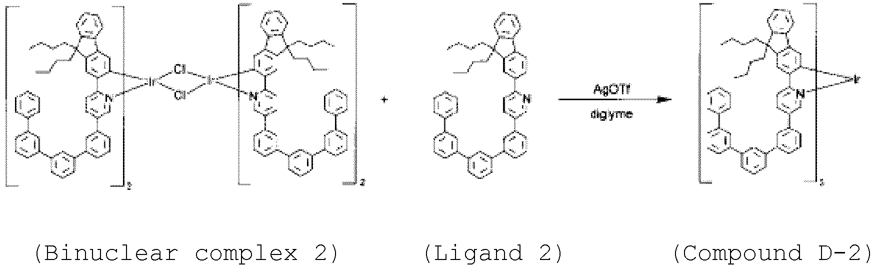

A 300 mL round bottom flask was charged with binuclear complex 2 (9.05 g), ligand 2 (5.97 g), and diglyme (25 mL), and the mixture was stirred in an oil bath at 150°C until dissolution. Then silver(I) trifluoromethanesulfonate (1.50 g) was added, and the mixture was stirred for 1 hour and further stirred at 160°C for 1.5 hours. Then the solvent was removed under reduced pressure, and the residue obtained was purified by silica gel column chromatography (dichloromethane / hexane = 1 / 1) to thereby obtain 1.23 g of compound (D-2) as an orange-yellow solid.

### <Synthesis Example 3: synthesis of compound (D-3)>

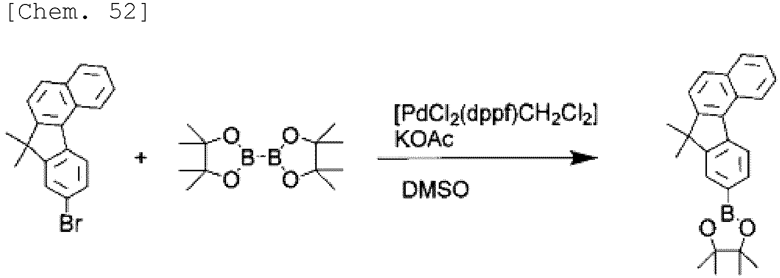

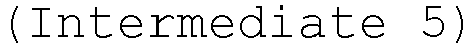

A 100 mL round bottom flask was charged with 9-bromo-7,7-dimethyl-7H-benzo[c]fluorene (manufactured by Tokyo Chemical Industry Co., Ltd., 4.74 g), bispinacolato diboron (4.31 g), potassium acetate (4.32 g), [Pd(dppf)₂Cl₂]CH₂Cl₂ (0.38 g), and dimethyl sulfoxide (45 mL), and the mixture was stirred in an oil bath at 90°C for 8 hours. The mixture was cooled to room temperature, and then water (0.5 L) and dichloromethane (0.10 L × 3) were added for separation and extraction. The combined oil phase was dried over magnesium sulfate and filtered. The solvents were removed from the filtrate under reduced pressure, and the residue obtained was purified by silica gel column chromatography (ethyl acetate / hexane = 15 / 85) to thereby obtain intermediate 5 (4.59 g) in a white amorphous form.

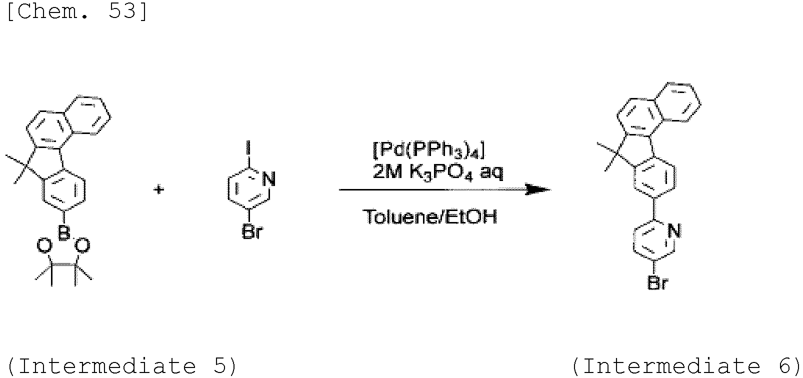

A 500 mL round bottom flask was charged with intermediate 5 (4.59 g), 5-bromo-2-iodopyridine (3.71 g), tetrakis(triphenylphosphine)palladium(0) (0.43 g), a 2M aqueous tripotassium phosphate solution (20 mL), toluene (30 mL), and ethanol (15 mL), and the mixture was stirred at reflux for 17 hours. The mixture was cooled to room temperature, and the aqueous phase was removed. The solvents were removed under reduced pressure, and the residue obtained was purified by silica gel column chromatography (dichloromethane / hexane = 1 / 1) to thereby obtain 4.71 g of intermediate 6 as a white solid.

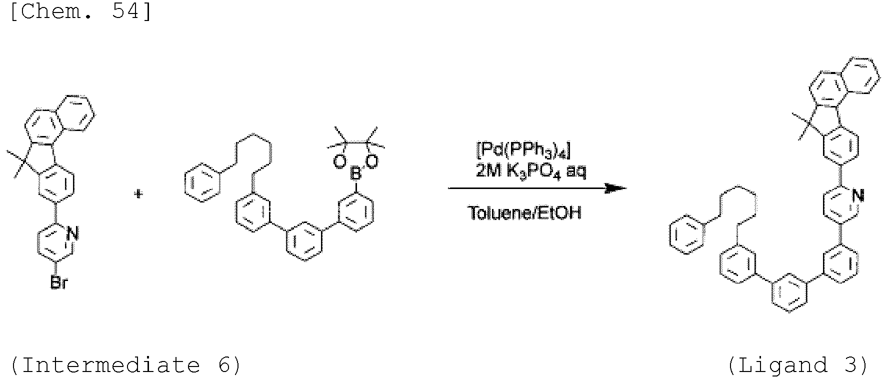

A 1 L round bottom flask was charged with intermediate 6 (4.70 g), 4,4,5,5-tetramethyl-2-[3''-(6-phenylhexyl)[1,1':3',1"-terphenyl]-3-yl]-1,3,2-dioxaborolane (synthesized using a method described in WO2016/194784A1, 6.59 g), tetrakis(triphenylphosphine)palladium(0) (0.32 g), a 2M aqueous tripotassium phosphate solution (20 mL), toluene (40 mL), and ethanol (20 mL), and the mixture was stirred at reflux for 9.5 hours. The mixture was cooled to room temperature, and the aqueous phase was removed. The solvents were removed under reduced pressure, and the residue obtained was purified by silica gel column chromatography (dichloromethane / hexane = 4 / 6) to thereby obtain 6.37 g of ligand 3 in a colorless amorphous form.

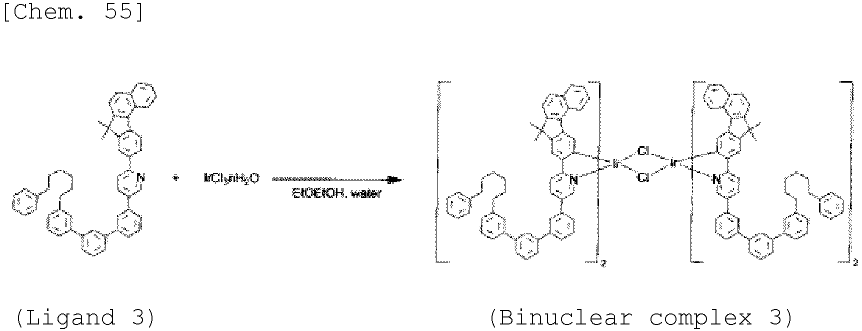

A 100 mL round bottom flask equipped with a Dimroth condenser having a side tube was charged with ligand 3 (3.62 g), iridium chloride (iridium complex compound-containing composition) n-hydrate (0.85 g), water (10 mL), and 2-ethoxyethanol (50 mL), and the mixture was stirred in an oil bath at 145°C for 2 hours while the solvents were distilled off. 2-Ethoxyethanol (30 mL) was added, and the resulting mixture was stirred for 6 hours. The volume of the liquid removed by distillation from the side tube during the reaction was 55 mL. After the mixture was cooled to room temperature, the solvent was removed under reduced pressure, and the residue obtained was purified by silica gel column chromatography (dichloromethane) to thereby obtain 4.14 g of red solids containing binuclear complex 3. The product was not further purified and was used for the next reaction.

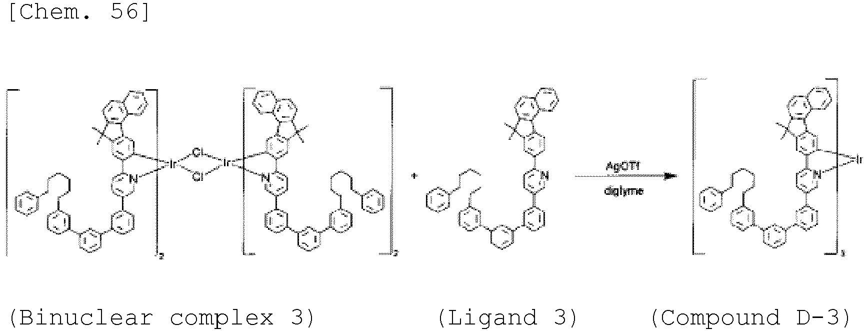

A 300 mL round bottom flask was charged with the red solids (4.14 g) obtained through the reaction in the previous step and containing binuclear complex 3, ligand 3 (2.75 g), and diglyme (15 mL), and the mixture was stirred in an oil bath at 150°C until dissolution. Then silver(I) trifluoromethanesulfonate (1.11 g) was added, and the resulting mixture was stirred at 160°C for 4 hours. Then the solvent was removed under reduced pressure, and the residue obtained was purified by silica gel column chromatography (dichloromethane / hexane = 1 / 1) to thereby obtain 3.24 g of compound (D-3) as a red solid.

### <Synthesis Example 4: synthesis of compound (D-4)>

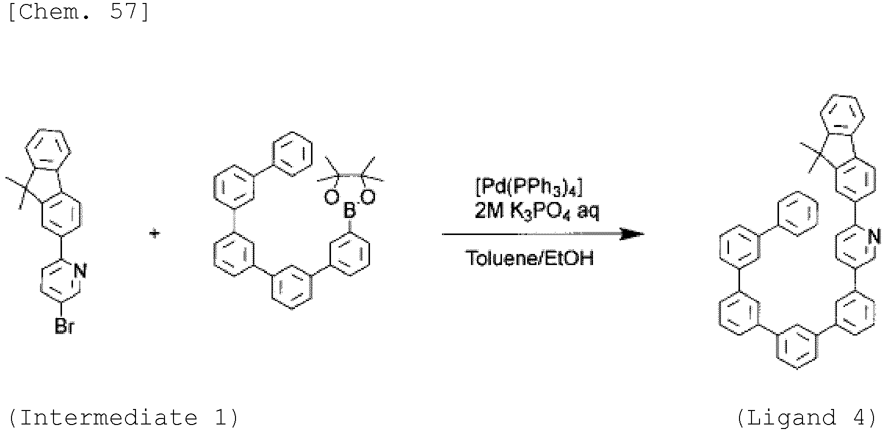

A 1 L round bottom flask was charged with intermediate 1 (7.32 g), 4,4,5,5-tetramethyl-2-[1,1':3',1":3",1‴,3‴:1ʺʺ-quinquephenyl]-3-yl-1,3,2-dioxaborolane (synthesized using a method described in US2017/0104163A1, 11.81 g), tetrakis(triphenylphosphine)palladium(0) (0.71 g), a 2M aqueous tripotassium phosphate solution (30 mL), toluene (65 mL), and ethanol (35 mL), and the mixture was stirred at reflux for 6 hours. The mixture was cooled to room temperature, and the aqueous phase was removed. The solvents were removed under reduced pressure, and the residue obtained was purified by silica gel column chromatography (dichloromethane) to thereby obtain 9.76 g of ligand 4 in a colorless amorphous form.

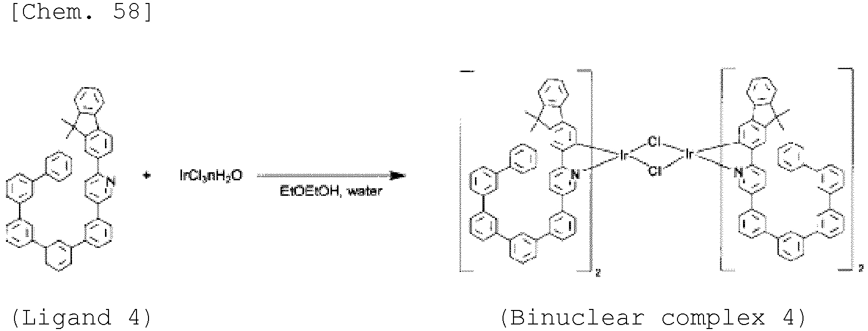

A 100 mL round bottom flask equipped with a Dimroth condenser having a side tube was charged with ligand 4 (5.77 g), iridium chloride (iridium complex compound-containing composition) n-hydrate (1.49 g), water (15 mL), and 2-ethoxyethanol (60 mL), and the mixture was stirred in an oil bath at 145°C for 7 hours while the solvents were distilled off. The volume of the liquid removed by distillation from the side tube during the reaction was 45 mL. After the mixture was cooled to room temperature, the solvents were removed under reduced pressure, and the residue obtained was purified by silica gel column chromatography (dichloromethane) to thereby obtain 7.43 g of red-orange solids containing binuclear complex 4. The product was not further purified and was used for the next reaction.

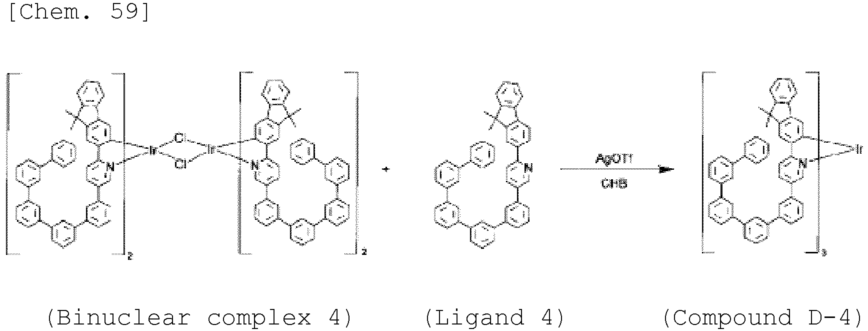

A 100 mL round bottom flask was charged with the red-orange solids (7.43 g) obtained through the reaction in the previous step and containing binuclear complex 4, ligand 4 (3.99 g), and diglyme (20 mL), and the mixture was stirred in an oil bath at 160°C until dissolution. Then silver(I) trifluoromethanesulfonate (1.22 g) was added, and the resulting mixture was further stirred at 160°C for 2.5 hours. Then the solvent was removed under reduced pressure, and the residue obtained was purified by silica gel column chromatography (dichloromethane / hexane = 1 / 1) to thereby obtain 5.42 g of compound (D-4) as an orange solid.

<Synthesis Example 5: synthesis of compound (D-5)>

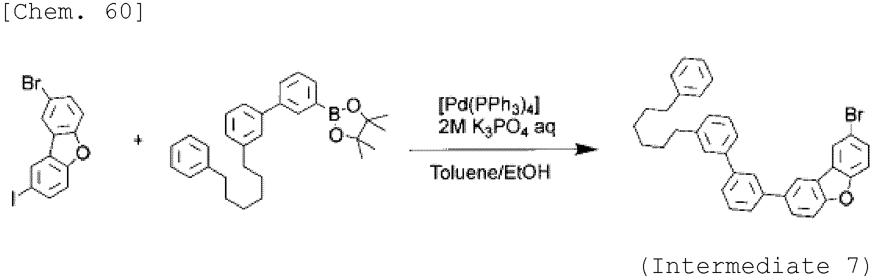

A 0.2 L round bottom flask was charged with 2-bromo-8-iododibenzofuran (manufactured by Tokyo Chemical Industry Co., Ltd., 4.97 g), 4,4,5,5-tetramethyl-2-[3''-(6-phenylhexyl)[1,1':3',1"-terphenyl]-3-yl]-1,3,2-dioxaborolane (synthesized using a method described in WO2016/194784A1, 6.58 g), tetrakis(triphenylphosphine)palladium(0) (0.174 g), dichlorobis(triphenylphosphine)palladium(II) (0.174 g), a 2M aqueous tripotassium phosphate solution (19 mL), toluene (40 mL), and ethanol (20 mL), and the mixture was stirred in an oil bath at 90°C for 5.5 hours. The mixture was cooled to room temperature, and the aqueous phase was removed. The solvents were removed under reduced pressure, and the residue obtained was purified by silica gel column chromatography (dichloromethane / hexane = 2 / 8 to 1 / 1) to thereby obtain 3.67 of intermediate 7 as a white solid.

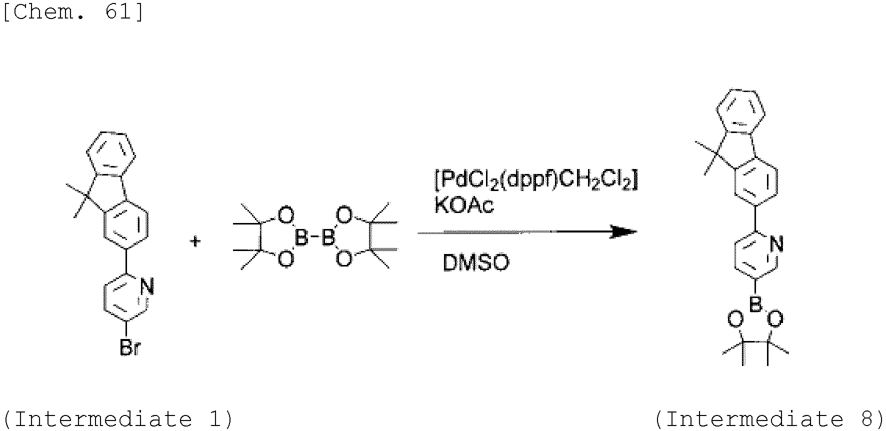

A 200 mL round bottom flask was charged with intermediate 1 (12.50 g), bispinacolato diboron (10.74 g), potassium acetate (10.80 g), [Pd(dppf)₂Cl₂]CH₂Cl₂ (1.04 g), and dimethyl sulfoxide (100 mL), and the mixture was stirred in an oil bath at 90°C for 5 hours. The mixture was cooled to room temperature and separated by adding water (0.4 L) and dichloromethane (0.4 L). After drying over magnesium sulfate, filtration was performed. The solvents were removed from the filtrate under reduced pressure, and the residue obtained was purified by silica gel column chromatography (ethyl acetate / hexane = 2 / 8) to thereby obtain intermediate 8 (10.46 g) as a light pink solid.

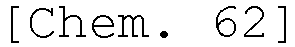

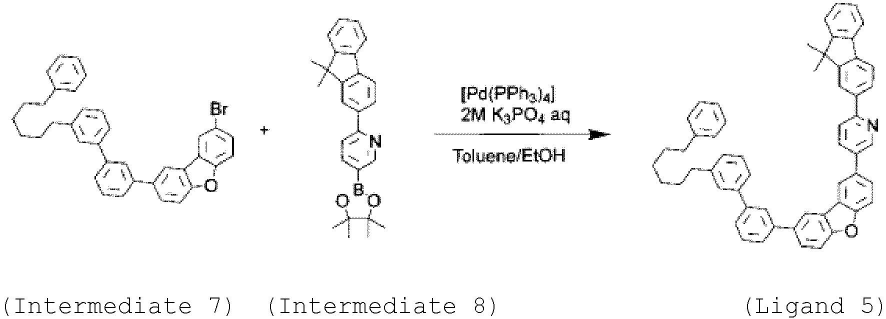

A 500 mL round bottom flask was charged with intermediate 7 (3.67 g), intermediate 8 (2.86 g), tetrakis(triphenylphosphine)palladium(0) (0.215 g), a 2M aqueous tripotassium phosphate solution (9 mL), toluene (20 mL), and ethanol (10 mL), and the mixture was stirred at reflux for 2.5 hours. The mixture was cooled to room temperature, and the aqueous phase was removed. The solvents were removed under reduced pressure, and the residue obtained was purified by silica gel column chromatography (dichloromethane / hexane = 1 / 1 to 8 / 2) to thereby obtain 3.93 g of ligand 5 as a white solid.

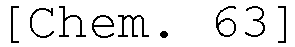

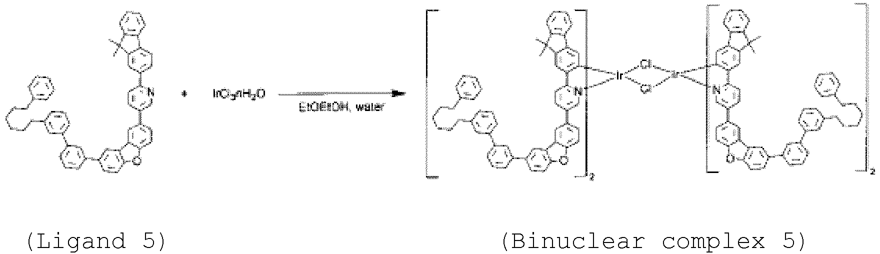

A 100 mL round bottom flask equipped with a Dimroth condenser having a side tube was charged with ligand 5 (1.99 g), iridium chloride(III) n-hydrate (0.47 g), water (3 mL), and 2-ethoxyethanol (20 mL), and the mixture was stirred in an oil bath for 12.5 hours while the solvents were distilled off. During the stirring, the temperature of the oil bath was increased from 125°C to 150°C. During the reaction, 2-ethoxyethanol was added in portions (the total amount added was 40 mL), and the total volume of the liquid removed by distillation from the side tube was 33 mL. After the mixture was cooled to room temperature, the solvents were removed under reduced pressure, and the residue obtained was purified by silica gel column chromatography (dichloromethane / hexane = 1 / 1 to 8 / 2) to thereby obtain 1.96 g of orange solids containing binuclear complex 5. The product was not further purified and was used for the next reaction.

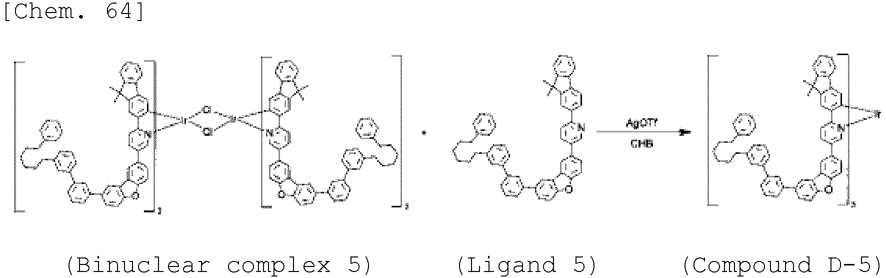

A 100 mL round bottom flask was charged with the orange solids (1.66 g) obtained through the reaction in the previous step and containing binuclear complex 5, ligand 5 (1.44 g), and diglyme (7.5 mL), and the mixture was stirred at room temperature until dissolution. Then silver(I) trifluoromethanesulfonate (0.30 g) was added, and the resulting mixture was placed in an oil bath. The temperature of the oil bath was increased to 150°C, and the mixture was stirred for 8 hours. Two hours after the start of the reaction, 2,6-lutidine (0.5 mL) was added. After completion of the reaction, the solvent was removed under reduced pressure, and the residue obtained was purified by silica gel column chromatography (dichloromethane / hexane = 45 / 55 to 6 / 4) to thereby obtain 1.46 g of compound (D-5) as an orange solid.

### <Synthesis Example 6: synthesis of compound (D-6)>

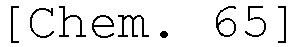

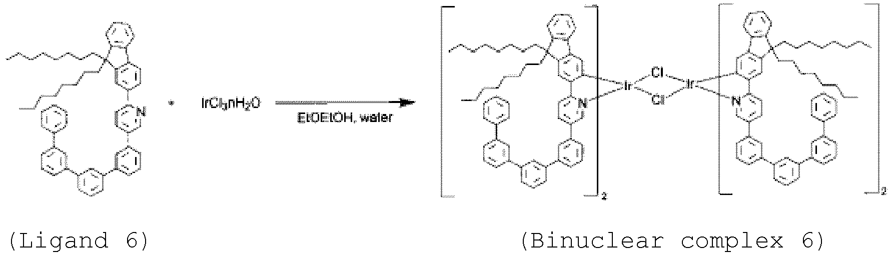

A 200 mL round bottom flask equipped with a Dimroth condenser having a side tube was charged with ligand 6 (synthesized according to the synthesis conditions for Ligand 4, 9.98 g), iridium chloride(III) n-hydrate (2.23 g), water (20 mL), and 2-ethoxyethanol (80 mL), and the mixture was stirred for 6 hours while the solvents were distilled off. During the stirring, the temperature of the oil bath was increased from 145°C to 150°C. During the reaction, 2-ethoxyethanol was added in portions (the total amount added was 50 mL), and the total volume of the liquid removed by distillation from the side tube was 90 mL. After the mixture was cooled to room temperature, the solvents were removed under reduced pressure, and the residue obtained was purified by silica gel column chromatography (dichloromethane / hexane = 1 / 1) to thereby obtain 10.36 g of red-orange solids containing binuclear complex 6. The product was not further refined and was used for the next reaction.

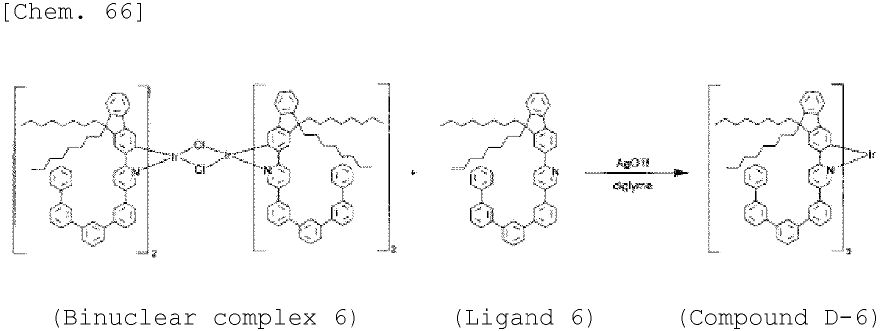

A 100 mL round bottom flask was charged with the orange solids (10.05 g) obtained through the reaction in the previous step and containing binuclear complex 6, ligand 6 (8.65 g), and diglyme (45 mL) and placed in an oil bath. After the temperature of the oil bath was increased to 150°C, silver(I) trifluoromethanesulfonate (1.53 g) was added, and the mixture was stirred for 8 hours. 4.5 Hours after the start of the reaction, 2,6-lutidine (1.0 mL) was added. After completion of the reaction, the solvent was removed under reduced pressure, and the residue obtained was purified by silica gel column chromatography (dichloromethane / hexane = 1 / 1) to thereby obtain 11.44 g of compound (D-6) as an orange solid.

### <Synthesis Example 7: synthesis of compound (D-7)>

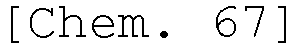

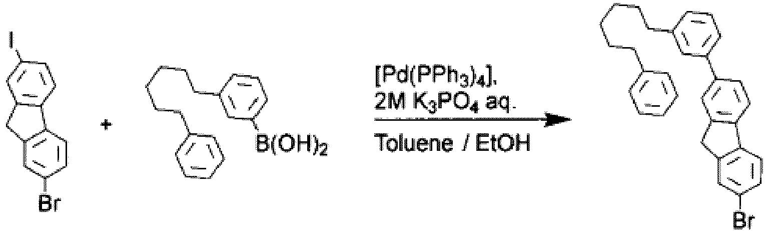

A 1 L round bottom flask was charged with 2-bromo-7-iodofluorene (46.30 g), 3-(6-phenyl-n-hexyl)phenylboronic acid (35.50 g), tetrakis(triphenylphosphine)palladium(0) (5.40 g), a 2M aqueous tripotassium phosphate solution (150 mL), toluene (300 mL), and ethanol (100 mL), and the mixture was stirred at reflux for 3 hours. The mixture was cooled to room temperature, and the aqueous phase was removed. The solvents were removed under reduced pressure, and the residue obtained was purified by silica gel column chromatography (dichloromethane / hexane = 15 / 85 to 2 / 8) to thereby obtain 51.34 g of 2-bromo-7-{3-(6-phenyl-n-hexyl)}phenylfluorene as a white solid.

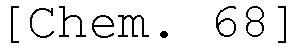

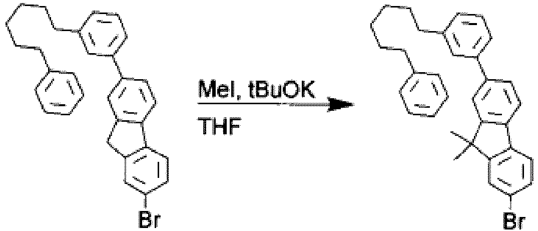

A 500 mL round bottom flask was charged with 2-bromo-7-{3-(6-phenyl-n-hexyl)}phenylfluorene (23.70 g) and tetrahydrofuran (200 mL), and potassium tert-butoxide (16.65 g) was gradually added to the prepared solution. The color of the solution was changed to a dark orange color. The resulting solution was placed in an ice-water bath, and methyl iodide (9.2 mL) was added dropwise from a syringe over 8 minutes. Then the reaction solution turned into an ocher slurry. The slurry was stirred for 2 hours, and water (70 mL) was added. The mixture was concentrated under reduced pressure, and the residue obtained was separated and extracted with water (80 mL), 1N-hydrochloric acid (10 mL), saturated brine (50 mL), and dichloromethane (400 mL). The oil phase was dried over sodium sulfate, filtered, and concentrated under reduced pressure. The residue obtained was purified by silica gel chromatography (dichloromethane / hexane = 1 / 9 to 4 / 6) to thereby obtain 22.50 g of 2-bromo-9,9-dimethyl-7-{3-(6-phenyl-n-hexyl)}phenylfluorene as a light yellow oily substance.

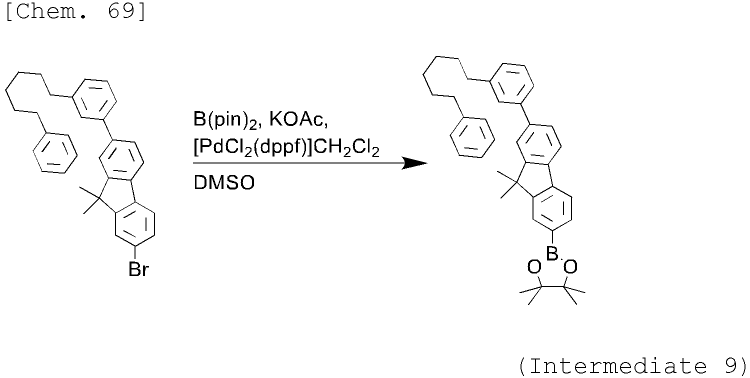

A 500 mL round bottom flask was charged with 2-bromo-7-{3-(6-phenyl-n-hexyl) }phenylfluorene (22.50 g), bispinacolato diboron (12.33 g), potassium acetate (13.05 g), [Pd(dppf)₂Cl₂]CH₂Cl₂ (1.08 g), and dimethyl sulfoxide (350 mL), and the mixture was stirred in an oil bath at 90°C for 4 hours. The mixture was cooled to room temperature, and then water (0.3 L) and dichloromethane (0.2 L × 2, 0.1 L × 1) were added for separation and extraction. The combined oil phase was dried over magnesium sulfate and filtered. The solvents were removed from the filtrate under reduced pressure, and the residue obtained was purified by silica gel column chromatography (ethyl acetate / hexane = 5 / 95 to 1 / 1) to thereby obtain intermediate 9 (23.45 g) as a light yellow oily substance.

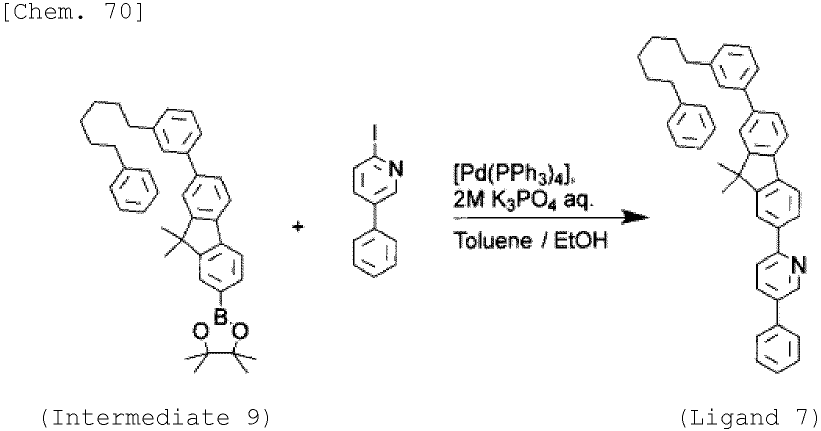

A 1 L round bottom flask was charged with intermediate 9 (7.45 g), 2-iodo-5-phenylpyridine (4.06 g), tetrakis(triphenylphosphine)palladium(0) (0.31 g), a 2M aqueous tripotassium phosphate solution (16 mL), toluene (40 mL), and ethanol (20 mL), and the mixture was stirred at reflux for 3 hours. After the mixture was cooled to room temperature, tetrakis(triphenylphosphine)palladium(0) (0.13 g) was added, and the resulting mixture was again stirred at reflux for 3.5 hours. The mixture was cooled to room temperature, and the aqueous phase was removed. The solvents were removed under reduced pressure, and the residue obtained was purified by silica gel column chromatography (dichloromethane / hexane = 4 / 96 to 1 / 1) to thereby obtain 5.42 g of ligand 7 as a light yellow solid.

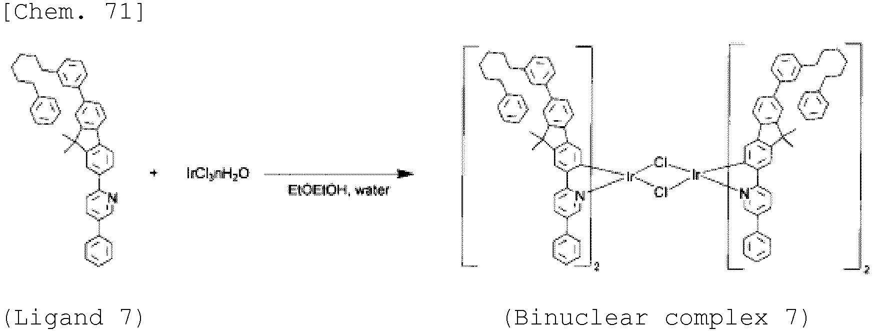

A 200 mL round bottom flask equipped with a Dimroth condenser having a side tube was charged with ligand 7 (1.66 g), iridium chloride(III) n-hydrate (0.51 g), water (2.5 mL), and 2-ethoxyethanol (20 mL), and the mixture was stirred in an oil bath at 145°C for 5 hours while the solvents were distilled off. The volume of the liquid removed by distillation from the side tube during the reaction was 3 mL. After the mixture was cooled to room temperature, the solvents were removed under reduced pressure, and the residue obtained was purified by silica gel column chromatography (dichloromethane) to thereby obtain 1.9 g of binuclear complex 7 as an orange solid.

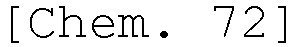

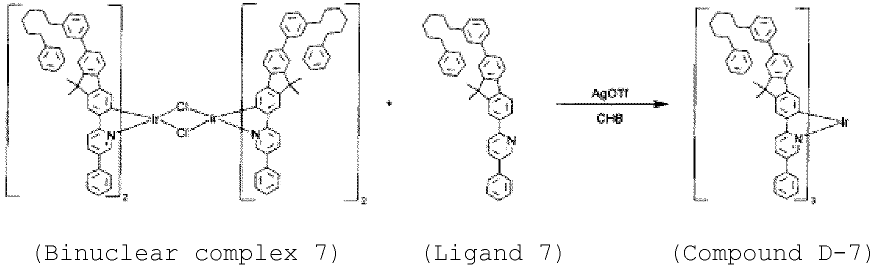

A 100 mL round bottom flask was charged with binuclear complex 7 (1.9 g), ligand 7 (1.40 g), and diglyme (40 mL), and the mixture was stirred in an oil bath at 180°C until dissolution and then cooled to 150°C. Silver(I) trifluoromethanesulfonate (0.43 g) was added, and the resulting mixture was stirred for 2 hours and 40 minutes. Then 2,6-lutidine (0.3 mL) was added, and the resulting mixture was stirred for 2 hours. After cooling, the solvent was removed under reduced pressure, and the residue obtained was purified by silica gel column chromatography (dichloromethane / hexane = 7 / 3) to thereby obtain 1.61 g of compound (D-7) as a red-orange solid.

### [Example 1]

An organic electroluminescent element was produced by the following method.

A glass substrate with a transparent conductive indium-tin oxide (ITO) film deposited to a thickness of 50 nm (a sputtered film product manufactured by Sanyo Vacuum Industries Co., Ltd.) was subjected to patterning using an ordinary photolithography technique and etching with hydrochloric acid to thereby form a 2 mm-wide stripe anode. The substrate with the patterned ITO formed thereon was subjected to ultrasonic cleaning with an aqueous surfactant solution, washed with ultrapure water, subjected to ultrasonic cleaning with ultrapure water, and washed with ultrapure water in this order, then dried using compressed air, and finally subjected to UV ozone cleaning.

A composition used as a hole injection layer-forming composition was prepared by dissolving, in ethyl benzoate, 3.0% by mass of a high-molecular weight hole transport compound having a repeating structure represented by formula (P-1) below and 0.6% by mass of an electron accepting compound represented by formula (HI-1) below.

The above substrate was spin-coated with this solution and dried on a hot plate at 240°C in air for 30 minutes, and a uniform film having a thickness of 40 nm was thereby formed and used as a hole injection layer.

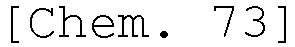

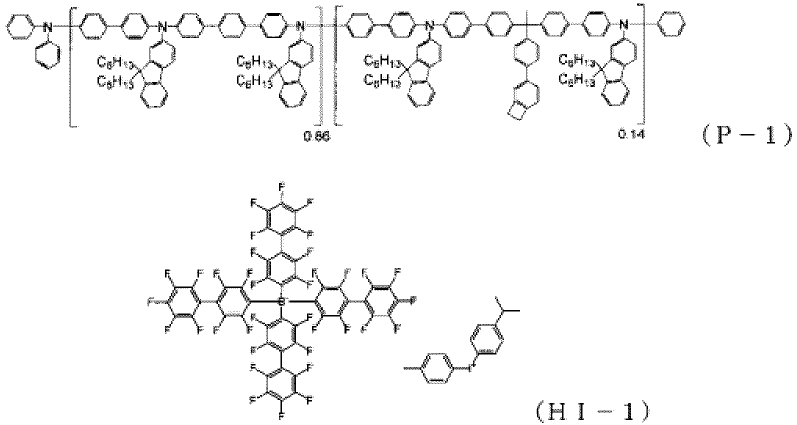

Next, 100 parts by mass of a high-molecular weight charge transport compound having a structure represented by formula (HT-1) below was discovered in mesitylene to prepare a 2.0% by mass solution.

The substrate with the hole injection layer formed thereon by application was spin-coated with the above solution in a nitrogen glove box and dried on a hot plate at 230°C in the nitrogen glove box for 30 minutes, and a uniform film having a thickness of 40 nm was thereby formed and used as a hole transport layer.

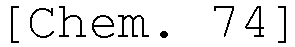

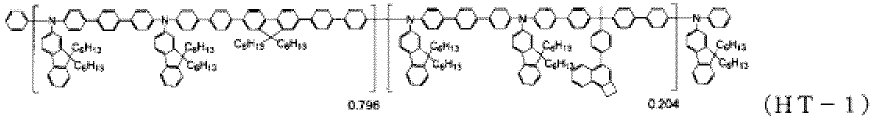

Next, materials of a light-emitting layer, i.e., 50 parts by mass of a compound represented by formula (H-1) below, 50 parts by mass of a compound represented by formula (H-2) below, 15 parts by mass of a compound represented by formula (RD-1) below and used as a red light-emitting dopant, and 15 parts by mass of compound (D-1) represented by formula (D-1) below and used as an assist dopant, were weighed and dissolved in cyclohexylbenzene to thereby prepare a 6.5% by mass solution as a light-emitting layer-forming composition.

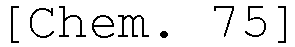

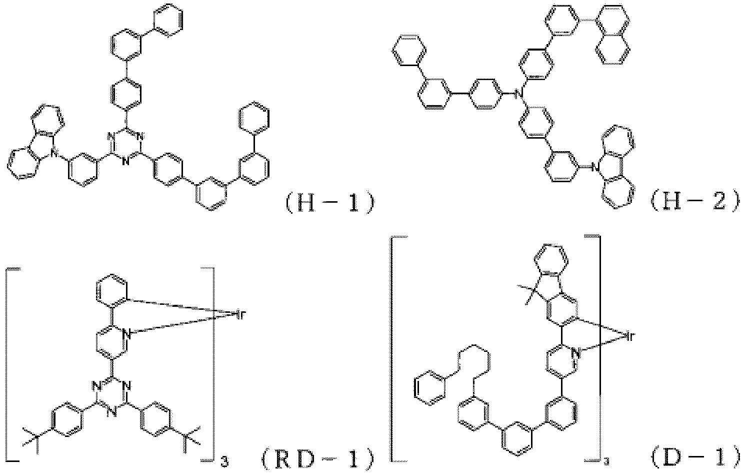

The substrate with the hole transport layer formed thereon by application was spin-coated with the light-emitting layer-forming composition in a nitrogen glove box and dried on a hot plate at 120°C in the nitrogen glove box for 20 minutes, and a uniform film having a thickness of 60 nm was thereby obtained and used as the light-emitting layer. The compound represented by formula (RD-1) is a dopant with a maximum emission wavelength of 613 nm, and compound (D-1) synthesized in Synthesis Example 1 is a dopant with a maximum emission wavelength of 584 nm.

The substrate with the light-emitting layer formed thereon was placed in a vacuum vapor deposition apparatus, and the apparatus was evacuated to 2 × 10⁻⁴ Pa or lower.

Next, a compound represented by formula (HB-1) below and 8-hydroxyquinolinolato-lithium were co-deposited at a thickness ratio of 2:3 on the light-emitting layer at a rate of 1 Å/second by a vacuum vapor deposition method to thereby form a hole blocking layer having a thickness of 30 nm.

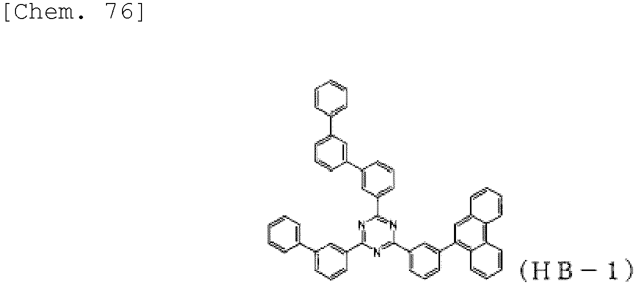

Next, a 2 mm-wide stripe-shaped shadow mask used as a cathode deposition mask was brought into close contact with the substrate so as to be orthogonal to the ITO stripe anode and placed in another vacuum vapor deposition apparatus. Then aluminum in a molybdenum boat was heated to form an 80 nm-thick aluminum layer serving as a cathode at an evaporation rate of 1 to 8.6 Å/second.

An organic electroluminescent element having a light-emitting portion having an area of 2 mm × 2 mm was obtained in the manner described above.

A voltage was applied to the obtained organic electroluminescent element, and red light emission originating from the compound represented by formula (RD-1) was observed.

### [Comparative Example 1]

An organic electroluminescent element was produced using the same procedure as in Example 1 except that a compound represented by formula (CD-1) below was used instead of compound (D-1) and that the chemical composition of the light-emitting layer-forming composition, i.e., the mass ratio of the compounds represented by the respective formulas, was changed to (H-1):(H-2):(CD-1):(RD-1) = 50:50:15:15.

The compound represented by formula (CD-1) below is a dopant having a maximum emission wavelength of 555 nm.

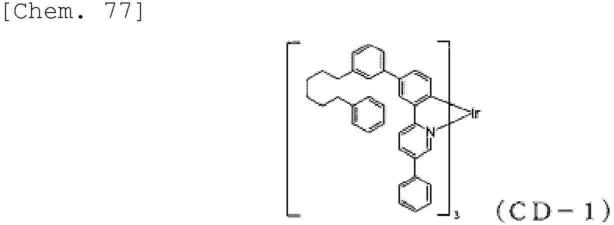

### [Evaluation of elements]

The organic electroluminescent elements obtained in Example 1 and Comparative Example 1 were caused to emit light at a luminance of 1000 cd/m², and the current luminous efficiency (cd/A) and the external quantum efficiency EQE (%) in this case were measured. The ratio of the current luminous efficiency in Example 1 relative to the current luminous efficiency in Comparative Example 1 was computed and is shown in Table 1 below as relative luminous efficiency. A value obtained by subtracting the EQE in Comparative Example 1 from the EQE in Example 1, i.e., ΔEQE = EQE (Example 1) - EQE (Comparative Example 1), is also shown in Table 1 below. Each of the organic electroluminescent elements was driven at a current density of 60 mA/cm², and the time LT97 until the relative emission luminance reached 97% was measured. Then a relative lifetime was obtained with the LT97 in Comparative Example 1 set to 100. The results are shown in Table 1 below.

**[Table 1]**

| | Light-emitting dopant | Assist dopant | Relative luminous efficiency | ΔEQE | Relative lifetime |
|---|---|---|---|---|---|
| Example 1 | RD-1 | D-1 | 1.06 | +0.5 | 141 |
| Comparative Example 1 | RD-1 | CD-1 | 1 | - | 100 |

### [Example 2]

An organic electroluminescent element was produced using the same procedure as in Example 1 except that a compound represented by formula (RD-2) below was used instead of the compound represented by formula (RD-1) and that the chemical composition of the light-emitting layer-forming composition, i.e., the mass ratio of the compounds represented by the respective formulas, was changed to (H-1):(H-2):(D-1):(RD-2) = 50:50:15:15.

The compound represented by formula (RD-2) below is a dopant having a maximum emission wavelength of 627 nm.

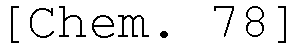

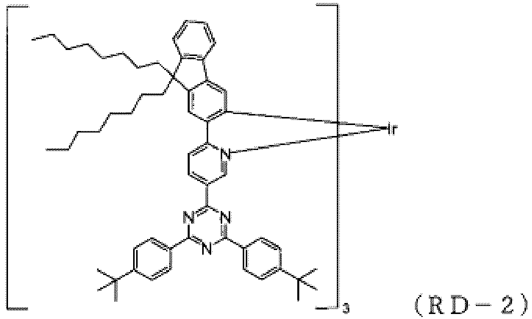

### [Example 3]

An organic electroluminescent element was produced using the same procedure as in Example 1 except that a compound represented by formula (RD-3) below was used instead of the compound represented by formula (RD-1) and that the chemical composition of the light-emitting layer-forming composition, i.e., the mass ratio of the compounds represented by the respective formulas, was changed to (H-1):(H-2):(D-1):(RD-3) = 50:50:15:15.

The compound represented by formula (RD-3) below is a dopant having a maximum emission wavelength of 619 nm.

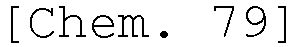

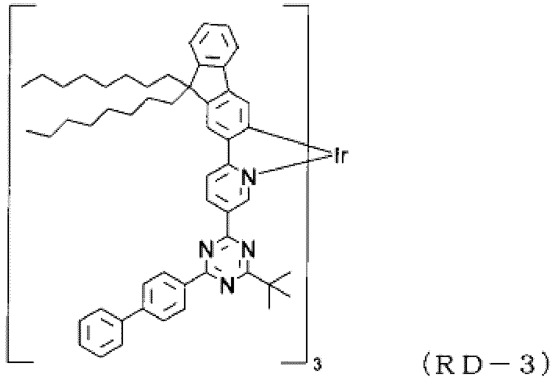

### [Example 4]

An organic electroluminescent element was produced using the same procedure as in Example 1 except that a compound represented by formula (RD-4) below was used instead of the compound represented by formula (RD-1) and that the chemical composition of the light-emitting layer-forming composition, i.e., the mass ratio of the compounds represented by the respective formulas, was changed to (H-1):(H-2):(D-1):(RD-4) = 50:50:15:15.

The compound represented by formula (RD-4) below is a dopant having a maximum emission wavelength of 629 nm.

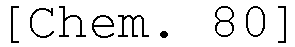

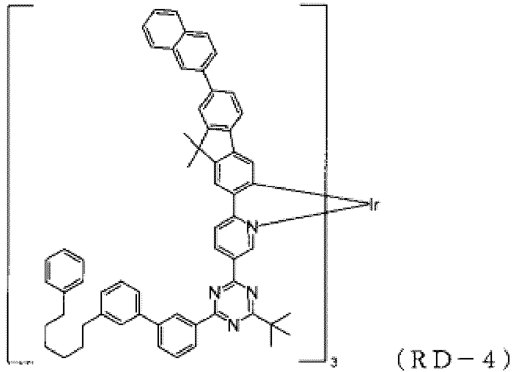

### [Evaluation of elements]

The organic electroluminescent elements obtained in Examples 1 to 4 and Comparative Example 1 were caused to emit light at a luminance of 100 cd/m², and the external quantum efficiency EQE(%) in this case was measured. A value obtained by subtracting the EQE in Comparative Example 1 from the EQE in an Example, i.e., ΔEQE = EQE (Example) - EQE (Comparative Example 1), is shown. Each of the organic electroluminescent elements was driven at a current density of 60 mA/cm², and the time LT97 until the relative emission luminance reached 97% was measured. Then the relative lifetime was obtained with the LT97 in Comparative Example 1 set to 100. The results are shown in Table 2 below.

As can be seen from the results in Table 2, the organic electroluminescent elements (Examples 1 to 4) that use compound (D-1), i.e., the iridium complex compound of the invention, as the light-emitting layer material serving as the assist dopant are elements with a longer driving lifetime than the organic electroluminescent element (Comparative Example 1) that uses the compound represented by formula (CD-1). The organic electroluminescent elements (Examples 2 to 3) that use the compounds represented by formulas (RD-2) to (RD-4) as the light-emitting layer material serving as the light-emitting dopant have a significantly improved driving lifetime, as does the organic electroluminescent element (Example 1) using the compound represented by formula (RD-1).

**[Table 2]**

| | Light-emitting dopant | Assist dopant | ΔEQE | Relative lifetime |
|---|---|---|---|---|
| Example 1 | RD-1 | D-1 | 1.2 | 141 |
| Comparative Example 1 | RD-1 | CD-1 | - | 100 |
| Example 2 | RD-2 | D-1 | 1.3 | 159 |
| Example 3 | RD-3 | D-1 | 1.8 | 171 |
| Example 4 | RD-4 | D-1 | 1.7 | 212 |

### [Comparative Example 2]

An organic electroluminescent element was produced using the same procedure as in Example 3 except that a compound represented by formula (CD-2) below was used instead of compound (D-1) and that the chemical composition of the light-emitting layer-forming composition, i.e., the mass ratio of the compounds represented by the respective formulas, was changed to (H-1): (H-2) : (CD-2) : (RD-3) = 50:50:15:15.

The compound represented by formula (CD-2) below is a dopant having a maximum emission wavelength of 611 nm.

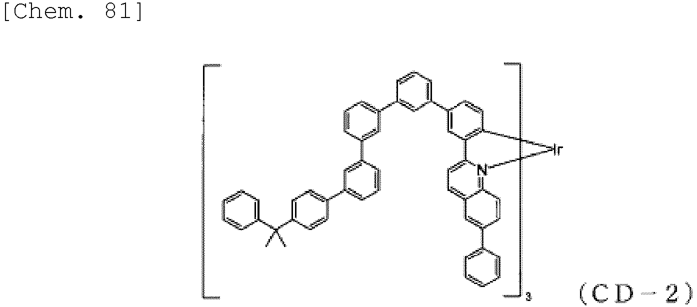

### [Example 5]

An organic electroluminescent element was produced using the same procedure as in Example 3 except that a compound represented by formula (D-2) below was used instead of compound (D-1) and that the chemical composition of the light-emitting layer-forming composition, i.e., the mass ratio of the compounds represented by the respective formulas, was changed to (H-1):(H-2):(D-2):(RD-3) = 50:50:15:15.

The compound represented by formula (D-2) below is a dopant having a maximum emission wavelength of 585 nm.

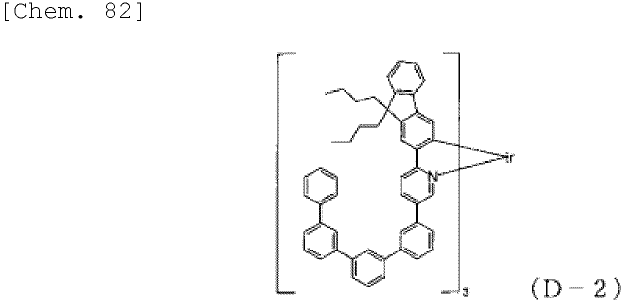

### [Example 6]

An organic electroluminescent element was produced using the same procedure as in Example 3 except that a compound represented by formula (D-3) below was used instead of compound (D-1) and that the chemical composition of the light-emitting layer-forming composition, i.e., the mass ratio of the compounds represented by the respective formulas, was changed to (H-1): (H-2) : (D-3) : (RD-3) = 50:50:15:15.

The compound represented by formula (D-3) below is a dopant having a maximum emission wavelength of 607 nm.

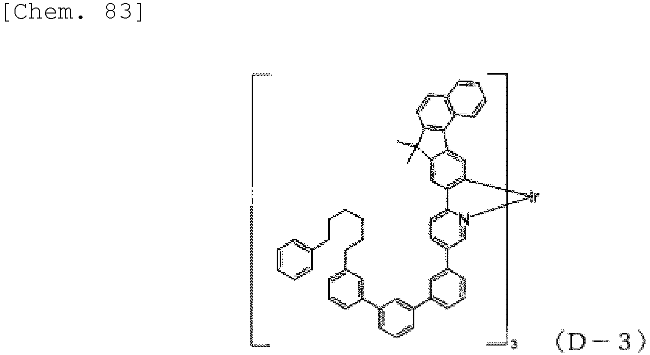

### [Example 7]

An organic electroluminescent element was produced using the same procedure as in Example 3 except that a compound represented by formula (D-4) was used instead of compound (D-1) and that the chemical composition of the light-emitting layer-forming composition, i.e., the mass ratio of the compounds represented by the respective formulas, was changed to (H-1): (H-2) : (D-4) : (RD-3) = 50:50:15:15.

The compound represented by formula (D-4) below is a dopant having a maximum emission wavelength of 586 nm.

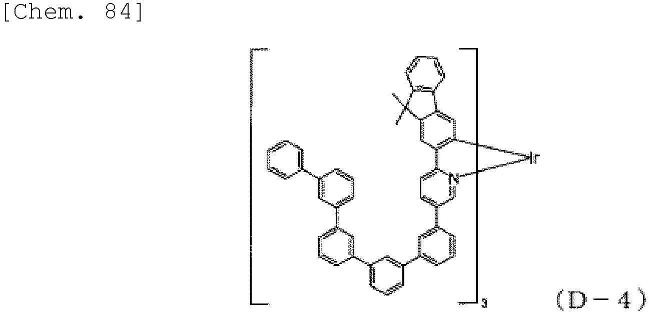

### [Example 8]

An organic electroluminescent element was produced using the same procedure as in Example 3 except that a compound represented by formula (D-5) below was used instead of compound (D-1) and that the chemical composition of the light-emitting layer-forming composition, i.e., the mass ratio of the compounds represented by the respective formulas, was changed to (H-1):(H-2):(D-5):(RD-3) = 50:50:15:15.

The compound represented by formula (D-5) below is a dopant having a maximum emission wavelength of 582 nm.

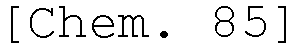

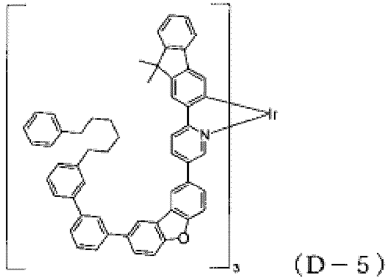

### [Example 9]

An organic electroluminescent element was produced using the same procedure as in Example 3 except that a compound represented by formula (D-6) below was used instead of compound (D-1) and that the chemical composition of the light-emitting layer-forming composition, i.e., the mass ratio of the compounds represented by the respective formulas, was changed to (H-1):(H-2):(D-6):(RD-3) = 50:50:15:15.

The compound represented by formula (D-6) below is a dopant having a maximum emission wavelength of 583 nm.

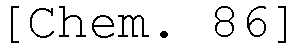

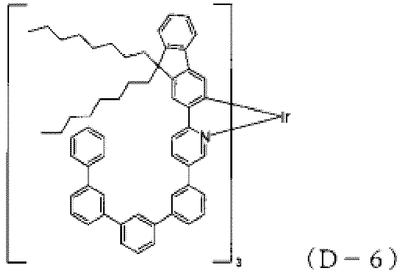

### [Evaluation of elements]

The organic electroluminescent elements obtained in Example 3, Comparative Example 2, and Examples 5 to 9 were caused to emit light at a luminance of 100 cd/m², and the external quantum efficiency EQE(%) in this case was measured. A value obtained by subtracting the EQE in Comparative Example 2 from the EQE in an Example, i.e., ΔEQE = EQE (Example) - EQE (Comparative Example 2), is shown. The results are shown in Table 3. Each of the organic electroluminescent elements was driven at a current density of 60 mA/cm², and the time LT65 until the relative emission luminance reached 65% was measured. The relative lifetime was obtained with the LT65 in Comparative Example 2 set to 100. The results are shown in Table 3 below.

As can be seen from the results in Table 3, in the organic electroluminescent elements (Examples 3 and 5 to 9) that use the compounds corresponding to the iridium complex compound of the invention as the light-emitting layer material serving as the assist dopant, the efficiency is higher than that of the organic electroluminescent element (Comparative Example 2) using the compound represented by formula (CD-2).

**[Table 3]**

| | Light-emitting dopant | Assist dopant | ΔEQE | LT65 |
|---|---|---|---|---|
| Example 3 | RD-3 | D-1 | 0.8 | 129 |
| Comparative Example 2 | RD-3 | CD-2 | - | 100 |
| Example 5 | RD-3 | D-2 | 1.2 | 117 |
| Example 6 | RD-3 | D-3 | 0.5 | 155 |
| Example 7 | RD-3 | D-4 | 1.1 | 143 |
| Example 8 | RD-3 | D-5 | 0.4 | 117 |
| Example 9 | RD-3 | D-6 | 0.1 | 100 |

### [Example 10]

An organic electroluminescent element was produced using the same procedure as in Example 3 except that a compound represented by formula (D-7) below was used instead of compound (D-1) and that the chemical composition of the light-emitting layer-forming composition, i.e., the mass ratio of the compounds represented by the respective formulas, was changed to (H-1): (H-2) : (D-7) : (RD-3) = 50:50:15:15.

The compound represented by formula (D-7) below is a dopant having a maximum emission wavelength of 584 nm.

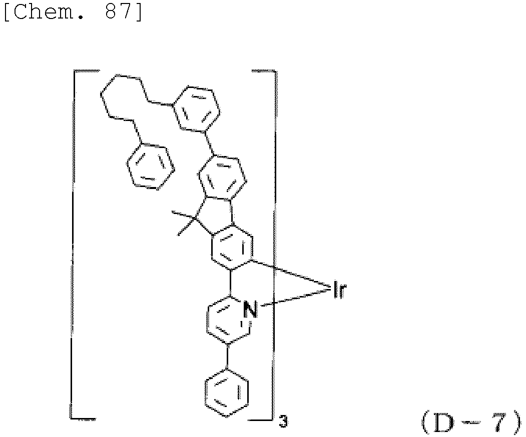

### [Evaluation of elements]

The organic electroluminescent elements obtained in Example 10 and Comparative Example 2 were caused to emit light at a luminance of 100 cd/m², and the external quantum efficiency EQE(%) in this case was measured. A value obtained by subtracting the EQE in Comparative Example 2 from the EQE in the Example, i.e., ΔEQE = EQE (Example) - EQE (Comparative Example 2), is shown. The results are shown in Table 4 below. Each of the organic electroluminescent elements was driven at a current density of 60 mA/cm², and the time LT97 until the relative emission luminance reached 97% was measured. The relative lifetime was obtained with the LT97 in Comparative Example 2 set to 100. The results are shown in Table 4 below.

As can be seen from the results in Table 4, the organic electroluminescent element (Example 10) that uses the iridium complex compound of the invention as the light-emitting layer material serving as the assist dopant has higher efficiency than the organic electroluminescent element (Comparative Example 2) that uses the compound represented by formula (CD-2).

**[Table 4]**

| | Light-emitting dopant | Assist dopant | ΔEQE | LT97 |
|---|---|---|---|---|
| Example 10 | RD-3 | D-7 | 1.55 | 141 |
| Comparative Example 2 | RD-3 | CD-2 | - | 100 |

### [Solubility test]

### [Example 11]

A 10 mL brown vial bottle was charged with 52.7 mg of compound (D-1). Cyclohexylbenzene was added to adjust the concentration of the compound to 2% by mass, and the mass of the mixture was 2.64 g. The bottle was heated on a hot plate heated to 100°C for 10 minutes to dissolve compound (D-1) completely. Then the mixture was allowed to stand at room temperature (22°C) and observed.

### [Example 12]

A solution was prepared using the same procedure as in Example 11 except that compound (D-2) was used instead of compound (D-1).

### [Example 13]

A solution was prepared using the same procedure as in Example 11 except that compound (D-3) was used instead of compound (D-1).

### [Example 14]

A solution was prepared using the same procedure as in Example 11 except that compound (D-4) was used instead of compound (D-1).

### [Example 15]

A solution was prepared using the same procedure as in Example 11 except that compound (D-5) was used instead of compound (D-1).

### [Example 16]

A solution was prepared using the same procedure as in Example 11 except that compound (D-6) was used instead of compound (D-1).

### [Example 17]

A solution was prepared using the same procedure as in Example 11 except that compound (D-7) was used instead of compound (D-1).

### [Evaluation of solubility]

The results of observation in Examples 11 to 17 are shown in Table 5. As can be seen from the results, in the 2% by mass solutions having a higher assist dopant compound concentration than the light-emitting layer-forming composition (light-emitting layer ink) prepared in Example 1 (0.75% by mass), the dissolution stability was higher in compounds (D-1) to (D-6) than in compound (D-7). To allow the light-emitting layer to have an optimal thickness using a spin coating method, a plurality of methods can be used. Specifically, the concentration of the ink, the viscosity of the solvent, the rotation speed, etc. are adjusted. However, with an inkjet method, a method in which the concentration of the ink is adjusted is selected because there is a preferred range of the ejection amount of ink droplets. In this case, the wider the allowable range of the ink concentration, the better. Therefore, in the present invention, the light-emitting layer-forming composition using the iridium complex compound represented by formula (1') and typified by compounds (D-1) to (D-6) is more preferred to the light-emitting layer-forming composition using the compound represented by formula (1) and typified by compound (D-7).

**[Table 5]**

| | Compound | Results |
|---|---|---|
| Example 11 | D-1 | Uniform solution state was maintained even after lapse of 24 hours. |
| Example 12 | D-2 | Uniform solution state was maintained even after lapse of 24 hours. |
| Example 13 | D-3 | Uniform solution state was maintained even after lapse of 24 hours. |
| Example 14 | D-4 | Uniform solution state was maintained even after lapse of 24 hours. |
| Example 15 | D-5 | Uniform solution state was maintained even after lapse of 24 hours. |
| Example 16 | D-6 | Uniform solution state was maintained even after lapse of 24 hours. |
| Example 17 | D-7 | Solution became turbid and precipitation occurred after lapse of 20 minute. |

Although the present invention has been described in detail by way of the specific modes, it is apparent for those skilled in the art that various changes can be made without departing from the spirit and scope of the present invention.

The present application is based on Japanese Patent Application No. 2022-003809 and Japanese Patent Application No. 2022-003810 filed on January 13, 2022, the entire contents of which are incorporated herein by reference. Reference Signs List

- 1: substrate
- 2: anode
- 3: hole injection layer
- 4: hole transport layer
- 5: light-emitting layer
- 6: hole blocking layer
- 7: electron transport layer
- 8: electron injection layer
- 9: cathode
- 10: organic electroluminescent element

## Claims

1. An organic electroluminescent element composition comprising: a compound represented by formula (31) below; and a compound represented by formula (32) below or a compound represented by formula (1) below: 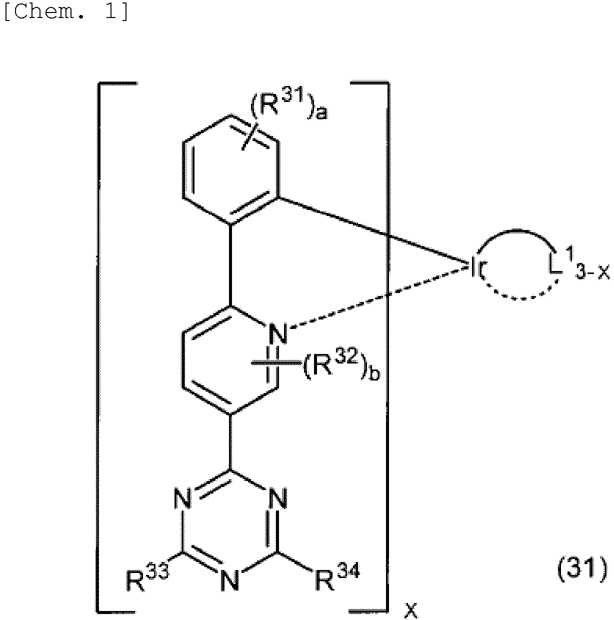
[wherein, in the above formula, Ir represents an iridium atom;
R³¹ and R³² are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms, each of which may optionally have a substituent;
when a plurality of R³¹'s or R³²'s are present, they may be the same or different;
when a plurality of R³¹'s are present, adjacent R³¹'s may be bonded together to form a ring;
a is an integer of 0 to 4; b is an integer of 0 to 3; R³³ and R³⁴ are each independently a hydrogen atom, a fluorine atom, a chlorine atom, a bromine atom, an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 20 carbon atoms, each of which may optionally have a substituent;
when a plurality of R³³'s or R³⁴'s are present, they may be the same or different;
L¹ represents an organic ligand; and x is an integer of 1 to 3], 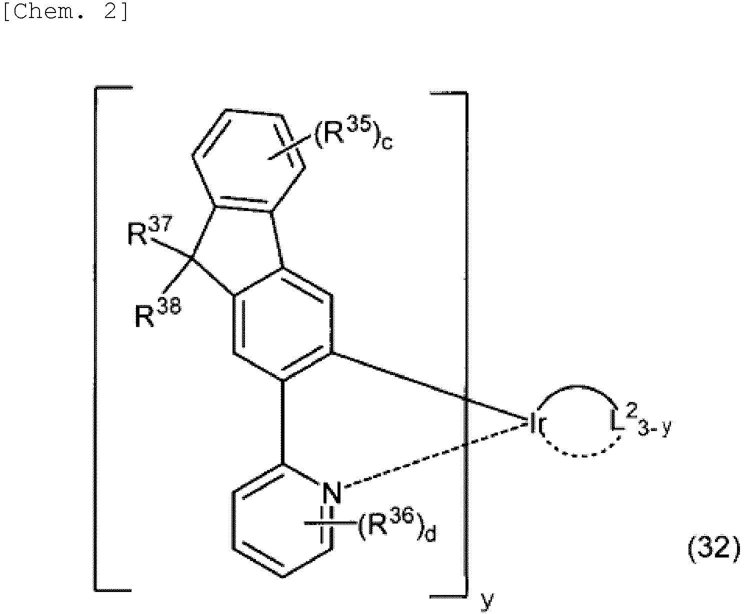
[wherein, in the above formula, Ir represents an iridium atom;
R³⁵ to R³⁸ are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms, each of which may optionally have a substituent;
when a plurality of R³⁵'s, R³⁶'s, R³⁷'s, or R³⁸'s are present, they may be the same or different;
when a plurality of R³⁵'s are present, adjacent R³⁵'s may be bonded together to form a ring;
c and d are each independently an integer of 0 to 4;
L² represents an organic ligand; and y is an integer of 1 to 3], 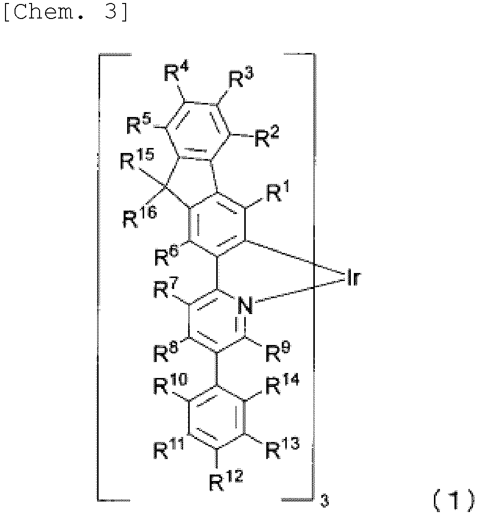
[wherein, in formula (1) above, Ir represents an iridium atom;
R¹ to R¹⁶ each represent a substituent within any of the following ranges; adjacent two of R¹ to R¹⁶ may be bonded together to form a ring while losing respective hydrogen atoms;
R² to R⁵ are each selected from a [substituent group W] shown below;
R¹, R⁶ to R¹⁰, and R¹⁴ are each independently a hydrogen atom, F, a methyl group, a trifluoromethyl group, an ethyl group, a vinyl group, or an ethynyl group;
R¹⁵ and R¹⁶ are each independently a linear, branched, or cyclic alkyl group having 1 to 30 carbon atoms, an aromatic hydrocarbon group having 5 to 60 carbon atoms, an aromatic heterocyclic group having 5 to 60 carbon atoms, an aralkyl group having 5 to 60 carbon atoms, or a heteroaralkyl group having 5 to 60 carbon atoms, each of which may optionally have a substituent, which is the same as R' in the "substituent group W" shown below;
one of R¹¹ to R¹³ has a structure represented by formula (2) below; and the remaining two are each selected from a [substituent group Z] shown below: 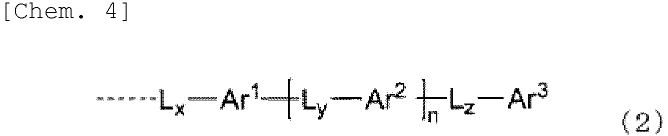
wherein, in formula (2) above, a broken line represents a bond to formula (1);
n represents an integer of 1 to 10;
when a plurality of L_{y}'s and a plurality of Ar²'s are present, they may be the same or different;
Lₓ, L_{y}, and L_{z} are each independently a direct bond or selected from -O-, -S-, -NR'-, -Si(R')₂-, -B(R')-, -C(=O)-, -P(=O) (R')-, -S(=O)₂-, -OSO₂-, and alkylene groups having 1 to 30 carbon atoms, wherein each of the alkylene groups may be optionally substituted with at least one R', wherein one -CH₂- group or 2 or more non-adjacent -CH₂- groups in each alkylene group may be replaced with -C(-R')=C(-R')-, -C=C-, -Si(-R')₂-, -C(=O)-, -NR'-, -O-, -S-, or -CONR'-, wherein R' is the same as R' in the [substituent group W] shown below, and wherein at least one hydrogen atom in these groups may be replaced with F, Cl, Br, I, or -CN;
Ar¹ and Ar² each independently represent a divalent 5- or 6-membered aromatic hydrocarbon group or a divalent 5- or 6-membered aromatic heterocyclic group; Ar¹ and Ar² may each optionally have a substituent selected from the [substituent group Z] shown below;
Ar³ represents a monovalent 5- or 6-membered aromatic hydrocarbon group or a monovalent 5- or 6-membered aromatic heterocyclic group; and Ar³ may optionally have a substituent selected from the [substituent group Z] shown below:
[substituent group W]
substituents selected from a hydrogen atom, F, Cl, Br, I, -N(R')₂, -CN, -NO₂, -OH, -SH, -COOR', -C(=O)R', -C(=O)NR', -P(=O)(R')₂, -S(=O)R', -S(=O)₂R', -OS(=O)₂R', -SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms,
wherein the alkyl groups, the alkoxy groups, the alkylthio groups, the alkenyl groups, and the alkynyl groups may each be optionally substituted with at least one R', wherein one -CH₂- group or 2 or more non-adjacent -CH₂-groups in each of these groups may be optionally replaced with -C(-R')=C(-R')-, -C=C-, -Si(-R')₂, -C(=O)-, -NR'-, -O-, -S-, -CONR'-, a divalent aromatic hydrocarbon group, or a divalent aromatic heterocyclic group, wherein at least one hydrogen atom in each of these groups may be optionally replaced with F, Cl, Br, I, or -CN, and
wherein the aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each independently be optionally substituted with at least one R';
R's are each independently selected from a hydrogen atom, F, Cl, Br, I, -N(R")₂, -OH, -SH, -CN, -NO₂, -Si(R")₃, -B(OR")₂, -C(=O)R'', -P(=O)(R")₂, -S(=O)₂R", -OSO₂R", linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms,
wherein the alkyl groups, the alkoxy groups, the alkylthio groups, the alkenyl groups, and the alkynyl groups may each be optionally substituted with at least one R", wherein one -CH₂- group or 2 or more non-adjacent -CH₂-groups in each of these groups may be optionally replaced with -C(-R') =C (-R") -, -C=C-, -Si(-R")₂-, -C(=O)-, -NR' '-, -O-, -S-, -CONR''-, a divalent aromatic hydrocarbon group, or a divalent aromatic heterocyclic group, wherein at least one hydrogen atom in each of these groups may be replaced with F, Cl, Br, I, or -CN,
wherein the aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each be optionally substituted with at least one R", and wherein two or more adjacent R's may be bonded together while losing respective hydrogen atoms to thereby form an aliphatic, aromatic hydrocarbon, or aromatic heterocyclic monocyclic or condensed ring;
R"s are each independently selected from a hydrogen atom, F, -CN, aliphatic hydrocarbon groups having 1 to 20 carbon atoms, aromatic hydrocarbon groups having 5 to 20 carbon atoms, and aromatic heterocyclic groups having 5 to 20 carbon atoms; and two or more adjacent R"s may be bonded together while losing respective hydrogen atoms to form an aliphatic, aromatic hydrocarbon, or aromatic heterocyclic monocyclic or condensed ring:
[substituent group Z]
substituents selected from a hydrogen atom, F, Cl, Br, I, -N(R')₂, -CN, -NO₂, -OH, -SH, -COOR', -C(=O)R', -C(=O)NR', -P(=O)(R')₂, -S(=O)R', -S(=O)₂R', -OS(=O)₂R', -SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms, wherein the alkyl groups, the alkoxy groups, the alkylthio groups, the aryloxy groups, the arylthio groups, the aralkyl groups, the heteroaralkyl groups, the diarylamino groups, the arylheteroarylamino groups, and the diheteroarylamino groups may each be optionally substituted with at least one R', and wherein R' is the same as R' in the [substituent group W] above].

2. The organic electroluminescent element composition according to claim 1, wherein the compound represented by formula (31) above is a compound represented by formula (31-1) below: 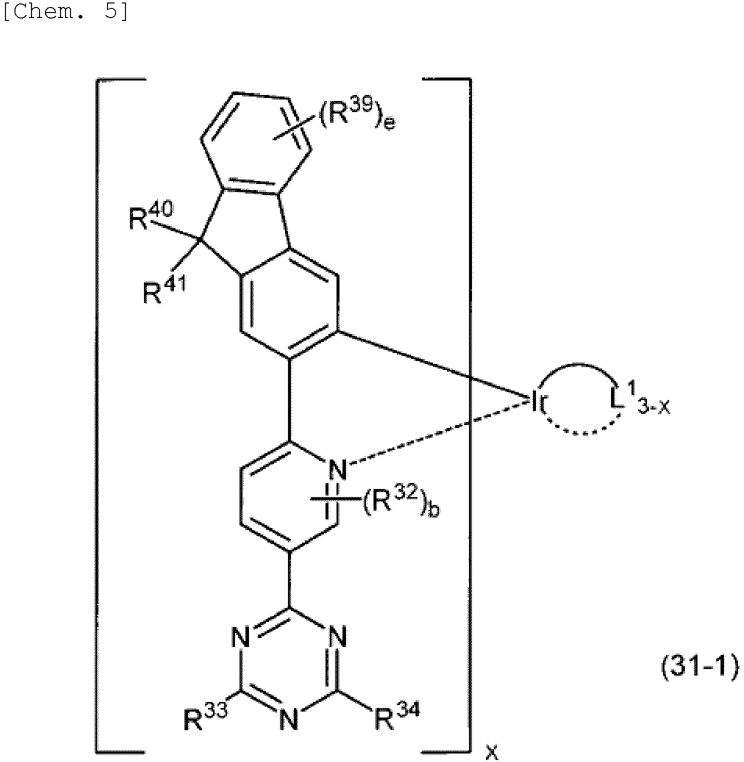
[wherein, in the above formula, Ir represents an iridium atom;
R³² to R³⁴, b, L¹, and x are the same as R³² to R³⁴, b, L¹, and x, respectively, in formula (31) above;
R³⁹ to R⁴¹ are each independently an alkyl group having 1 to 20 carbon atoms, a (hetero)aralkyl group having 7 to 40 carbon atoms, an alkoxy group having 1 to 20 carbon atoms, a (hetero)aryloxy group having 3 to 20 carbon atoms, an alkylsilyl group having 1 to 20 carbon atoms, an arylsilyl group having 6 to 20 carbon atoms, an alkylcarbonyl group having 2 to 20 carbon atoms, an arylcarbonyl group having 7 to 20 carbon atoms, an alkylamino group having 1 to 20 carbon atoms, an arylamino group having 6 to 20 carbon atoms, or a (hetero)aryl group having 3 to 30 carbon atoms, each of which may optionally have a substituent; when a plurality of R³⁹'s, R⁴⁰'s, or R⁴¹'s are present, they may be the same or different; when a plurality of R³⁹'s are present, adjacent R³⁹'s may be bonded together to form a ring; and
e is an integer of 0 to 4].

3. The organic electroluminescent element composition according to claim 1 or 2, wherein R³⁶ in formula (32) above is a group including a plurality of benzene rings linked together.

4. The organic electroluminescent element composition according to any one of claims 1 to 3, wherein the optional substituents on R³¹ to R³⁴ in formula (31) above are each an alkyl group, an aralkyl group, a heteroaralkyl group, an alkoxy group, an aryloxy group, a heteroaryloxy group, an alkylsilyl group, an arylsilyl group, an alkylcarbonyl group, an arylcarbonyl group, an alkylamino group, an arylamino group, an aryl group, or a heteroaryl group.

5. The organic electroluminescent element composition according to any one of claims 1 to 4, wherein the optional substituents on R³⁵ to R³⁸ in formula (32) above are each an alkyl group, an aralkyl group, a heteroaralkyl group, an alkoxy group, an aryloxy group, a heteroaryloxy group, an alkylsilyl group, an arylsilyl group, an alkylcarbonyl group, an arylcarbonyl group, an alkylamino group, an arylamino group, an aryl group, or a heteroaryl group.

6. The organic electroluminescent element composition according to any one of claims 1 to 5, wherein x in formula (31) above is 2 or less, and wherein L¹ has at least one structure selected from the group consisting of formulas (33), (34), and (35) below: 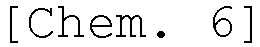 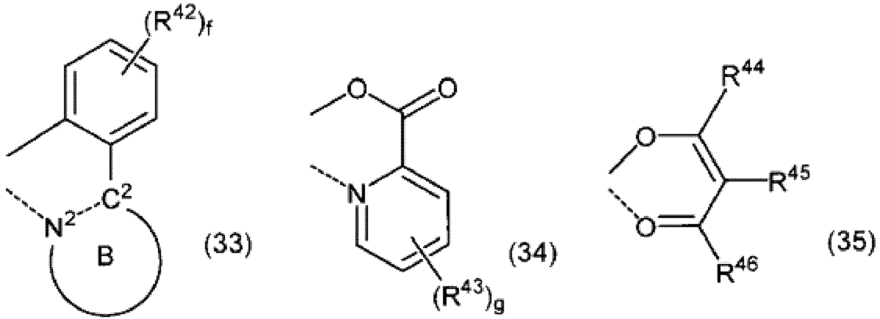
[wherein, in formulas (33) to (35) above, R⁴² and R⁴³ are each independently the same as R³¹ in formula (31); when a plurality of R⁴²s or R⁴³'s are present, they may be the same or different;
R⁴⁴ to R⁴⁶ are each independently a hydrogen atom, an alkyl group having 1 to 20 carbon atoms and optionally substituted with a fluorine atom, a phenyl group optionally substituted with an alkyl group having 1 to 20 carbon atoms, or a halogen atom;
f is an integer of 0 to 4; g is an integer of 0 to 4; ring B is a pyridine ring, a pyrimidine ring, an imidazole ring, a quinoline ring, an isoquinoline ring, a quinazoline ring, a quinoxaline ring, an azatriphenylene ring, a carboline ring, a benzothiazole ring, or a benzoxazole ring; and ring B may optionally have a substituent].

7. The organic electroluminescent element composition according to any one of claims 1 to 6, wherein y in formula (32) above is 2 or less, and wherein L² has at least one structure selected from the group consisting of formulas (33), (34), and (35) below: 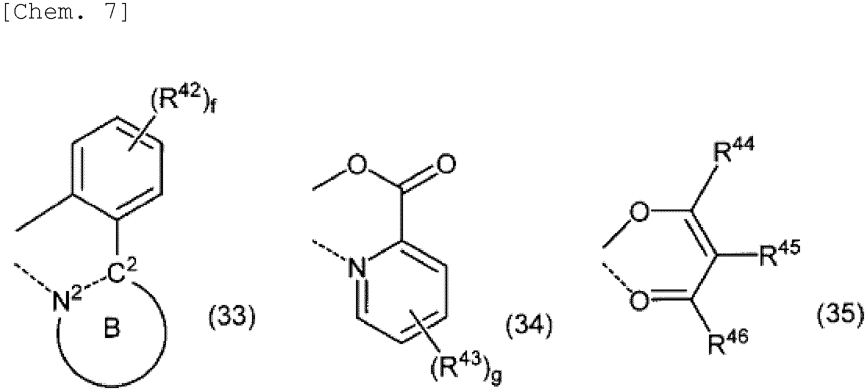
[wherein, in formulas (33) to (35) above, R⁴² and R⁴³ are each independently the same as R³¹ in formula (31) above; when a plurality of R⁴²'s or R⁴³'s are present, they may be the same or different;
R⁴⁴ to R⁴⁶ are each independently a hydrogen atom, an alkyl group having 1 to 20 carbon atoms and optionally substituted with a fluorine atom, a phenyl group optionally substituted with an alkyl group having 1 to 20 carbon atoms, or a halogen atom;
f is an integer of 0 to 4; g is an integer of 0 to 4;
ring B is a pyridine ring, a pyrimidine ring, an imidazole ring, a quinoline ring, an isoquinoline ring, a quinazoline ring, a quinoxaline ring, an azatriphenylene ring, a carboline ring, a benzothiazole ring, or a benzoxazole ring; and ring B may optionally have a substituent].

8. The organic electroluminescent element composition according to any one of claims 1 to 7, wherein a in formula (31) above is 1, or wherein a in formula (31) above is an integer of 2 or more and adjacent R³¹'s are not bonded together to form a ring.

9. The organic electroluminescent element composition according to any one of claims 1 to 8, wherein the compositional mass ratio of the compound represented by formula (31) above is equal to or more than one-fifth of the compositional mass ratio of the compound represented by formula (32) above or the compound represented by formula (1) above.

10. An organic electroluminescent element comprising an anode and a cathode that are disposed on a substrate and further comprising an organic layer between the anode and the cathode,
wherein the organic layer contains the organic electroluminescent element composition according to any one of claims 1 to 9.

11. The organic electroluminescent element according to claim 10, wherein the organic layer is a light-emitting layer.

12. A display device comprising the organic electroluminescent element according to claim 11.

13. The organic electroluminescent element composition according to any one of claims 1 to 9, further comprising a solvent.

14. A method for producing an organic electroluminescent element including an anode and a cathode that are disposed on a substrate and further including an organic layer between the anode and the cathode, the method comprising the step of forming a light-emitting layer by a wet deposition method using the organic electroluminescent element composition according to claim 13.

15. An iridium complex compound represented by formula (1') below: 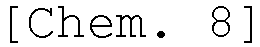 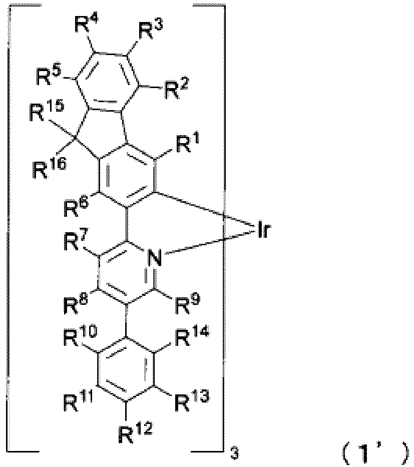
[wherein, in formula (1') above, Ir represents an iridium atom;
R¹ to R¹⁶ each represent a substituent within any of the following ranges; adjacent two of R¹ to R¹⁶ may be bonded together to form a ring while losing respective hydrogen atoms;
R² to R⁵ are each selected from a [substituent group W] shown below;
R¹, R⁶ to R¹⁰, and R¹⁴ are each independently a hydrogen atom, F, a methyl group, a trifluoromethyl group, an ethyl group, a vinyl group, or an ethynyl group;
R¹⁵ and R¹⁶ are each independently a linear, branched, or cyclic alkyl group having 1 to 30 carbon atoms, an aralkyl group having 5 to 60 carbon atoms, or a heteroaralkyl group having 5 to 60 carbon atoms, each of which may optionally have a substituent, which is the same as R' in the "substituent group W" shown below;
one of R¹¹ to R¹³ has a structure represented by formula (2) below; and the remaining two are each selected from a [substituent group Z] shown below: 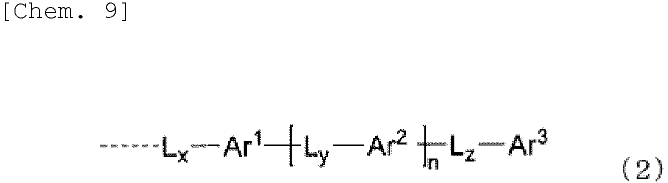
wherein, in formula (2) above, a broken line represents a bond to formula (1');
n represents an integer of 1 to 10;
when a plurality of L_{y}'s and a plurality of Ar²'s are present, they may be the same or different;
Lₓ, L_{y}, and L_{z} are each independently a direct bond or selected from -O-, -S-, -NR'-, -Si(R')₂-, -B(R')-, -C(=O)-, -P(=O) (R')-, -S(=O)₂-, -OSO₂-, and alkylene groups having 1 to 30 carbon atoms, wherein each of the alkylene groups may be optionally substituted with at least one R', wherein one -CH₂- group or 2 or more non-adjacent -CH₂- groups in each alkylene group may be replaced with -C(-R')=C(-R')-, -C≡C-, -Si(-R')₂-, -C(=O)-, -NR'-, -O-, -S-, or -CONR'-, wherein R' is the same as R' in the [substituent group W] shown below, and wherein at least one hydrogen atom in these groups may be replaced with F, Cl, Br, I, or -CN;
Ar¹ and Ar² each independently represent a divalent 5- or 6-membered aromatic hydrocarbon group or a divalent 5- or 6-membered aromatic heterocyclic group; Ar¹ and Ar² may each optionally have a substituent selected from the [substituent group Z] shown below;
Ar³ represents a monovalent 5- or 6-membered aromatic hydrocarbon group or a monovalent 5- or 6-membered aromatic heterocyclic group; and Ar³ may optionally have a substituent selected from the [substituent group Z] shown below:
[substituent group W]
substituents selected from a hydrogen atom, F, Cl, Br, I, -N(R')₂, -CN, -NO₂, -OH, -SH, -COOR', -C(=O)R', -C(=O)NR', -P(=O) (R')₂, -S(=O)R', -S(=O)₂R', -OS(=O)₂R', -SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms,
wherein the alkyl groups, the alkoxy groups, the alkylthio groups, the alkenyl groups, and the alkynyl groups may each be optionally substituted with at least one R', wherein one -CH₂- group or 2 or more non-adjacent -CH₂-groups in each of these groups may be optionally replaced with -C(-R')=C(-R')-, -C=C-, -Si(-R')₂, -C(=O)-, -NR'-, -O-, -S-, -CONR'-, a divalent aromatic hydrocarbon group, or a divalent aromatic heterocyclic group, wherein at least one hydrogen atom in each of these groups may be optionally replaced with F, Cl, Br, I, or -CN, and
wherein the aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each independently be optionally substituted with at least one R';
R's are each independently selected from a hydrogen atom, F, Cl, Br, I, -N(R")₂, -OH, -SH, -CN, -NO₂, -Si(R")₃, -B(OR'')₂, -C(=O)R", -P(=O)(R")₂, -S(=O)₂R", -OSO₂R", linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, linear, branched, or cyclic alkenyl groups having 2 to 30 carbon atoms, linear, branched, or cyclic alkynyl groups having 2 to 30 carbon atoms, aromatic hydrocarbon groups having 5 to 60 carbon atoms, aromatic heterocyclic groups having 5 to 60 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms,
wherein the alkyl groups, the alkoxy groups, the alkylthio groups, the alkenyl groups, and the alkynyl groups may each be optionally substituted with at least one R", wherein one -CH₂- group or 2 or more non-adjacent -CH₂-groups in each of these groups may be optionally replaced with -C(-R') =C (-R") -, -C≡C-, -Si(-R")₂-, -C(=O)-, -NR"-, -O-, -S-, -CONR''-, a divalent aromatic hydrocarbon group, or a divalent aromatic heterocyclic group, wherein at least one hydrogen atom in each of these groups may be replaced with F, Cl, Br, I, or -CN,
wherein the aromatic hydrocarbon groups, the aromatic heterocyclic groups, the aryloxy groups, the arylthio groups, the aralkyl groups, the heteroaralkyl groups, the diarylamino groups, the arylheteroarylamino groups, and the diheteroarylamino groups may each be optionally substituted with at least one R", and wherein two or more adjacent R's may be bonded together while losing respective hydrogen atoms to thereby form an aliphatic, aromatic hydrocarbon, or aromatic heterocyclic monocyclic or condensed ring;
R"s are each independently selected from a hydrogen atom, F, -CN, aliphatic hydrocarbon groups having 1 to 20 carbon atoms, aromatic hydrocarbon groups having 5 to 20 carbon atoms, and aromatic heterocyclic groups having 5 to 20 carbon atoms; and two or more adjacent R"s may be bonded together while losing respective hydrogen atoms to form an aliphatic, aromatic hydrocarbon, or aromatic heterocyclic monocyclic or condensed ring:
[substituent group Z]
substituents selected from a hydrogen atom, F, Cl, Br, I, -N(R')₂, -CN, -NO₂, -OH, -SH, -COOR', -C(=O)R', -C(=O)NR', -P(=O)(R')₂, -S(=O)R', -S(=O)₂R', -OS(=O)₂R', -SiR'₃, linear, branched, or cyclic alkyl groups having 1 to 30 carbon atoms, linear, branched, or cyclic alkoxy groups having 1 to 30 carbon atoms, linear, branched, or cyclic alkylthio groups having 1 to 30 carbon atoms, aryloxy groups having 5 to 40 carbon atoms, arylthio groups having 5 to 40 carbon atoms, aralkyl groups having 5 to 60 carbon atoms, heteroaralkyl groups having 5 to 60 carbon atoms, diarylamino groups having 10 to 40 carbon atoms, arylheteroarylamino groups having 10 to 40 carbon atoms, and diheteroarylamino groups having 10 to 40 carbon atoms, wherein the alkyl groups, the alkoxy groups, the alkylthio groups, the aryloxy groups, the arylthio groups, the aralkyl groups, the heteroaralkyl groups, the diarylamino groups, the arylheteroarylamino groups, and the diheteroarylamino groups may each be optionally substituted with at least one R', and wherein R' is the same as R' in the [substituent group W] above].

16. The iridium complex compound according to claim 15,
wherein R¹¹ has a structure represented by formula (2) above.

17. The iridium complex compound according to claim 15 or 16, wherein R¹, R⁶ to R¹⁰, and R¹⁴ are each a hydrogen atom.

18. The iridium complex compound according to any one of claims 15 to 17, wherein R¹⁵ and R¹⁶ are each independently a linear, branched, or cyclic alkyl group having 1 to 8 carbon atoms.

19. The iridium complex compound according to any one of claims 15 to 18, wherein n in formula (2) above is 5 or less.

20. The iridium complex compound according to any one of claims 15 to 19, wherein Ar¹ and Ar² are each independently a phenylene group optionally having a substituent, and wherein Ar³ is a phenyl group optionally having a substituent.

21. The iridium complex compound according to claim 20,
wherein Ar¹ and Ar² are each independently a phenylene group optionally having, as a substituent, a linear, branched, or cyclic alkyl group having 1 to 30 carbon atoms, and wherein Ar³ is a phenyl group optionally having, as a substituent, a linear, branched, or cyclic alkyl group having 1 to 30 carbon atoms.

22. The iridium complex compound according to any one of claims 15 to 21, wherein formula (1') above is represented by formula (3), (4), or (5) below: 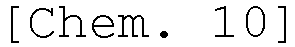 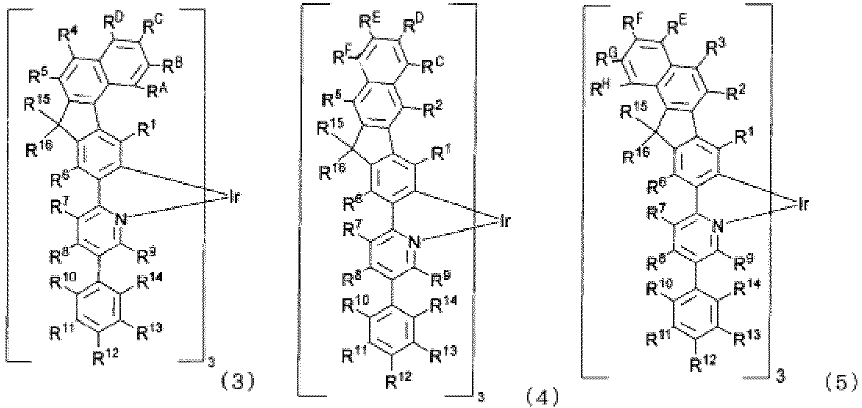 [wherein, in formulas (3) to (5),
R¹ to R¹⁶ are the same as R¹ to R¹⁶ in formula (1');
R^{A} and R^{B} are each the same as R²;
R^{C} and R^{D} are each the same as R³;
R^{E} and R^{F} are each the same as R⁴; and
R^{G} and R^{H} are each the same as R⁵].

23. An organic electroluminescent element composition comprising the iridium complex compound according to any one of claims 15 to 22.

24. The organic electroluminescent element composition according to claim 23, further comprising a phosphorescent light-emitting material represented by formula (201) below: 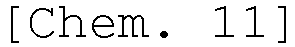 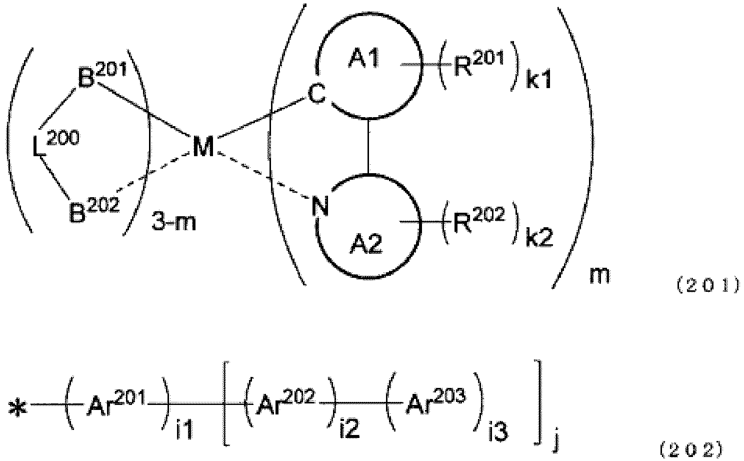
[wherein, in formula (201) above, M is a metal selected from groups 7 to 11 of a periodic table;
ring A1 represents an aromatic hydrocarbon ring structure optionally having a substituent or an aromatic heterocyclic structure optionally having a substituent;
ring A2 represents an aromatic heterocyclic structure optionally having a substituent;
R²⁰¹ and R²⁰² are each independently a structure represented by formula (202) above; "*" represents a bond to ring A1 or ring A2; R²⁰¹ and R²⁰² may be the same or different; when a plurality of R²⁰¹'s are present, they may be the same or different; when a plurality of R²⁰²'s are present, they may be the same or different;
Ar²⁰¹ represents a divalent aromatic hydrocarbon ring structure optionally having a substituent or a divalent aromatic heterocyclic structure optionally having a substituent; when a plurality of Ar²⁰¹'s are present, they may be the same or different;
Ar²⁰² represents a divalent aromatic hydrocarbon ring structure optionally having a substituent, a divalent aromatic heterocyclic structure optionally having a substituent, or a divalent aliphatic hydrocarbon structure optionally having a substituent; when a plurality of Ar²⁰²'s are present, they may be the same or different;
Ar²⁰³ represents a monovalent aromatic hydrocarbon ring structure optionally having a substituent or a monovalent aromatic heterocyclic structure optionally having a substituent; when a plurality of Ar²⁰³'s are present, they may be the same or different;
substituents bonded to ring A1, substituents bonded to ring A2, or a substituent bonded to ring A1 and a substituent bonded to ring A2 may be bonded together to form a ring;
B²⁰¹-L²⁰⁰-B²⁰² represents an anionic bidentate ligand;
B²⁰¹ and B²⁰² each independently represent a carbon atom, an oxygen atom, or a nitrogen atom; these atoms may each be an atom included in a ring;
L²⁰⁰ represents a single bond or an atomic group that, together with B²⁰¹ and B²⁰², forms the bidentate ligand;
when a plurality of B²⁰¹-L²⁰⁰-B²⁰² moieties are present, they may be the same or different;
i1 and i2 are each independently an integer of 0 or more and 12 or less;
i3 is an integer of 0 or more, with the upper limit thereof being the number of substituents that Ar²⁰² can have;
j is an integer of 0 or more, with the upper limit thereof being the number of substituents that Ar²⁰¹ can have;
k1 and k2 are each independently an integer of 0 or more, with the upper limit thereof being the number of substituents that ring A1 or A2 can have; and
m is an integer of 1 to 3].

25. The organic electroluminescent element composition according to claim 24, wherein a combination of (ring A1 - ring A2) in formula (201) above is (benzene ring-pyridine ring-triazine ring), (benzene ring-quinoline ring), (benzene ring-quinoxaline ring), (benzene ring-quinazoline ring), (benzene ring-imidazole ring), or (benzene ring-benzothiazole ring).

26. An organic electroluminescent element comprising an anode and a cathode that are disposed on a substrate and further comprising an organic layer between the anode and the cathode, wherein the organic layer contains the iridium complex compound according to any one of claims 15 to 22.

27. An organic electroluminescent element comprising an anode and a cathode that are disposed on a substrate and further comprising an organic layer between the anode and the cathode, wherein the organic layer contains the organic electroluminescent element composition according to any one of claims 23 to 25.

28. The organic electroluminescent element according to claim 26 or 27, wherein the organic layer is a light-emitting layer.

29. A display device comprising the organic electroluminescent element according to any one of claims 26 to 28.

30. The organic electroluminescent element composition according to any one of claims 23 to 25, further comprising an organic solvent.

31. A method for producing an organic electroluminescent element including an anode and a cathode that are disposed on a substrate and further including an organic layer between the anode and the cathode, the method comprising the step of forming the organic layer by a wet deposition method using the organic electroluminescent element composition according to claim 30.

32. The method for producing an organic electroluminescent element according to claim 31, wherein the organic layer is a light-emitting layer.
